(19) Europäisches Patentamt
European Patent Office
Office européen des brevets

(11) EP 4 478 604 B1

(12) # EUROPEAN PATENT SPECIFICATION

(45) Date of publication and mention of the grant of the patent:
**15.04.2026 Bulletin 2026/16**

(21) Application number: **23903589.2**

(22) Date of filing: **15.12.2023**

(51) International Patent Classification (IPC):
***H02P 25/22*** *(2006.01)* ***B62D 5/04*** *(2006.01)*
***H02P 29/032*** *(2016.01)* ***H02P 29/68*** *(2016.01)*
***H02M 1/32*** *(2007.01)* ***H02M 7/48*** *(2007.01)*
*H03K 17/08* *(2006.01)*

(52) Cooperative Patent Classification (CPC):
**B62D 5/0496; B62D 5/0481; H02M 1/327; H02M 7/48; H02P 25/22; H02P 29/032; H02P 29/68;** H03K 2017/0806

(86) International application number:
**PCT/JP2023/045009**

(87) International publication number:
**WO 2024/128310 (20.06.2024 Gazette 2024/25)**

(54) **CURRENT CONTROL DEVICE, MOTOR CONTROL DEVICE, AND ELECTRIC POWER STEERING DEVICE**

STROMSTEUERUNGSVORRICHTUNG, MOTORSTEUERUNGSVORRICHTUNG UND ELEKTRISCHE SERVOLENKVORRICHTUNG

DISPOSITIF DE COMMANDE DE COURANT, DISPOSITIF DE COMMANDE DE MOTEUR ET DISPOSITIF DE DIRECTION ASSISTÉE ÉLECTRIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:
**15.12.2022 JP 2022200428**
**23.01.2023 JP 2023008343**
**11.05.2023 JP 2023078573**
**17.05.2023 JP 2023081635**
**26.06.2023 JP 2023104510**
**26.07.2023 JP 2023121562**
**30.11.2023 JP 2023203138**

(43) Date of publication of application:
**18.12.2024 Bulletin 2024/51**

(73) Proprietor: **NSK Steering & Control, Inc.
Tokyo, 141-0032 (JP)**

(72) Inventor: **FUJITA, Masahiko
Tokyo 141-0032 (JP)**

(74) Representative: **Rings, Rolf
Klingseisen, Rings & Partner
Patentanwälte
Postfach 10 15 61
80089 München (DE)**

(56) References cited:
**CN-A- 105 184 363**
**JP-A- 2011 234 525**
**JP-A- 2017 028 886**
**JP-A- 2021 118 583**
**US-A1- 2014 118 866**
**US-A1- 2021 136 947**

- **HAN XINGNING ET AL: "Lifetime Estimation of Semiconductor Devices in Wind Turbine Converter Under Fractional Frequency Transmission System", 2021 INTERNATIONAL CONFERENCE ON POWER SYSTEM TECHNOLOGY (POWERCON), IEEE, 8 December 2021 (2021-12-08), pages 1486 - 1491, XP034080409, DOI: 10.1109/POWERCON53785.2021.9697872**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 478 604 B1

## Description

### Technical Field

The present invention relates to a current control device, a motor control device and an electric power steering device.

### Background Art

PTL 1 describes a technology that detects the temperature of a motor drive circuit for driving a motor that generates a steering assist force in an electric power steering apparatus and, when the detected temperature is equal to or above a threshold value, limits a motor drive current.

### Citation List

PTL 1: JP 2006-341795 A

US 2014/118866 A1 which discloses the features of the preamble of claim 1, relates to an electric power steering control device and an electric power steering control method, which use an electric motor to assist a steering force of a steering wheel. This document aims to realize an appropriate countermeasure against heat in accordance with a thermal characteristic of a component used to supply a motor current. For this purpose, this document proposes to sequentially correct the current upper-limit value obtained for each component by using overheat-protection coefficients of both a first overheat-protection characteristic and a second overheat-protection characteristic to continue current control for the electric motor with a limitation on the current for driving the electric motor in accordance with a smallest current upper-limit value of results of the correction.

US 2021/136947 A1 aims to address parasitic impedances, such as loop inductance by providing a power substrate, connecting a first terminal to the power substrate, providing a second terminal, and connecting a third terminal to the power substrate. Further, power devices are connected to the power substrate, a gate-source board electrically connected to the power devices is mounted, pin fins arranged on the base plate are provided to cool a component of the power module.

Xingning Han et al: "Lifetime Estimation of Semiconductor Devices in Wind Turbine Converter Under Fractional Frequency Transmission System" discloses an integration method for long-distance offshore wind farms, thermal modelling based on averaging power losses on particular elements during a fundamental period and investigates the lifetime of the power electronics converters of the wind turbines under reduced grid frequency. The mechanism of the influence of fractional frequency transmission technology on the service life of semiconductor devices in power converter is revealed.

CN 105 184 363 A generally relates to a zinc oxide arrester valve plate power loss prediction system, which uses temperature and charge rate as input parameters of a neural network to predict the power loss of the valve plate.

### Summary of Invention

### Technical Problem

However, if the threshold value of the component temperature at which the drive current limit to drive a load such as a motor begins to be limited is set according to a component with the largest temperature rise, the threshold value needs to be set to a small value for safety. Consequently, limitation of the drive current may be started in an excessively early stage.

In view of such a problem described above, it is an object of the present invention to suppress excessive limitation of drive current in the overheat protection of a current control circuit that controls the drive current to drive a load, while suppressing overheat of a plurality of electronic components in the current control circuit that are susceptible to thermal damage.

### Solution to Problem

In order to achieve the above-described object, according to an aspect of the present invention, there is provided a current control apparatus including: a current control circuit including a plurality of electronic components; a temperature detection circuit having a temperature detecting element disposed in the vicinity of the current control circuit; a current detecting unit configured to detect or estimate a current value flowing to each of the plurality of electronic components; a component temperature estimating unit configured to estimate a component temperature, which is a temperature of the electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient, wherein the component temperature estimating unit estimates a power loss generated in the electronic component for each of the plurality of electronic components, and estimates the component temperature of any of the plurality of electronic components based on a sum of a first value obtained by filtering the power loss through a plurality of first low-pass filters connected in parallel with each other or connected in series with each other, and a second value obtained by filtering the detected temperature detected by the temperature detection circuit through a second low-pass filter, wherein the component temperature estimating unit acquires the first value by filtering the result of the multiplication of the power loss with the predetermined gain through the plurality of first low-pass filters, and wherein at least one of the plurality of first low-pass filters (74) is a second-order or higher low-pass filter as defined in claim 1.

According to another aspect of the present invention, there is provided a motor control apparatus characterized in that current supplied to an electric motor as the load is controlled by the current control apparatus described above.

According to still another aspect of the present invention, there is provided an electric power steering apparatus including: the motor control apparatus described above, and an electric motor configured to be controlled by the motor control apparatus, characterized in that the electric motor provides a steering assist force to a steering system of a vehicle.

## Advantageous Effects of Invention

According to the present invention, it is possible to suppress excessive limitation of drive current in the overheat protection of a current control circuit that controls the drive current to drive a load, while suppressing overheat of a plurality of electronic components in the current control circuit that are susceptible to thermal damage.

## Brief Description of Drawings

FIG. 1 is a configuration diagram illustrating an overview of an example of an electric power steering apparatus of the embodiment.

FIG. 2 is a configuration diagram illustrating an overview of an example of an electronic control unit (ECU) of the embodiment.

FIG. 3 is a circuit diagram of an example of the temperature detection circuit.

FIG. 4 is a schematic illustration of a heat dissipation structure that dissipates heat generated by a power conversion circuit.

FIG. 5 is a block diagram illustrating an example of a functional configuration of the control calculating apparatus.

FIG. 6 is a block diagram of an example of the functional configuration of the first reduction coefficient setting unit according to the first embodiment.

FIG. 7 is a block diagram of an example of the functional configuration of the high-side FET temperature estimating unit.

FIG. 8 is a schematic illustration of an example of a characteristic map of high-side FET reduction coefficients.

FIGS. 9A to 9C are schematic illustration of an example of a setting operation of the component reduction coefficient.

FIG. 10 is a schematic illustration of an example of a characteristic map of battery reduction coefficients.

FIG. 11 is an example flowchart of a process in the control calculating apparatus.

FIG. 12 is a schematic illustration to describe effects of a second low-pass filter.

FIG. 13 is a block diagram of an example of the functional configuration of a first reduction coefficient setting unit according to a second embodiment.

FIG. 14 is a graph illustrating temperatures when a specific magnitude of current is applied in order to investigate trends in component temperatures and temperatures of the temperature sensor in each of the dual-system drive mode and the single-system drive mode.

FIG. 15 is a graph illustrating temperatures difference when a specific magnitude of current is applied in order to investigate trends in difference between component temperatures and temperatures of the temperature sensor in each of the dual-system drive mode and the single-system drive mode.

FIG. 16A is a drawing illustrating an example of conversion gain setting, and FIG. 16B is a drawing illustrating an example of first cutoff frequency setting.

FIGS. 17A to 17C are schematic illustrations illustrating the relationship between a distribution ratio of output current between a first current control circuit and a second current control circuit, a conversion gain and a first cutoff frequency.

FIG. 18 is a block diagram of a first example of the functional configuration of the high-side FET temperature estimating unit according to a fourth embodiment.

FIGS. 19A and 19B are schematic illustrations of temperature estimation results in the first embodiment and the fourth embodiment, respectively, and FIGS. 19C and 19D are schematic illustrations of estimation errors in the first embodiment and the fourth embodiment, respectively.

FIGS. 20A and 20B are schematic illustrations of heat dissipation paths from electronic components to a heat sink, and FIG. 20C is an equivalent circuit diagram that schematically represents the heat dissipation paths in FIGS. 20A and 20B.

FIG. 21 is a block diagram of a second example of the functional configuration of the high-side FET temperature estimating unit according to the fourth embodiment.

FIG. 22 is a block diagram of a first example of the functional configuration of a capacitor temperature estimating unit according to a fifth embodiment.

FIGS. 23A and 23B are schematic illustrations of temperature estimation results in the first embodiment and the fifth embodiment, respectively, and FIGS. 23C and 23D are schematic illustrations of estimation errors in the first embodiment and the fifth embodiments, respectively.

FIGS. 24A to 24I are image diagrams illustrating the trend of component temperature estimation results when the three-phase FETs are each driven at a specific duty ratio.

FIG. 25A is a schematic illustration of the heat dissipation paths from electronic components to the heat sink, FIG. 25B is an equivalent circuit diagram schematically representing the heat dissipation paths in FIG. 25A, and FIG. 25C is a block diagram of a second example of the functional configuration of the capacitor temperature estimating unit according to the fifth embodiment.

FIGS. 26A and 26B are block diagrams illustrating a first modification and a second modification of the component temperature estimating unit configured to estimate the component temperatures of electronic components included in the current control circuit.

FIG. 27 is a configuration diagram illustrating an overview of an example of an electronic control unit according to a sixth embodiment.

FIG. 28 is a block diagram illustrating an example of the functional configuration of the high-side FET temperature estimating unit according to the sixth embodiment.

FIGS. 29A to 29D are schematic illustrations for explaining an error that occurs in an estimated component temperature based on a first estimated gain Ge1 when a delayed response of the component temperature to be estimated is slower than a delayed response of a second detected temperature.

FIG. 30A is a schematic illustration of an example of a second estimated gain Ge2, and FIG. 30B is a schematic illustration of the estimated component temperature based on the second estimated gain Ge2.

FIGS. 31A to 31C are schematic illustrations for explaining an error that occurs in the estimated component temperature based on the first estimated gain Ge1 when the delayed response of the component temperature to be estimated is faster than the delayed response of the second detected temperature, FIG. 31D is a schematic illustration of an example of the second estimated gain Ge2, and FIG. 31E is a schematic illustration of the estimated component temperature based on the second estimated gain Ge2.

FIG. 32A illustrates an example of the change in assumed component temperature of a choke coil La, FIG. 32B illustrates an example of the change in assumed component temperature of power cutoff FET QC2, FIG. 32C illustrates an example of the change in assumed component temperature of power cutoff FET QD2, FIG. 32D illustrates an example of the change in assumed component temperature of power cutoff FET QC1, and FIG. 32E illustrates an example of the change in assumed component temperature of power cutoff FET QD1.

FIGS. 33A to 33C are schematic illustrations of a first example to a third example of heat dissipation paths from the choke coil.

FIGS. 34A and 34B are block diagrams of a first example and a second example of the functional configuration of the power cutoff FET temperature estimating unit of a seventh embodiment, respectively.

FIG. 35 is a configuration diagram illustrating an overview of a first modification of the electronic control unit.

FIG. 36 is a configuration diagram illustrating an overview of a second modification of the electronic control unit.

FIG. 37 is a configuration diagram illustrating an overview of the first modification of the electric power steering apparatus.

FIG. 38 is a configuration diagram illustrating an overview of a second modification of the electric power steering apparatus.

FIG. 39 is a configuration diagram illustrating an overview of a third modification of the electric power steering apparatus.

## Description of Embodiments

The embodiments of the present invention will be described in detail with reference to the drawings. Note that the embodiments of the present invention given below are examples of apparatuses and methods to embody the technical concept of the invention, and the technical concept of the present invention does not specify the configuration, arrangement, and the like of the components to those given below. The technical concept of the present invention may be modified in various ways within the technical scope defined by the claims.

In addition, in the following description, a case in which the present invention is applied to a current control apparatus configured to supply drive current to an electric motor that generates steering assist force for electric power steering will be described, but the present invention is not limited to application to electric power steering apparatuses or motors and can be widely applied to various applications. For example, the present invention may be applied to a current control apparatus configured to apply drive current for an actuator that drives robot's joints, or the present invention may be applied to a current control apparatus configured to supply drive current for an electrical device other than the motor (such as a light emitting diode, or IC such as a pre-driver or microcontroller).

## First Embodiment

### Configuration

FIG. 1 is a configuration diagram illustrating an overview of an example of an EPS (electric power steering) according to an embodiment. A steering shaft (handle shaft) 2 of a steering wheel (steering handle) 1 is connected to steered wheels 8L and 8R via a reduction gear (worm gear) 3, which constitute a reduction mechanism, universal joints 4a and 4b, a pinion rack mechanism 5 and tie rods 6a and 6b and then via hub units 7a and 7b.

The pinion rack mechanism 5 includes a pinion 5a coupled to a pinion shaft to which a steering force is transferred from the universal joint 4b, and a rack 5b engaged with the pinion 5a, and configured to convert a rotational motion transferred to the pinion 5a into a linear motion in the vehicle's width direction by the rack 5b.

The steering shaft 2 is provided with a torque sensor 10 configured to detect a steering torque Th. In addition, the steering shaft 2 is provided with a steering angle sensor 14 configured to detect a steering angle θh of the steering wheel 1.

A motor 20 configured to assist the steering force of the steering wheel 1 is connected to the steering shaft 2 via the reduction gear 3. The motor 20 may be, for example, a multiphase motor. In the following description, an example of a three-phase motor having a double winding configuration configured to rotates a common rotor by two system coils including a first system coil and a second system coil wound in a common motor housing will be described. However, the motor 20 may be a motor other than the double winding motor, and the motor 20 does not necessarily have to be of 3-phases. A plurality of the motors 20 configured to assist the steering force of the steering wheel 1 may be connected to the same steering shaft 2.

An ECU (electronic control unit) 30 configured to control an electric power steering apparatus receives a supply of power from a battery 13 and an input of an ignition key signal via an ignition switch 11.

The ECU 30 controls current to be supplied to the motor 20 (a phase A current I1a, a phase B current I1b, and a phase C current I1c of the first system coil, and a phase A current I2a, a phase B current I2b, and a phase C current I2c of the second system coil) by the voltage control command value obtained by calculating the current command value of the assist control command based on the steering torque Th detected by the torque sensor 10, a vehicle speed Vh detected by a vehicle speed sensor 12, and steering angle θh detected by the steering angle sensor 14 and applying compensation or the like to the current command value. The ECU 30 is an example of a "current control apparatus" and a "motor control apparatus" described in claims.

The steering angle sensor 14 is not mandatory and may be substituted by calculation of the steering angle θh by adding a torsion angle of a torsion bar of the torque sensor 10 to a product of a motor rotational angle θm obtained from a rotational angle sensor 23a that detects a rotational angle of a rotating shaft of the motor 20 and a gear ratio of the reduction gear 3. For example, a resolver configured to detect a rotational position of the motor, or a magnetic sensor configured to detect a magnetic field of a magnet attached to the rotating shaft of the motor 20 may be employed as the rotational angle sensor 23a. Alternatively, a turning angle of steered wheels 8L and 8R may be used instead of the steering angle θh. For example, the turning angle may be detected by detecting the amount of displacement of the rack 5b.

The ECU 30 includes, for example, a computer that includes a processor and peripheral components such as storage devices. The processor may be, for example, CPU (Central Processing Unit) or MPU (Micro-Processing Unit).

The storage device may include any one of a semiconductor storage device, a magnetic storage device, and an optical storage device. The storage device may include memories such as a register, a cache memory, an ROM (Read Only Memory), and an RAM (Random Access Memory).

Functions of the ECU 30 described below are implemented, for example, by the processor of the ECU 30 executing a computer program stored in the storage device.

Note that the ECU 30 may be formed by dedicated hardware for executing each data processing described below.

For example, the ECU 30 may include a functional logic circuit set in a general-purpose semiconductor integrated circuit. For example, the ECU 30 may have a Programmable Logic Device (PLD) such as a Field-Programmable Gate Array (FPGA).

FIG. 2 is a configuration diagram illustrating an overview of an example of the ECU 30 of the embodiment. The ECU 30 includes a motor rotational angle detection circuit 23, control calculating apparatuses 31a and 31b, a first motor current cutoff circuit 33A and a second motor current cutoff circuit 33B, a first gate drive circuit 41A and a second gate drive circuit 41B, a first power conversion circuit 42A and a second power conversion circuit 42B, a first power cutoff circuit 44A and a second power cutoff circuit 44B, and temperature detection circuits 45A and 45B.

A power line PWa configured to transmit power from the battery 13 is connected to the ECU 30 via a connector CNT. A positive-side power line Lpa of the power line PWa branches at a branch point Pb after passing through a noise filter circuit such as EMC (Electromagnetic Compatibility) filter formed of a choke coil La and ceramic capacitors Ca1 and Ca2. One of the branches of the positive-side power line Lpa branched at the branch point Pb is connected to the control calculating apparatus 31a and the first power cutoff circuit 44A, and the other branch is connected to the control calculating apparatus 31b and the second power cutoff circuit 44B.

One end of the choke coil La is connected to the positive-side power line Lpa and one end of the ceramic capacitor Ca1 and the other end of the choke coil La is connected to one end of the ceramic capacitor Ca2 and the branch point Pb, and the other ends of the ceramic capacitors Ca1 and Ca2 are grounded. On the other hand, a negative-side line of the power line PWa is connected to a ground line of the ECU 30.

A voltage detection circuit 34A detects supply voltage VRA supplied from the first power cutoff circuit 44A to the first power conversion circuit 42A, and outputs the detected supply voltage VRA to the control calculating apparatus 31a. A voltage detection circuit 34B detects supply voltage VRB supplied from the second power cutoff circuit 44B to the second power conversion circuit 42B, and outputs the detected supply voltage VRB to the control calculating apparatus 31b.

The steering torque Th detected by the torque sensor 10, the vehicle speed Vh detected by the vehicle speed sensor 12, and a signal of the steering angle θh detected by the steering angle sensor 14 are transferred to the control calculating apparatuses 31a and 31b via the connector CNT.

The control calculating apparatus 31a calculates the current command value, which is a target value of control of the drive current of the motor 20 based at least on the steering torque Th, and outputs voltage control command values V1a, V1b, and V1c obtained by applying compensation or the like on the current command value to the first gate drive circuit 41A. The voltage control command values V1a, V1b, and V1c are a phase A voltage control command value, a phase B voltage control command value, and a phase C voltage control command value of the first system coil, respectively.

The control calculating apparatus 31b calculates the current command value, which is a target value of control of the drive current of the motor 20 based at least on the steering torque Th, and outputs voltage control command values V2a, V2b, and V2c obtained by applying compensation or the like on the current command value to the second gate drive circuit 41B. The voltage control command values V2a, V2b, and V2c are a phase A voltage control command value, a phase B voltage control command value, and a phase C voltage control command value of the second system coil, respectively.

Note that the control calculating apparatus 31a and the control calculating apparatus 31b may be integrated into a single control calculating apparatus.

The first power cutoff circuit 44A includes a series circuit configuration with two power cutoff field effect transistors (FET) QC1 and QC2 connected source to source, ensuring that parasitic diodes are oriented opposite directions to connect or disconnect the positive-side power line Lpa and the first power conversion circuit 42A. The drain of the power cutoff FET QC1 is connected to a positive-side power line Lpa, and the drain of the power cutoff FET QC2 is connected to drains of high-side FETs Q1, Q3, and Q5 of the first power conversion circuit 42A. The control calculating apparatus 31a outputs control signals SsA and SpA configured to control energization and cutting-off of the power cutoff FETs QC1 and QC2, respectively, to the first gate drive circuit 41A. The first gate drive circuit 41A outputs gate signals of the power cutoff FETs QC1 and QC2 according to the control signals SsA and SpA, respectively, to control power on and off of the power cutoff FETs QC1 and QC2. Note that the power cutoff FET QC2 functions as a reverse connection protection field-effect transistor that is connected between DC power source and an inverter to prevent current from flowing from an inverter-side to a DC power source-side in order to prevent failures that may occur when the battery 13, which is the DC power source, is connected incorrectly to the wrong polarity by mistake.

Likewise, the second power cutoff circuit 44B includes a series circuit configuration with two power cutoff FET QD1 and QD2 connected source to source, ensuring that parasitic diodes are oriented opposite directions to connect or disconnect the positive-side power line Lpa and the second power conversion circuit 42B. The power cutoff FET QD2 also functions as the reverse connection protection field-effect transistor. The drain of the power cutoff FET QD1 is connected to a positive-side power line Lpa, and the drain of the power cutoff FET QD2 is connected to drains of high-side FETs Q1, Q3

and Q5 of the second power conversion circuit 42B. The control calculating apparatus 31b outputs control signals SsB and SpB configured to control energization and cutting-off of the power cutoff FETs QD1 and QD2, respectively, to the second gate drive circuit 41B. The second gate drive circuit 41B outputs gate signals of the power cutoff FETs QD1 and QD2 according to the control signals SsB and SpB, respectively, to control power on and off of the power cutoff FETs QD1 and QD2.

When voltage control command values V1a, V1b, and V1c are input from the control calculating apparatus 31a, the first gate drive circuit 41A forms six gate signals which are pulse-width-modulated (PWM) based on these voltage control command values V1a, V1b, and V1c and a triangle carrier signal. These gate signals are then outputted to the first power conversion circuit 42A.

When voltage control command values V2a, V2b, and V2c are input from the control calculating apparatus 31b, the second gate drive circuit 41B forms six gate signals which are pulse-width-modulated based on these voltage control command values V2a, V2b, and V2c and a triangle carrier signal. These gate signals are then outputted to the second power conversion circuit 42B.

The first power conversion circuit 42A includes an inverter having three switching arms SWAa, SWAb, and SWAc composed of FETs as switching devices, and electrolytic capacitors CA1 and CA2.

The switching arms SWAa, SWAb, and SWAc are connected in parallel to each other. The phase A switching arm SWAa includes the high-side FET Q1 and the low-side FET Q2 connected in series, the phase B switching arm SWAb includes a high-side FET Q3 and a low-side FET Q4 connected in series, and the phase C switching arm SWAc includes a high-side FET Q5 and a low-side FET Q6 connected in series.

Gate signals outputted from the first gate drive circuit 41A are inputted to the gates of each of the FETs Q1 to Q6, and by means of these gate signals, the phase A current I1a, the phase B current I1b, and the phase C current I1c from connecting points between the FETs of each of the switching arms SWAa, SWAb, and SWAc are supplied to a phase A winding, a phase B winding, and a phase C winding of the first system coil of the motor 20 via the first motor current cutoff circuit 33A.

The electrolytic capacitors CA1 and CA2 include a noise cancellation function and a power supply assistance function with respect to the first power conversion circuit 42A. The electrolytic capacitors CA1 and CA2 may be, for example, hybrid capacitors using electrolyte combining conductive polymer and electrolyte solution.

The second power conversion circuit 42B includes an inverter having three switching arms SWBa, SWBb, and SWBc composed of FETs as switching devices, and electrolytic capacitors CB1 and CB2.

The switching arms SWBa, SWBb, and SWBc are connected in parallel to each other. The phase A switching arm SWBa includes the high-side FET Q1 and the low-side FET Q2 connected in series, the phase B switching arm SWBb includes a high-side FET Q3 and a low-side FET Q4 connected in series, and the phase C switching arm SWBc includes a high-side FET Q5 and a low-side FET Q6 connected in series.

Gate signals outputted from the second gate drive circuit 41B are inputted to the gates of each of the FETs Q1 to Q6, and by means of these gate signals, the phase A current I2a, the phase B current I2b, and the phase C current I2c from connecting points between the FETs of each of the switching arms SWBa, SWBb, and SWBc are supplied to the phase A winding, the phase B winding, and the phase C winding of the second system coil of the motor 20 via the second motor current cutoff circuit 33B.

The electrolytic capacitors CB1 and CB2 include a noise cancellation function and a power supply assistance function with respect to the second power conversion circuit 42B. The electrolytic capacitors CB1 and CB2 may be, for example, hybrid capacitors.

Note that the first power conversion circuit 42A and the second power conversion circuit 42B may be power conversion circuits supplying three-phase current to two different motors each providing a steering assist force that assists steering of the steering wheel 1. For example, these two different motors may be connected to the same steering shaft 2 via reduction gears.

Current detection circuits 39A1, 39B1, and 39C1 are provided on the respective source sides of the low-side FETs Q2, Q4, and Q6 that form the lower arm of the switching arms SWAa, SWAb, and SWAc of the first power conversion circuit 42A. The current detection circuits 39A1, 39B1, and 39C1 include shunt resistors through which downstream currents of the switching arms SWAa, SWAb, and SWAc flow, respectively, current detection circuits 39A1, 39B1, and 39C1 detects a phase A current, a phase B current, and a phase C current of the first system coil based on the voltage drop across the shunt resistor, and outputs detected values I1ad, I1bd, and I1cd.

Current detection circuits 39A2, 39B2, and 39C2 are provided on the respective source sides of the low-side FETs Q2, Q4, and Q6 that form the lower arm of the switching arms SWBa, SWBb, and SWBc of the second power conversion circuit 42B. The current detection circuits 39A2, 39B2, and 39C2 include shunt resistors through which downstream currents of the switching arms SWBa, SWBb, and SWBc flow, respectively, current detection circuits 39A2, 39B2, and 39C2 detects a phase A current, a phase B current, and a phase C current of the second system coil based on the voltage drop across the shunt resistor, and outputs detected values I2ad, I2bd, and I2cd.

The first motor current cutoff circuit 33A includes three phase cutoff FETs QA1, QA2, and QA3 for cutting off the phase current of the motor. The source of the phase cutoff FET QA1 is connected to the connecting points of the FETs Q1 and Q2 of the switching arm SWAa of the first power conversion circuit 42A, and the drain is connected to the phase A winding of the first system coil of the motor 20. The source of the phase cutoff FET QA2 is connected to the connecting point of the FETs Q3 and Q4 of the switching arm SWAb, and the drain is connected to the phase B winding of the first system coil. The source of the phase cutoff FET QA3 is connected to the connecting point of the FETs Q5 and Q6 of the switching arm SWAc, and the drain is connected to the phase C winding of the first system coil.

The control calculating apparatus 31a outputs a control signal SmA configured to control energization and cutting-off of the first motor current cutoff circuit 33A to the first gate drive circuit 41A. The first gate drive circuit 41A outputs gate signals of the phase cutoff FETs QA1 to QA3 according to the control signals SmA to power the phase A current I1a the phase B current I1b, and the phase C current I1c from the first power conversion circuit 42A to the motor 20 on or off.

The second motor current cutoff circuit 33B includes three phase cutoff FETs QB1, QB2, and QB3 for cutting off the phase current of the motor. The source of the phase cutoff FET QB1 is connected to the connecting points of the FETs Q1 and Q2 of the switching arm SWBa of the second power conversion circuit 42B, and the drain is connected to the phase A winding of the second system coil of the motor 20. The source of the phase cutoff FET QB2 is connected to the connecting point of the FETs Q3 and Q4 of the switching arm SWBb, and the drain is connected to the phase B winding of the second system coil. The source of the phase cutoff FET QB3 is connected to the connecting point of the FETs Q5 and Q6 of the switching arm SWBc, and the drain is connected to the phase C winding of the second system coil.

The control calculating apparatus 31b outputs a control signal SmB configured to control energization and cutting-off of the second motor current cutoff circuit 33B to the second gate drive circuit 41B. The second gate drive circuit 41B outputs gate signals of the phase cutoff FETs QB1 to QB3 according to the control signals SmB to energize or cutoff the phase A current I2a, the phase B current I2b, and the phase C current I2c from the second power conversion circuit 42B to the motor 20.

For example, silicon devices may be used or silicon carbide devices may be used as the high-side FETs Q1, Q3, and Q5, the low-side FET Q2, Q4, and Q6, the phase cutoff FETs QA1 to QA3 and QB1 to QB3, and the power cutoff FETs QC1, QC2, QD1, and QD2.

The motor rotational angle detection circuit 23 acquires detected values from the rotational angle sensor 23a, and detects the motor rotational angle $\theta m$, which is the rotational angle of the rotating shaft of the motor 20. The motor rotational angle detection circuit 23 outputs the motor rotational angle $\theta m$ to the control calculating apparatuses 31a and 31b.

The temperature detection circuit 45A includes two temperature sensors disposed in close proximity to each other in the vicinity of the first power conversion circuit 42A. The temperature detection circuit 45B includes two temperature sensors disposed in close proximity to each other in the vicinity of the second power conversion circuit 42B. These temperature sensors are examples of "temperature detecting element" described in claims. Note that the temperature sensors do not have to be arranged at the positions in the vicinity of the first power conversion circuit 42A and the second power conversion circuit 42B. The temperature sensors need only to be disposed at any locations susceptible to heat generation in the ECU 30.

The temperature detection circuit 45A outputs a detection signal SdA1 of the temperature of the ECU 30 based on the outputted from one of the two temperature sensors and a detection signal SdA2 of the temperature of the ECU 30 based on the outputted from the other sensor to the control calculating apparatus 31a. The temperature detection circuit 45B outputs a detection signal SdB1 of the temperature of the ECU 30 based on the outputted from one of the two temperature sensors and a detection signal SdB2 of the temperature of the ECU 30 based on the outputted from the other sensor to the control calculating apparatus 31b.

These temperature sensors may be, for example, a thermistor. The temperature detection circuits 45A and 45B may include a thermistor processing circuit configured to detect the temperature of the ECU 30 according to the resistance value of the thermistor.

FIG. 3 illustrates a circuit diagram of an example of the temperature detection circuit 45A. The temperature detection circuit 45A includes a voltage-dividing circuit to which thermistors such as the temperature sensor 45A1 and the thermistor 45A2 and fixed resistors R1 and R2 are connected in series respectively, and capacitors Ct1 and Ct2. The temperature detection circuit 45B includes the same configuration.

The voltage-dividing circuit composed of the thermistor 45A1 and the fixed resistor R1 divides a predetermined voltage Vcc at a ratio of the resistance value of the thermistor 45A1 to the resistance value of the fixed resistor R1, and outputs the value obtained by voltage division to the control calculating apparatus 31a as the detection signal SdA1. The voltage-dividing circuit composed of the thermistor 45A2 and the fixed resistor R2 divides a predetermined voltage Vcc at a ratio of the resistance value of the thermistor 45A2 to the resistance value of the fixed resistor R2, and outputs the value obtained by voltage division to the control calculating apparatus 31a as the detection signal SdA2.

FIG. 4 is a schematic illustration illustrating a heat dissipation structure that dissipates heat generated by the first power conversion circuit 42A and the second power conversion circuit 42B. Reference numeral 36 denotes a circuit board, and electronic components of the first power conversion circuit 42A and the second power conversion circuit 42B are mounted on a front surface ff and a back surface fr of the circuit board 36. Reference numeral 37 denotes a heat-dissipating member 37 configured to dissipate heat generated by the first power conversion circuit 42A and the second power conversion circuit 42B. The heat-dissipating member 37 may be a heat sink formed of heat-conductive metal such as aluminum alloy.

Electronic components included in each of the first power conversion circuit 42A and the second power conversion circuit 42B dissipate heat through the heat sink 37. A surface f1 of the electronic component mounted on the front surface ff of the circuit board 36 on the opposite side from the circuit board 36 and surfaces f2 of the temperature sensors 45A1 and 45A2 of the temperature detection circuit 45A on the opposite side from the circuit board 36 are thermally connected to the same heat sink 37. An electronic component mounted on the back surface fr of the circuit board 36 is thermally connected to the same heat sink 37 through a via penetrating through the circuit board 36.

For example, the surfaces f1 and f2 are brought into contact with the heat sink 37 via thermal interface materials (TIM) 38a and 38b such as conductive paste (for example, heat dissipating grease), respectively, and the electronic component mounted on the back surface fr is brought into contact with the heat sink 37 through the thermal interface material 38c and the via.

The temperature sensor of the temperature detection circuit 45B is also thermally connected to the heat sink 37 in the same configuration as the temperature sensors 45A1 and 45A2.

Refer to FIG. 2. The control calculating apparatus 31a acquires detected values I1ad, I1bd, and I1cd of the phase A current, the phase B current, and the phase C current of the first system coil and detection signals SdA1 and SdA2 of the temperature of the ECU 30 via an A/D converting unit, not illustrated. The control calculating apparatus 31b acquires detected values I2ad, I2bd, and I2cd of the phase A current, the phase B current, and the phase C current of the second system coil and detection signals SdB1 and SdB2 of the temperature of the ECU 30 via an A/D converting unit, not illustrated. In the following description, the detection signals SdA1 and SdA2 may be collectively expressed as "SdA", and the detection signals SdB1 and SdB2 may be collectively referred to as "SdB".

The control calculating apparatus 31a and the control calculating apparatus 31b are connected via a communication line 35 such as CAN (Controller Area Network), thereby transmitting data with each other.

For example, the control calculating apparatus 31a may calculate battery current Ibat1 flowing from the battery 13 to the first system coil based on the detected values I1ad, I1bd, and I1cd of the phase A current, the phase B current, and the phase C current of the first system coil and transmit the calculated battery current Ibat1 to the control calculating apparatus 31b. Likewise, the control calculating apparatus 31b may calculate battery current Ibat2 flowing from the battery 13 to the second system coil based on the detected values I2ad, I2bd, and I2cd of the phase A current, the phase B current, and the phase C current of the second system coil and transmit the calculated battery current Ibat2 to the control calculating apparatus 31a.

Based on the detected values I1ad, I1bd, and I1cd of the phase A current, the phase B current, and the phase C current of the first system coil of the motor 20, the battery currents Ibat1 and Ibat2, the supply voltage VRA, and detection signal SdA outputted by the temperature detection circuit 45A, the control calculating apparatus 31a estimates component temperatures, which are the temperatures of a plurality of electronic components that constitutes the first current control circuit 40A configured to control current that drives the first system coil.

As the electronic components that constitutes the first current control circuit 40A, the control calculating apparatus 31a may estimate the component temperatures of, for example, the high-side FETs Q1, Q3, and Q5, the low-side FETs Q2, Q4, and Q6 of the first power conversion circuit 42A, the electrolytic capacitors CA1 and CA2, the shunt resistors of the current detection circuits 39A1, 39B1, and 39C1, the phase cutoff FETs QA1, QA2, and QA3, and the power cutoff FETs QC1 and QC2.

Likewise, based on the detected values I2ad, I2bd, and I2cd of the phase A current, the phase B current, and the phase C current of the second system coil of the motor 20, the battery currents Ibat1 and Ibat2, the supply voltage VRB, and detection signal SdB outputted by the temperature detection circuit 45B, the control calculating apparatus 31b estimates component temperatures, which are the temperatures of a plurality of electronic components that constitutes the second current control circuit 40B configured to control current that drives the second system coil.

As the electronic components that constitutes the second current control circuit 40B, the control calculating apparatus 31b may estimate the component temperatures of, for example, the high-side FETs Q1, Q3, and Q5, the low-side FETs Q2, Q4, and Q6 of the second power conversion circuit 42B, the electrolytic capacitors CB1 and CB2, the shunt resistors of the current detection circuits 39A2, 39B2, and 39C2, the phase cutoff FETs QB1, QB2, and QB3, and the power cutoff FETs QD1 and QD2.

The control calculating apparatuses 31a and 31b may estimate the component temperature of a choke coil La of the noise filter circuit as a common electronic component of the first current control circuit 40A and the second current control circuit 40B.

The control calculating apparatus 31a estimates the temperature of the ECU 30 based on the detection signal SdA outputted by the temperature detection circuit 45A. The control calculating apparatus 31b estimates the temperature of the ECU 30 based on the detection signal SdB outputted by the temperature detection circuit 45B. In the following description, the temperature of the ECU 30 is referred to as "ECU temperature".

The control calculating apparatus 31a also estimate the temperature of the motor 20 (for example, the temperature of the winding coil of the first system coil) based on the detected values I1ad, I1bd, and I1cd of the phase A current, the phase B current, and the phase C current of the first system coil and the ECU temperature. The control calculating apparatus 31b estimates the temperature of the motor 20 (for example, the temperature of the winding coil of the second system coil) based on the detected values I2ad, I2bd, and I2cd of the phase A current, the phase B current, and the phase C current of the second system coil and the ECU temperature. In the following description, the temperature of the motor 20 may be referred to as "motor temperature".

The control calculating apparatus 31a limits the current that drives the first system coil based on the estimated component temperature, the ECU temperature, and the motor temperature, and the battery voltage Vbat1, which is a voltage between output terminals of the battery 13. Likewise, the control calculating apparatus 31b limits the current that drives the second system coil based on the estimated component temperature, the ECU temperature, and the motor temperature, and the battery voltage Vbat1.

The control calculating apparatuses 31a and 31b will be described. FIG. 5 is a block diagram of an example of a functional configuration of the control calculating apparatus 31a. The control calculating apparatus 31b has the similar configuration.

The control calculating apparatus 31a includes a current command value calculating unit 50, a current limiting unit 51, subtractors 52 and 53, a proportional-Integral (PI) control unit 54, a 2-phase/3-phase converting unit 55, a three phase/two phase converting unit 56, an angular speed converting unit 57, a first reduction coefficient setting unit 60, a second reduction coefficient setting unit 70, and a third reduction coefficient setting unit 71, and the motor 20 is driven by a vector control.

The current command value calculating unit 50 calculates a q-axis current command value Iq0 and a d-axis current command value Id0 to be flowed to the motor 20 based on the steering torque Th, the vehicle speed Vh, the motor rotational angle θm of the motor 20, and the rotational angular speed ω of the motor 20.

The current limiting unit 51 limits the q-axis current command value Iq0 and d-axis current command value Id0 based on the component reduction coefficient K1 set by the first reduction coefficient setting unit 60, the ECU reduction coefficient K2 and motor reduction coefficient K3 set by the second reduction coefficient setting unit 70 and the battery reduction coefficient K4 set by the third reduction coefficient setting unit 71. The limited q-axis current command value Iq1 and limited d-axis current command value Id1 are outputted. The component reduction coefficient K1, ECU reduction coefficient K2, motor reduction coefficient K3 and battery reduction coefficient K4 will be discussed below.

The detected values I1ad, I1bd and I1cd of the phase A current, the phase B current and the phase C current of the first system coil of motor 20 detected by the current detection circuits 39A1, 39B1 and 39C1 are converted to d-q2 axis currents id and iq in the 3-phase/2-phase converting unit 56.

The subtractors 52 and 53 calculate the q-axis deviation current Δq and d-axis deviation current Δd by subtracting the fed back currents iq and id from the q-axis current command value Iq1 and d-axis current command value Id1, respectively.

The PI control unit 54 calculates the voltage command values vq and vd such that the q-axis deviation current Δq and d-axis deviation current Δd each becomes zero. The 2-phase/3-phase converting unit 55 converts the voltage commands vd and vq into a phase A voltage control command value V1a, a phase B voltage control command value V1b and a phase C voltage control command value V1c of the first system of motor 20, respectively, and outputs the converted values to the first gate drive circuit 41A.

The angular speed converting unit 57 calculates the rotational angular speed ω of the motor 20 based on the temporal variation of the motor rotational angle θm. These motor rotational angles θm and rotational angular speed ω are input to the current command value calculating unit 50 for vector control.

FIG. 6 is a block diagram of an example of the functional configuration of the first reduction coefficient setting unit 60 according to the first embodiment. The first reduction coefficient setting unit 60 estimates the component temperature of each of the plurality of electronic components which constitute the first current control circuit 40A. The first reduction coefficient setting unit 60 sets a plurality of reduction coefficients for limiting the current that drives the first system coil based on the component temperature estimated for each of the plurality of electronic components. For example, a plurality of different reduction coefficients are set for a plurality of different component temperatures included in the component temperature estimated for each of the plurality of electronic components.

For example, the first reduction coefficient setting unit 60 may sort the plurality of electronic components into a plurality of groups based on the type of the electronic components and the connection relation or the like in the first current control circuit 40A and set the reduction coefficient for each group. The first reduction coefficient setting unit 60 selects one of the plurality of limiting coefficients as a component reduction coefficient K1 and outputs the selected one.

The first reduction coefficient setting unit 60 includes high-side FET temperature estimating units 61a1 to 61a3, low-side FET temperature estimating units 61b1 to 61b3, shunt resistance temperature estimating units 61c1 to 61c3, phase cutoff FET temperature estimating units 61d1 to 61d3, power cutoff FET temperature estimating units 61e1 and 61e2, capacitor temperature estimating units 61f1 and 61f2, coil temperature estimating unit 61g, selectors 62a, 62b, 62c, 62d, 62e, 62f and 64, high-side FET reduction coefficient setting unit 63a, low-side FET reduction coefficient setting unit 63b, shunt resistance reduction coefficient setting unit 63c, phase cutoff FET reduction coefficient setting unit 63d, power cutoff FET reduction coefficient setting unit 63e, capacitor reduction coefficient setting unit 63f and coil reduction coefficient setting unit 63g.

The high-side FET temperature estimating units 61a1 to 61a3 estimate the component temperatures Teal to Tea3 of the high-side FETs Q1, Q3 and Q5 of the first power conversion circuit 42A, respectively. The low-side FET temperature estimating units 61b1 to 61b3 estimate the component temperatures Teb1 to Teb3 of the low-side FETs Q2, Q4 and Q6 of the first power conversion circuit 42A, respectively. The shunt resistance temperature estimating units 61c1 to 61c3 estimate the component temperatures Tec1 to Tec3 of the shunt resistors of the current detection circuits 39A1, 39B1 and 39C1, respectively.

The phase cutoff FET temperature estimating units 61d1 to 61d3 estimate the component temperatures Ted1 to Ted3 of the phase cutoff FETs QA1, QA2, and QA3, respectively. The power cutoff FET temperature estimating units 61e1 and 61e2 estimate the component temperatures Tee1 and Tee2 of the power cutoff FETs QC1 and QC2. The capacitor temperature estimating units 61f1 and 61f2 estimate the component temperatures Tef1 and Tef2 of the electrolytic capacitors CA1 and CA2 of the first power conversion circuit 42A, respectively. The coil temperature estimating unit 61g estimates the component temperature Teg of the choke coil La in the noise filter circuit.

In the following description, the component temperature Teg of the choke coil La may be referred to as "coil temperature Teg".

FIG. 7 is a block diagram of an example of the functional configuration of the high-side FET temperature estimating unit 61a1.

The high-side FET temperature estimating unit 61a1 has a power loss calculating unit 72, a gain multiplying unit 73, a first low-pass filter 74, a second low-pass filter 75 and an adder 76.

The power loss calculating unit 72 calculates the power loss W in the high-side FET Q1 of the first power conversion circuit 42A.

For example, the power loss calculating unit 72 estimates the ON-resistance Rf of the FET based on the previous value of the component temperature Teal of the high-side FET Q1 calculated in the previous control cycle. Then, the power loss calculating unit 72 calculates a power loss W in the high-side FET Q1 based on the ON-resistance Rf, the duty ratio Da of the phase A voltage control command value, the phase A current I1ad, the supply voltage VRA, the switching loss generation time Tsw of the FET, the body diode forward voltage Vdsf, the body diode current generation time Td and the motor drive PWM frequency fpwm.

The power loss calculating unit 72 of the control calculating apparatus 31b estimates the power loss W using the supply voltage VRB instead of the supply voltage VRA. The same applies in the following description.

The switching loss generation time Tsw is the sum of the FET turn-on and turn-off times, while the body diode current generation time Td is the time for regenerative current to flow in the body diode (parasitic diode) after the FET is switched off.

For example, the power loss calculating unit 72 may calculate the power loss W based on the following calculation formula.

$$W = Rf \times Da \times I1ad^2 + (1/6) \times VRA \times I1ad \times Tsw \times fpwm \text{ (where, } I1ad \geq 0)$$

$$W = Rf \times Da \times I1ad^2 - Vdsf \times I1ad \times Td \times fpwm \text{ (where } I1ad < 0)$$

The gain multiplying unit 73 calculates a product of the power loss W and a predetermined conversion gain G1 (G1 × W) and output the result to the first low-pass filter 74. The first low-pass filter 74 outputs a signal obtained by applying a low-pass filtering to the product (G1 × W) to the adder 76. The second low-pass filter 75 outputs a signal obtained by applying the low-pass filtering to a detection signal SdA of the temperature of the ECU 30 outputted by the temperature detection circuit 45A to the adder 76 as a base temperature Tth. The adder 76 calculates the sum of the output of the first low-pass filter 74 and the base temperature Tth as the component temperature Teal of the high-side FET Q1.

Note that the conversion gain G1 as well as the first cutoff frequency fc1 of the first low-pass filter 74 and a second cutoff frequency fc2 of the second low-pass filter 75 may be set as needed by simulation or the like in advance.

The high-side FET temperature estimating units 61a2 and 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, the capacitor temperature estimating units 61f1 and 61f2, and the coil temperature estimating unit 61g may be considered to have the similar configuration as the high-side FET temperature estimating unit 61a1.

However, these temperature estimating units and the high-side FET temperature estimating unit 61a1 are different from each other in the conversion gain G1 of the gain multiplying unit 73, the first cutoff frequency fc1 of the first low-pass filter 74 and he second cutoff frequency fc2 of the second low-pass filter 75, and a way of calculating the power loss W in the power loss calculating unit 72.

For example, the conversion gain G1 of the gain multiplying unit 73 and the first cutoff frequency fc1 of the first low-pass filter 74 and the second cutoff frequency fc2 of the second low-pass filter 75 may be set to different values among the electronic components disposed at different locations. These conversion gains G1, these first cutoff frequencies fc1, and these second cutoff frequencies fc2 may be set as needed by simulation or the like in advance.

Also, the method of calculating the power loss W in the power loss calculating unit 72 may differ for each of the electronic components having different heat generation modes.

For example, the power loss calculating unit 72 of the high-side FET temperature estimating unit 61a2 estimates the ON-resistance Rf of the FETs based on the previous value of the component temperature Tea2 of the high-side FET Q3 calculated in the previous control cycle. Then, the power loss calculating unit 72 calculates a power loss W in the high-side FET Q3 based on the ON-resistance Rf, the duty ratio Db of the phase B voltage control command value, the phase B current I1bd, the supply voltage VRA, the switching loss generation time Tsw, the body diode forward voltage Vdsf, the body diode current generation time Td and the motor drive PWM frequency fpwm.

For example, the power loss calculating unit 72 of the high-side FET temperature estimating unit 61a2 may calculate the power loss W based on the following calculation formulas.

$$W = Rf \times Db \times I1bd^2 + (1/6) \times VRA \times I1bd \times Tsw \times fpwm \text{ (where } I1bd \geq 0)$$

$$W = Rf \times Db \times I1bd^2 - Vdsf \times I1bd \times Td \times fpwm \text{ (where } I1bd < 0)$$

In addition, for example, the power loss calculating unit 72 of the high-side FET temperature estimating unit 61a3 estimates the ON-resistance Rf of the FETs based on the previous value of the component temperature Tea3 of the high-side FET Q5 calculated in the previous control cycle. Then, the power loss calculating unit 72 calculates a power loss W in the high-side FET Q5 based on the ON-resistance Rf, the duty ratio Dc of the phase C voltage control command value, the phase C current I1cd, the supply voltage VRA, the switching loss generation time Tsw, the body diode forward voltage Vdsf, the body diode current generation time Td and the motor drive PWM frequency fpwm.

For example, the power loss calculating unit 72 of the high-side FET temperature estimating units 61a3 may calculate the power loss W based on the following calculation formulas.

$$W = Rf \times Dc \times I1cd^2 + (1/6) \times VRA \times I1cd \times Tsw \times fpwm \text{ (where } I1cd \geq 0)$$

$$W = Rf \times Dc \times I1cd^2 - Vdsf \times I1cd \times Td \times fpwm \text{ (where } I1cd < 0)$$

In addition, for example, the power loss calculating unit 72 of the low-side FET temperature estimating unit 61b1 estimates the ON-resistance Rf of the FETs based on the previous value of the component temperature Teb1 of the low-side FET Q2 calculated in the previous control cycle. Then, the power loss calculating unit 72 calculates a power loss W in the low-side FET Q2 based on the ON-resistance Rf, the duty ratio Da of the phase A, the phase A current I1ad, the supply voltage VRA, the switching loss generation time Tsw, the body diode forward voltage Vdsf, the body diode current generation time Td and the motor drive PWM frequency fpwm.

For example, the power loss calculating unit 72 of the low-side FET temperature estimating unit 61b1 may calculate the power loss W based on the following calculation formulas.

$$W = Rf \times (1 - Da) \times I1ad^2 - (1/6) \times VRA \times I1ad \times Tsw \times fpwm \text{ (where } I1ad > 0)$$

$$W = Rf \times (1 - Da) \times I1ad^2 + Vdsf \times I1ad \times Td \times fpwm \text{ (where } I1ad > 0)$$

In addition, for example, the power loss calculating unit 72 of the low-side FET temperature estimating unit 61b2 estimates the ON-resistance Rf of the FETs based on the previous value of the component temperature Teb2 of the low-side FET Q4 calculated in the previous control cycle. Then, the power loss calculating unit 72 calculates a power loss W in the low-side FET Q4 based on the ON-resistance Rf, the duty ratio Db of the phase B, the phase B current I1bd, the supply voltage VRA, the switching loss generation time Tsw, the body diode forward voltage Vdsf, the body diode current generation time Td and the motor drive PWM frequency fpwm.

For example, the power loss calculating unit 72 of the low-side FET temperature estimating units 61b2 may calculate the power loss W based on the following calculation formulas.

$$W = Rf \times (1 - Db) \times I1bd^2 - (1/6) \times VRA \times I1bd \times Tsw \times fpwm \text{ (where } I1bd < 0)$$

$$W = Rf \times (1-Db) \times I1bd^2 + Vdsf \times I1bd \times Td \times fpwm \text{ (where } I1bd > 0)$$

In addition, for example, the power loss calculating unit 72 of the low-side FET temperature estimating unit 61b3 estimates the ON-resistance Rf of the FETs based on the previous value of the component temperature Teb3 of the low-side FET Q6 calculated in the previous control cycle. Then, the power loss calculating unit 72 calculates a power loss W in the low-side FET Q6 based on the ON-resistance Rf, the duty ratio Dc of the phase C, the phase C current I1cd, the supply voltage VRA, the switching loss generation time Tsw, the body diode forward voltage Vdsf, the body diode current generation time Td and the motor drive PWM frequency fpwm.

For example, the power loss calculating unit 72 of the low-side FET temperature estimating units 61b3 may calculate the power loss W based on the following calculation formulas.

$$W = Rf \times (1 - Dc) \times I1cd^2 - (1/6) \times VRA \times I1cd \times Tsw \times fpwm \text{ (where } I1cd < 0)$$

$$W = Rf \times (1 - Dc) \times I1cd^2 + Vdsf \times I1cd \times Td \times fpwm \text{ (where } I1cd > 0)$$

Also, the power loss calculating unit 72 of the shunt resistance temperature estimating unit 61c1 estimates the resistance value Rs of the shunt resistor based on the previous value of the component temperature Tec1 of the shunt resistor of the current detection circuit 39A1 calculated in the previous control cycle. Based on the shunt resistor Rs and the phase A duty ratio Da, and the phase A current I1ad, the power loss calculating unit 72 calculates the power loss W in the shunt resistor of the current detection circuit 39A1.

For example, the power loss calculating unit 72 of the shunt resistance temperature estimating unit 61c1 may calculate the power loss W based on the following calculation formula.

$$W = Rs \times (1-Da) \times I1ad^2$$

Also, the power loss calculating unit 72 of the shunt resistance temperature estimating unit 61c2 estimates the resistance value Rs of the shunt resistor based on the previous value of the component temperature Tec2 of the shunt resistor of the current detection circuit 39B1 calculated in the previous control cycle. Based on the shunt resistor Rs and the phase B duty ratio Db, and the phase B current I1bd, the power loss calculating unit 72 calculates the power loss W in the shunt resistor of the current detection circuit 39B1.

For example, the power loss calculating unit 72 of the shunt resistance temperature estimating unit 61c2 may calculate the power loss W based on the following calculation formula.

$$W = Rs \times (1-Db) \times I1bd^2$$

Also, the power loss calculating unit 72 of the shunt resistance temperature estimating unit 61c3 estimates the resistance value Rs of the shunt resistor based on the previous value of the component temperature Tec3 of the shunt resistor of the current detection circuit 39C1 calculated in the previous control cycle. Based on the shunt resistor Rs and the phase C duty ratio Dc, and the phase C current I1cd, the power loss calculating unit 72 calculates the power loss W in the shunt resistor of the current detection circuit 39C1.

For example, the power loss calculating unit 72 of the shunt resistance temperature estimating unit 61c3 may calculate the power loss W based on the following calculation formula.

$$W = Rs \times (1-Dc) \times I1cd^2$$

In addition, for example, the power loss calculating unit 72 of the phase cutoff FET temperature estimating units 61d1 estimates the ON-resistance Rf of the FETs based on the previous value of the component temperature Ted1 of the phase cutoff FET QA1 calculated in the previous control cycle. Then, based on the On-resistance Rf and the phase A current I1ad, the power loss W in the phase cutoff FET QA1 is calculated.

For example, the power loss calculating unit 72 of the phase cutoff FET temperature estimating unit 61d1 may calculate the power loss W based on the following calculation formula.

$$W = Rf \times I1ad^2$$

In addition, for example, the power loss calculating unit 72 of the phase cutoff FET temperature estimating units 61d2 estimates the ON-resistance Rf of the FETs based on the previous value of the component temperature Ted2 of the phase cutoff FET QA2 calculated in the previous control cycle. Then, based on the On-resistance Rf and the phase B current I1bd, the power loss W in the phase cutoff FET QA2 is calculated.

For example, the power loss calculating unit 72 of the phase cutoff FET temperature estimating unit 61d2 may calculate the power loss W based on the following calculation formula.

$$W = Rf \times I1bd^2$$

In addition, for example, the power loss calculating unit 72 of the phase cutoff FET temperature estimating units 61d3 estimates the ON-resistance Rf of the FETs based on the previous value of the component temperature Ted3 of the phase cutoff FET QA3 calculated in the previous control cycle. Then, based on the On-resistance Rf and the phase C current I1cd, the power loss W in the phase cutoff FET QA3 is calculated.

For example, the power loss calculating unit 72 of the phase cutoff FET temperature estimating unit 61d3 may calculate the power loss W based on the following calculation formula.

$$W = Rf \times I1cd^2$$

For example, the power loss calculating unit 72 of the power cutoff FET temperature estimating units 61e1 and 61e2 estimate the ON-resistance Rf of the power cutoff FETs QC1 and QC2 based on the previous values of the component temperatures Tee1 and Tee2 of the power cutoff FETs QC1 and QC2 calculated in the previous control cycle. Then, the power loss W of each of the power cutoff FETs QC1 and QC2 is calculated based on the ON-resistance Rf and the Battery current Ibat1.

For example, the power loss calculating unit 72 of the power cutoff FET temperature estimating units 61e1 and 61e2 may calculate the power loss W based on the following calculation formula.

$$W = Rf \times Ibat1^2$$

For example, the capacitor temperature estimating units 61f1 and 61f2 estimate Equivalent Series Resistances (ESR) Resr of the electrolytic capacitors CA1 and CA2 respectively based on the previous values of the component temperatures Tef1, Tef2 of the electrolytic capacitors CA1 and CA2 of the first power conversion circuit 42A calculated in the previous control cycle. The power loss calculating unit 72 of the capacitor temperature estimating units 61f1 and 61f2 then calculate the power loss W of each of the electrolytic capacitors CA1 and CA2 based on the equivalent series resistance Resr and the d-axis current id and the q-axis current iq calculated by the 3-phase/2-phase converting unit 56.

For example, the power loss calculating unit 72 of the capacitor temperature estimating units 61f1 and 61f2 may calculate the power loss W based on the following calculation formulas.

$$W = Rf \times (Id^2 + Iq^2)$$

The coil temperature estimating unit 61g estimates a series resistance Rdc of the choke coil La of the noise filter circuit based on the previous value of the coil temperature Teg calculated in the previous control cycle. The power loss calculating unit 72 of the coil temperature estimating unit 61g then calculates the power loss W in the choke coil La based on the series resistance Rdc and the battery current Ibat1 and Ibat2.

For example, the power loss calculating unit 72 of the coil temperature estimating unit 61g may calculate the power loss W based on the following calculation formulas.

$$W = Rdc \times (Ibat1 + Ibat2)^2$$

Note that if the driving of the second system coil is prohibited, the power loss W can be calculated by substituting the battery current Ibat2 with 0[A]. When the data of the battery current Ibat2 cannot be acquired from the control calculating apparatus 31b due to the reason such as abnormality or the like of the communication line 35, the value of the battery current Ibat2 can be substituted with the value of the battery current Ibat1.

Refer to FIG. 6. The selector 62a selects any one of the component temperatures Teal to Tea3 of the high-side FETs Q1, Q3 and Q5 estimated by the high-side FET temperature estimating units 61a1 to 61a3 as a high-side FET temperature Tea. For example, the selector 62a may select the highest temperature out of the component temperatures Teal to Tea3 as the high-side FET temperature Tea.

The selector 62b selects any one of the component temperatures Teb1 to Teb3 of the low-side FET Q2, Q4, and Q6 estimated by the low-side FET temperature estimating units 61b1 to 61b3 as a low-side FET temperature Teb. For example, the selector 62b may select the highest temperature among the component temperatures Teb1 to Teb3 as the low-side FET temperature Teb.

The selector 62c selects any one of the component temperatures Tec1 to Tec3 of the shunt resistor estimated by the shunt resistance temperature estimating units 61c1 to 61c3 as the shunt resistance temperature Tec. For example, the selector 62c may select the highest temperature among the component temperatures Tec1 to Tec3 as the shunt resistance temperature Tec.

The selector 62d selects any one of the component temperatures Ted1 to Ted3 of the phase cutoff FETs QA1, QA2, and QA3 estimated by the phase cutoff FET temperature estimating units 61d1 to 61d3 as the phase cutoff FET temperature Ted. For example, the selector 62d may select the highest temperature among the component temperatures Ted1 to Ted3 as the phase cutoff FET temperature Ted.

The selector 62e selects any one of the component temperatures Tee1 and Tee2 of the power cutoff FETs QC1 and QC2 estimated by the power cutoff FET temperature estimating units 61e1 and 61e2 as the power cutoff FET temperature Tee. The selector 62e may select a temperature higher than either one of the component temperatures Tee1 and Tee2 as the power cutoff FET temperature Tee.

The selector 62f selects either one of the component temperatures Tef1 and Tef2 of the electrolytic capacitors CA1 and CA2 estimated by the capacitor temperature estimating units 61f1 and 61f2 as the capacitor temperature Tef. For example, the selector 62f may select a temperature higher than either one of the component temperatures Tef1 and Tef2 as the capacitor temperature Tef.

The high-side FET reduction coefficient setting unit 63a sets a high-side FET reduction coefficient Ka, which is a reduction coefficient for limiting the current that drives the first system coil based on the high-side FET temperature Tea.

FIG. 8 is a schematic illustration illustrating an example of a characteristic map illustrating the characteristics of the high-side FET reduction coefficient Ka set by the high-side FET reduction coefficient setting unit 63a. The high-side FET reduction coefficient setting unit 63a sets the high-side FET reduction coefficient Ka to a maximum value Kmax when the high-side FET temperature Tea is lower than the first temperature T1. The maximum value Kmax may be, for example, greater than 0 [%] and less than or equal to 100 [%].

The high-side FET reduction coefficient setting unit 63a sets the high-side FET reduction coefficient Ka to the maximum value Kmax in order to impart hysteresis characteristics to the high-side FET reduction coefficient Ka in a state in which the high-side FET reduction coefficient Ka is at its maximum value Kmax, as long as the high-side FET temperature Tea is lower than the second temperature T2, which is higher than the first temperature T1.

When the high-side FET temperature Tea exceeds the second temperature T2 in a state in which the high-side FET reduction coefficient Ka is at its maximum value Kmax, the high-side FET reduction coefficient setting unit 63a reduces the high-side FET reduction coefficient Ka from the maximum value Kmax to a minimum value Kmin until the high-side FET temperature Tea reaches a third temperature T3, which is higher than the second temperature T2. The minimum value Kmin may be, for example, less than 100 [%] and greater than or equal to 0 [%]. The high-side FET reduction coefficient setting unit 63a sets the high-side FET reduction coefficient Ka to a minimum value Kmin when the high-side FET temperature Tea is higher than the third temperature T3.

In a state in which the high-side FET reduction coefficient Ka is at it minimum value Kmin, the high-side FET reduction coefficient setting unit 63a sets the high-side FET reduction coefficient Ka to the minimum value Kmin as long as the high-side FET temperature Tea is lower than a fourth temperature T4, which is lower than the third temperature T3. When the high-side FET temperature Tea becomes smaller than the fourth temperature T4 in a state in which the high-side FET reduction coefficient Ka is at its minimum value Kmin, the high-side FET reduction coefficient setting unit 63a increases the high-side FET reduction coefficient Ka from the minimum value Kmin to a maximum value Kmax until the high-side FET temperature Tea reaches the first temperature T1.

A margin width ΔT3, which is a difference between a rated temperature Tn as the electronic component of the high-side FET Q1 to the third temperature T3, a reduction width ΔT4, which is a difference between the first temperature T1 and the fourth temperature T4, a reduction width ΔT2, which is a difference between the second temperature T2 and the third temperature T3, and a hysteresis width ΔT1, which is a difference between the first temperature T1 and the second temperature T2 may be set in advance as needed by simulation or the like. The rated temperature Tn may be set as needed according to the high-side FET Q1 used. Note that the reduction width ΔT2 and the reduction width ΔT4 may be set to the same value, and the reduction width ΔT2 and the reduction width ΔT4 may be set to different values. For example, the hysteresis width on the high-temperature side may be increased by setting the reduction width ΔT4 to a width smaller than the reduction width ΔT2.

Refer to FIG. 6. The low-side FET reduction coefficient setting unit 63b sets a low-side FET reduction coefficient Kb for limiting the current that drives the first system coil based on the low-side FET temperature Teb. The shunt resistance reduction coefficient setting unit 63c sets a shunt reduction coefficient Kc for limiting the current that drives the first system coil based on the shunt resistance temperature Tec. The phase cutoff FET reduction coefficient setting unit 63d sets a phase cutoff FET reduction coefficient Kd for limiting the current that drives the first system coil based on the phase cutoff FET temperature Ted.

The power cutoff FET reduction coefficient setting unit 63e sets a power cutoff FET reduction coefficient Ke for limiting the current that drives the first system coil based on the power cutoff FET temperature Tee. The capacitor reduction coefficient setting unit 63f sets a capacitor reduction coefficient kf for limiting the current that drives the first system coil based on the capacitor temperature Tef. The coil reduction coefficient setting unit 63g sets a coil reduction coefficient Kg for limiting the current that drives the first system coil based on the coil temperature Teg.

The low-side FET reduction coefficient setting unit 63b, the shunt resistance reduction coefficient setting unit 63c, the phase cutoff FET reduction coefficient setting unit 63d, the power cutoff FET reduction coefficient setting unit 63e, the capacitor reduction coefficient setting unit 63f, and the coil reduction coefficient setting unit 63g may set the low-side FET reduction coefficient Kb, the shunt reduction coefficient Kc, the phase cutoff FET reduction coefficient Kd, the power cutoff FET reduction coefficient Ke, the capacitor reduction coefficient Kf, and the coil reduction coefficient Kg having the same characteristics as the characteristic map in FIG. 8.

It is also applicable to set at least one of the rated temperature Tn, the hysteresis width $\Delta T1$, the reduction widths $\Delta T2$ and $\Delta T4$, and the margin width $\Delta T3$ in the characteristic map in FIG. 8 to a different value among different types of electronic components. In other words, at least one of the first temperature T1 to the fourth temperature T4 may be set to a different value among different types of electronic components.

For example, at least one of the rated temperature Tn, the hysteresis width $\Delta T1$, the reduction widths $\Delta T2$ and $\Delta T4$, and the margin width $\Delta T3$ may be set to a different value among the FETs (the high-side FETs Q1, Q3, and Q5, the low-side FETs Q2, Q4, and Q6, the phase cutoff FETs QA1 to QA3, the power cutoff FETs QC1 and QC2), the resistance (shunt resistor), the capacitors (electrolytic capacitors CA1 and CA2), and coil (choke coil Lp). These hysteresis width $\Delta T1$, the reduction widths $\Delta T2$ and $\Delta T4$, and the margin width $\Delta T3$ may be set as needed in advance, for example, by simulation. The rated temperature Tn may be set as needed according to the electronic component used.

The selector 64 selects any one of the high-side FET reduction coefficient Ka, the low-side FET reduction coefficient Kb, the shunt reduction coefficient Kc, the phase cutoff FET reduction coefficient Kd, the power cutoff FET reduction coefficient Ke, the capacitor reduction coefficient Kf, and the coil reduction coefficient Kg as the component reduction coefficient K1. For example, the selector 64 may select the smallest coefficient among the above-described reduction coefficients Ka to Kg as the component reduction coefficient K1.

FIGS. 9A to 9C are schematic illustration of an example of a setting operation of the component reduction coefficient K1. For the sake of simplify the description, it is here assumed that the low-side FET reduction coefficient Kb, the shunt reduction coefficient Kc, the phase cutoff FET reduction coefficient Kd, the power cutoff FET reduction coefficient Ke, and the capacitor reduction coefficient Kf are fixed to the maximum value Kmax. It is also assumed that the selector 64 selects the smallest coefficient among the reduction coefficients Ka to Kg as the component reduction coefficient K1.

As illustrated in FIG. 9A, the high-side FET reduction coefficient Ka is set to the maximum value Kmax from the time t0 to the time t3, then starts to reduce at the time t3, then is reduced to values K11, K13, and K15 at the time t4, the time t5, and the time t6, respectively.

In contrast, as illustrated in FIG. 9B, the coil reduction coefficient Kg is set to the maximum value Kmax from the time t0 to the time t1, then starts to reduce at the time t1, and is reduced to the value K12 at the time t2, which is earlier than the time t3. The value K12 is smaller than the value K11 and is greater than the value K13. Subsequently, the coil reduction coefficient Kg is set to the value K12 during the period from the time t2 to the time t4, and then is reduced to K13 and K14 at the time t5 and t6, respectively. The value K14 is smaller than the value K13 and is greater than the value K15.

When the selector 64 selects the smaller one of the high-side FET reduction coefficient Ka and the coil reduction coefficient Kg as the component reduction coefficient K1, the selector 64 sets the component reduction coefficient K1 to the maximum value Kmax from the time t0 to the time t1, selects the coil reduction coefficient Kg as the component reduction coefficient K1 from the time t1 to the time t5, and selects the high-side FET reduction coefficient Ka as the component reduction coefficient K1 from the time t5 onward.

Consequently, the component reduction coefficient K1 is set to the maximum value Kmax from the period from the time t0 to the time t1, starts to reduce at the time t1, and reduces to the value K12 at the time t2. During the period from the time t2 to the time t4, the component reduction coefficient K1 is set to K12, and then is reduced to K13 and K15 at the time t5 and the time t6, respectively.

Refer to FIG. 5. The second reduction coefficient setting unit 70 estimates the ECU temperature based on the detection signal SdA outputted by the temperature detection circuit 45A. Based on the detected values I1ad, I1bd, and I1cd of the phase A current, the phase B current and the phase C current, the rising value of the temperature in the motor 20 due to the motor current (for example, the temperature of the winding coil of the first system coil) is estimated, and the sum of the ECU temperature and the raised value is estimated as the motor temperature.

The second reduction coefficient setting unit 70 sets the ECU reduction coefficient K2 based on the ECU temperature. For example, the second reduction coefficient setting unit 70 may set the ECU reduction coefficient K2 having the characteristics similar to that in the characteristic map in FIG. 8 for variation of ECU temperature.

The second reduction coefficient setting unit 70 sets the motor reduction coefficient K3 based on the motor temperature. For example, the second reduction coefficient setting unit 70 may set the motor reduction coefficient K3 having the characteristics similar to that in the characteristic map in FIG. 8 for variation of motor temperature.

The third reduction coefficient setting unit 71 sets the battery reduction coefficient K4 based on the battery voltage Vbat1, which is a voltage between output terminals of the battery 13. FIG. 10 is a schematic illustration of an example of the characteristic map of the battery reduction coefficient K4 set by the third reduction coefficient setting unit 71. The third reduction coefficient setting unit 71 sets the battery reduction coefficient K4 to the minimum value K4min when the battery voltage Vbat1 is lower than the first voltage V1. The minimum value K4min may be, for example, less than 100 [%] and greater than or equal to 0 [%].

When the battery voltage Vbat1 is in the range from the first voltage V1 to the second voltage V2, the higher the battery voltage Vbat1 is, the greater battery reduction coefficient K4 the third reduction coefficient setting unit 71 sets, and when the battery voltage Vbat1 reaches the second voltage V2, sets the battery reduction coefficient K4 to the maximum value K4max. The maximum value K4max may be, for example, a value greater than 0 [%] and equal to or smaller than 100 [%].

When the battery voltage Vbat1 is in the range from the second voltage V2 to the third voltage V3, the third reduction coefficient setting unit 71 sets the battery reduction coefficient K4 to the maximum value K4max.

When the battery voltage Vbat1 is in the range from the third voltage V3 to the fourth voltage V4, the higher the battery voltage Vbat1 is, the smaller battery reduction coefficient K4 the third reduction coefficient setting unit 71 sets, and when the battery voltage Vbat1 reaches the four voltage V4, sets the battery reduction coefficient K4 to the minimum value K4min.

The third reduction coefficient setting unit 71 sets the battery reduction coefficient K4 to the minimum value K4min when the battery voltage Vbat1 is higher than the fourth voltage V4.

Refer to FIG. 5. The current limiting unit 51 limits the q-axis current command value Iq0 and d-axis current command value Id0 based on the component reduction coefficient K1, the ECU reduction coefficient K2, the motor reduction coefficient K3, and the battery reduction coefficient K4, and outputs the limited q-axis current command value Iq1 and the limited d-axis current command value Id1.

For example, the current limiting unit 51 may select the minimum coefficient out of the component reduction coefficient K1, the ECU reduction coefficient K2, and motor reduction coefficient K3, and the battery reduction coefficient K4 as the reduction coefficient K, and limit the q-axis current command value Iq0 and the d-axis current command value Id0 based on the reduction coefficient K. For example, the q-axis current command value Iq0 and the d-axis current command value Id0 may be limited so that the smaller the reduction coefficient K, the smaller the limited q-axis current command value Iq1 and the limited d-axis current command value Id1 will be. For example, the product of each of the q-axis current command value Iq0 and the d-axis current command value Id0 multiplied by the reduction coefficient K may be calculated as limited q-axis current command value $Iq1 = K \times Iq0$ and limited d-axis current command value $Id1 = K \times Id0$.

(Operation)

FIG. 11 is an example flowchart of a process in the control calculating apparatus 31a.

In Step S1, the first reduction coefficient setting unit 60 and the second reduction coefficient setting unit 70 acquires a detection signal SdA of the temperature detection circuit 45A.

In Step S2, the current detection circuits 39A1, 39B1, and 39C1 detect the phase A current I1ad, the phase B current I1bd, and the phase C current I1cd of the first system coil.

Step S3, the voltage detection circuit 34A detects the supply voltage VRA of the first power conversion circuit 42A.

In Step S4, the control calculating apparatus 31a calculates the battery current Ibat1 flowing from the battery 13 to the first system coil based on the phase A current I1ad, the phase B current I1bd, and the phase C current I1cd. The control calculating apparatus 31a also receives the battery current Ibat2 flowing from the battery 13 to the second system coil from the control calculating apparatus 31b.

In Step S5, the first reduction coefficient setting unit 60 estimates the power loss W in each of the plurality of electronic components which constitute the first current control circuit 40A based on the phase A current I1ad, the phase B current I1bd, the phase C current I1cd, the battery currents Ibat1 and Ibat2, and the supply voltage VRA.

In Step S6, the first reduction coefficient setting unit 60 estimates the component temperature of each of the plurality of electronic components which constitute the first current control circuit 40A based on the power loss W and the detection signal SdA.

In Step S7, the second reduction coefficient setting unit 70 estimates the ECU temperature based on the detection signal SdA. The second reduction coefficient setting unit 70 also estimates the motor temperature based on the phase A current I1ad, the phase B current I1bd, and the phase C current I1cd based on the ECU temperature.

In Step S8, the first reduction coefficient setting unit 60 sets the component reduction coefficient K1 based on the estimated component temperature of each of the plurality of electronic components.

In Step S9, the second reduction coefficient setting unit 70 sets the ECU reduction coefficient K2 based on the estimated ECU temperature.

In Step S10, the second reduction coefficient setting unit 70 sets the motor reduction coefficient K3 based on the estimated motor temperature.

In Step S11, the third reduction coefficient setting unit 71 sets the battery reduction coefficient K4 based on the battery voltage Vbat1, which is a voltage between output terminals of the battery 13.

In Step S12, the current limiting unit 51 limits the drive current of the first system coil based on the component reduction coefficient K1, the ECU reduction coefficient K2, the motor reduction coefficient K3, and the battery reduction coefficient K4. The process is then ended.

Note that the configuration and the process of the control calculating apparatus 31b is the same as the configuration and the process of the control calculating apparatus 31a described above. Therefore, in reading the above-described description, "temperature detection circuit 45A" is replaced with "temperature detection circuit 45B", "detection signal SdA, SdA1, SdA2" is replaced with "detection signal SdB, SdB1, SdB2", "first system coil" is replaced with "second system coil", "phase A current I1ad, phase B current I1bd, phase C current I1cd" is replaced with "phase A current I2ad, phase B current I2bd, phase C current I2cd", "control calculating apparatus 31a" is replaced with "control calculating apparatus 31b", "battery current Ibat1" is replaced with "battery current Ibat2", "control calculating apparatus 31b" is replaced with "control calculating apparatus 31a", "voltage detection circuit 34A" is replaced with "voltage detection circuit 34B", "first power conversion circuit 42A" is replaced with "second power conversion circuit 42B", and "supply voltage VRA" is replaced with "supply voltage VRB".

(Effect of the First Embodiment)

(1) The current control apparatus according to the first embodiment includes: a current control circuit including a plurality of electronic components; a temperature detection circuit having a temperature detecting element disposed in the vicinity of the current control circuit; a current detecting unit configured to detect or estimate current values flowing to each of the plurality of electronic components; a component temperature estimating unit configured to estimate a component temperature, which is the temperature of the electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient.

This can suppress overheating of the plurality of electronic components included in the current control circuit that are susceptible to thermal damage. For example, even when the components with a large heat generation rate change due to the changes in the energizing pattern in the current control circuit, the reduction coefficient can be set according to the components that are more susceptible to thermal damage due to the increase in heat generation rate. The reduction coefficient can be set according to the characteristics of each component (for example, rated voltage) and the component temperature, depending on the component susceptible to thermal damage. By setting the reduction coefficient according to the needs of individual components, excessive limitation of drive current can be suppressed.

(2) The plurality of electronic components may include electronic components with different heat generation modes. The component temperature estimating unit estimates the component temperature of each of the electronic components with different heat generation modes based on the resistance value of the electronic component, the current value, and the energization time of the current flowing to the electronic component (for example, energization duty ratio), and the detected temperature detected by the temperature detection circuit.

This allows individual component temperatures to be estimated according to the heat generation modes of each electronic component.

(3) A plurality of electronic components may include a plurality of different types of electronic components. The reduction coefficient setting unit may set one reduction coefficient for each type of electronic component.

By setting reduction coefficients for a plurality of electronic components of the same type together, the calculation load required for the process of setting reduction coefficients when estimating component temperatures for each of the plurality of electronic components can be reduced.

(4) At least one of the plurality of different types of electronic components may include a plurality of electronic components disposed at different locations in the current control circuit. The current control apparatus may include a second selecting unit configured to select any one of the component temperatures estimated for each of the plurality of electronic components disposed at different locations. The reduction coefficient setting unit may set the reduction coefficient for at least one type of electronic component based on the component temperature selected by the second selecting unit.

By grouping electronic components based on component types and locations and setting a reduction coefficient for each group, the calculation load required for the process of setting reduction coefficients when estimating component temperatures for each of the plurality of electronic components can be reduced.

(5) The component temperature estimating unit may estimate the power loss generated in electronic component for each of the plurality of electronic components. The component temperature estimating unit may estimate the component temperature for each of the plurality of electronic components based on the sum of the value obtained by first low-pass filtering the product of the power loss and the predetermined gain and the value obtained by second low-pass filtering the detected temperature detected by the temperature detection circuit.

By estimating the component temperature based on the value obtained by the first low-pass filtering of the power loss, the component temperature can be estimated with high accuracy. By the second low-pass filtering the detected temperature detected by the temperature detection circuit, an estimated value of the ambient temperature in the proximity of individual electronic components can be obtained. If the electronic component is thermally connected to a heat sink, the heat sink temperature in the proximity of the electronic component can be obtained.

FIG. 12 is a schematic illustration of the effect of the second low-pass filtering. Reference numerals 100, 101, and 102 schematically illustrate electronic components provided on the circuit board 36. The component temperature estimating unit estimates the individual temperatures of the electronic components 100 to 102 by adding the temperature change due to power loss of each of the electronic components 100 to 102 to the ambient temperature. Therefore, if the detected value of the temperature detection circuit is used as it is as the ambient temperature when estimating the component temperature of the electronic components 100 and 101, it is affected by the heat generated by the other electronic components 102 disposed near the temperature sensors 45A1 and 45A2 of the temperature detection circuit and thus the component temperature around the electronic components 100 and 101 cannot be properly estimated. Therefore, by the second low-pass filtering the detected temperature detected by the temperature detection circuit, the ambient temperature in the vicinity of individual electronic components can be estimated with high accuracy by suppressing the effect of heat generated by the 102 electronic components in the proximity of the temperature sensors 45A1 and 45A2.

(6) The plurality of electronic components may include electronic components disposed at different locations in the current control circuit. At least one of the above-described predetermined gains, the cutoff frequency of the first low-pass filtering, and the cutoff frequency of the second low-pass filtering may be set to a different value among electronic components disposed at different locations.

This allows the component temperatures to be estimated individually based on locations where electronic components are disposed. For example, as illustrated in FIG. 12, the distance between temperature sensors 45A1 and 45A2 and individual electronic components 100 to 102 differs depending on the electronic components 100 to 102. Therefore, by setting the cutoff frequency of the second low-pass filtering to different values among the electronic components the effect of the difference in distance between the temperature sensor and electronic components can be suppressed.

(7) The current limiting unit may limit the output current so that the smaller the reduction coefficient, the smaller the output current outputted from the current control circuit to the load. The reduction coefficient setting unit may set the reduction coefficient to the maximum value when the component temperature is lower than a first temperature, and reduce the reduction coefficient from the maximum value to a minimum value until the component temperature reaches a third temperature, which is higher than the second temperature when the component temperature exceeds a second temperature which is higher than the first temperature in a state in which the reduction coefficient is at its maximum value, set the reduction coefficient to the minimum value when the component temperature is higher than the third temperature, and increase the reduction coefficient from the minimum value to the maximum value until the component temperature reaches the first temperature when the component temperature reaches a fourth temperature which is lower than the third temperature in a state in which the reduction coefficient is at its minimum value. The plurality of electronic components may include electronic components with different heat generation modes, and at least one of the first temperature, the second temperature, the third temperature, and the fourth temperature may be set to a different value among electronic components with different heat generation modes.

This allows the reduction coefficient to be set individually according to the heat generation modes of electronic components.

(8) The current control apparatus may include a heat sink to dissipate heat generated from the current control circuit. The temperature detecting element may be thermally coupled to the heat sink.

This makes it easier to detect the overall temperature of the electronic components of the current control circuit with the temperature detecting element.

Second Embodiment

In the first embodiment, one of the component temperatures estimated for each of a plurality of electronic components of the same type disposed at different locations respectively is selected, and the reduction coefficients for these electronic components are set based on the selected component temperature. For example, one of the component temperatures Teal to Tea3 of the high-side FETs Q1, Q3, and Q5 estimated by the high-side FET temperature estimating units 61a1 to 61a3 is selected as the high-side FET temperature Tea, and the high-side FET reduction coefficient Ka is set based on the high-side FET temperature Tea.

In the second embodiment, a plurality of different reduction coefficients are set for a plurality of electronic components of the same type, each disposed at different locations. For example, a plurality of high-side FET reduction coefficients Ka1 to Ka3 may be set based on each of the component temperatures Teal to Tea3 of high-side FETs Q1, Q3 and Q5. Similarly, for the low-side FETs Q2, Q4, and Q6, the shunt resistors, the phase cutoff FETs QA1 to QA3, the power cutoff FETs QC1 and QC2, and the electrolytic capacitors CA1 and CA2, a plurality of low-side FET reduction coefficients Kb1 to Kb3, shunt reduction coefficients Kc1 to Kc3, phase cutoff FET reduction coefficients Kd1 to Kd3, power cutoff FET reduction coefficients Ke1 and Ke2, and capacitor reduction coefficients Kf1 and Kf2, respectively, may be set.

Then, any one of the high-side FET reduction coefficients Ka1 to Ka3, the low-side FET reduction coefficients Kb1 to Kb3, the shunt reduction coefficients Kc1 to Kc3, the phase cutoff FET reduction coefficients Kd1 to Kd3, the power cutoff FET reduction coefficients Ke1 and Ke2, the capacitor reduction coefficients Kf1 and Kf2, and the coil reduction coefficient Kg is selected as the component reduction coefficient K1.

In this manner, by selecting one of the reduction coefficients set for each of the plurality of electronic components of the same type disposed at different locations as the component reduction coefficient K1, it is possible to limit the output current more finely based on the electronic components.

FIG. 13 is a block diagram of an example of the functional configuration of the first reduction coefficient setting unit 60 according to the second embodiment. The first reduction coefficient setting unit 60 of the second embodiment has a similar configuration to the first reduction coefficient setting unit 60 of the first embodiment described with reference to FIG. 6, and the same or similar components are indicated by the same reference numerals and duplicate descriptions are omitted. The first reduction coefficient setting unit 60 of the second embodiment has high-side FET reduction coefficient setting units 63a1 to 63a3, low-side FET reduction coefficient setting units 63b1 to 63b3, shunt resistance reduction coefficient setting units 63c1 to 63c3, phase cutoff FET reduction coefficient setting units 63d1 to 63d3, power cutoff FET reduction coefficient setting units 63e1 and 63e2, and capacitor reduction coefficient setting units 63f1 and 63f2, and coil reduction coefficient setting unit 63g.

The high-side FET reduction coefficient setting units 63a1 to 63a3 set a plurality of high-side FET reduction coefficients Ka1 to Ka3 based on each of the component temperatures Teal to Tea3 of high-side FETs Q1, Q3 and Q5. The low-side FET reduction coefficient setting units 63b1 to 63b3 set a plurality of low-side FET reduction coefficients Kb1 to Kb3 based on each of the component temperatures Teb1 to Teb3 of low-side FETs Q2, Q4 and Q6. The shunt resistance reduction coefficient setting units 63c1 to 63c3 set a plurality of shunt reduction coefficients Kc1 to Kc3 based on each of the component temperatures Tec1 to Tec3 of the shunt resistors of the current detection circuits 39A1, 39B1 and 39C1. The phase cutoff FET reduction coefficient setting units 63d1 to 63d3 set a plurality of phase cutoff FET reduction coefficients Kd1 to Kd3 based on each of the component temperatures Ted1 to Ted3 of the phase cutoff FETs QA1, QA2, and QA3. The power cutoff FET reduction coefficient setting units 63e1 and 63e2 set a plurality of power cutoff FET reduction coefficients Ke1 and Ke2 based on each of the component temperatures Tee1 and Tee2 of the power cutoff FETs QC1 and QC2. The capacitor reduction coefficient setting units 63f1 and 63f2 set a plurality of capacitor reduction coefficients Kf1 and Kf2 based on each of the component temperatures Tef1 and Tef2 of the electrolytic capacitors CA1 and CA2 of the first power conversion circuit 42A. The coil reduction coefficient setting unit 63g sets the coil reduction coefficient Kg based on the coil temperature Teg.

The high-side FET reduction coefficient setting units 63a1 to 63a3, the low-side FET reduction coefficient setting units 63b1 to 63b3, the shunt resistance reduction coefficient setting units 63c1 to 63c3, the phase cutoff FET reduction coefficient setting units 63d1 to 63d3, the power cutoff FET reduction coefficient setting units 63e1 and 63e2, the capacitor reduction coefficient setting units 63f1 and 63f2, and the coil reduction coefficient setting unit 63g may set the high-side FET reduction coefficients Ka1 to Ka3, the low-side FET reduction coefficients Kb1 to Kb3, the shunt reduction coefficients Kc1 to Kc3, the phase cutoff FET reduction coefficients Kd1 to Kd3, the power cutoff FET reduction coefficients Ke1 and Ke2, the capacitor reduction coefficients Kf1 and Kf2, and coil reduction coefficient Kg having the same characteristics as the characteristic map illustrated in FIG. 8.

It is also applicable to set at least one of the rated temperature Tn, the hysteresis width $\Delta T1$, the reduction widths $\Delta T2$ and $\Delta T4$, and the margin width $\Delta T3$ in the characteristic map in FIG. 8 to a different value among different types of electronic components.

In particular, at least one of the rated temperature Tn, the hysteresis width $\Delta T1$, the reduction widths $\Delta T2$ and $\Delta T4$, and the margin width $\Delta T3$ may be set to a different value among a plurality of electronic components of the same type disposed at different locations, respectively. For example, at least one of the rated temperature Tn, the hysteresis width ΔT1, the reduction widths ΔT2 and ΔT4, and the margin width ΔT3 may be set to a different value among the plurality of shunt reduction coefficients Kc1 to Kc3. The same is true for the low-side FET reduction coefficients Kb1 to Kb3, the shunt reduction coefficients Kc1 to Kc3, the phase cutoff FET reduction coefficients Kd1 to Kd3, the power cutoff FET reduction coefficients Ke1 and Ke2, and the capacitor reduction coefficients Kf1 and Kf2.

The selector 64 selects any one of the high-side FET reduction coefficients Ka1 to Ka3, the low-side FET reduction coefficients Kb1 to Kb3, the shunt reduction coefficients Kc1 to Kc3, the phase cutoff FET reduction coefficients Kd1 to Kd3, the power cutoff FET reduction coefficients Ke1 and Ke2, the capacitor reduction coefficients Kf1 and Kf2, and the coil reduction coefficient Kg as the component reduction coefficient K1. For example, the selector 64 may select the smallest coefficient out of the above reduction coefficients Ka1 to Ka3, Kb1 to Kb3, Kc1 to Kc3, Kd1 to Kd3, Ke1 and Ke2, Kf1 and Kf2 and Kg as the component reduction coefficient K1.

(Effect of Second embodiment)

The current control apparatus according to the second embodiment includes: a current control circuit including a plurality of electronic components; a temperature detection circuit having a temperature detecting element disposed in the vicinity of the current control circuit; a current detecting unit configured to detect or estimate current values flowing to each of the plurality of electronic components; a component temperature estimating unit configured to estimate a component temperature, which is the temperature of the electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient. The plurality of electronic components includes a plurality of different types of electronic components, and at least one type of electronic component among the plurality of different types of electronic components includes a plurality of electronic components disposed at different locations in the current control circuit. The reduction coefficient setting unit sets a plurality of different reduction coefficients each for a plurality of electronic components disposed at different locations in the current control circuit included in the at least one type of electronic component.

This can suppress overheating of the plurality of electronic components included in the current control circuit that are susceptible to thermal damage. For example, even when the components with a large heat generation rate change due to the changes in the energizing pattern in the current control circuit, the reduction coefficient can be set according to the components that are more susceptible to thermal damage due to the increase in heat generation rate. The reduction coefficient can be set according to the characteristics of each component (for example, rated voltage) and the component temperature, depending on the component susceptible to thermal damage. By setting the reduction coefficient according to the needs of individual components, excessive limitation of drive current can be suppressed.

Third Embodiment

Next, the third embodiment of the present invention will be described. There are two operating modes in which the current control apparatus drives the electric motor. One is a dual-system drive mode in which both the first system coil and the second system coil are driven, and another is a single-system drive mode in which only one of the first system coil and the second system coil is driven. In the dual-system drive mode, drive current is output to motor 20 from both the first current control circuit 40A and the second current control circuit 40B, while in the single-system drive mode, drive current is output to motor 20 from only one of them. For example, the current control apparatus operates in dual-system drive mode during normal operation and in single-system drive mode during abnormal conditions.

In the case of the dual-system drive mode, unlike the case of the single-system drive mode, the component temperature of the electronic components of the first current control circuit 40A is affected by the heat generated by the electronic components of the second current control circuit 40B, and conversely, the component temperature of the electronic components of the second current control circuit 40B is affected by the heat generated by the electronic components of the first current control circuit 40A. For example, the temperature of the heat-dissipating member 37 is higher in the dual-system drive mode than in the single-system drive mode, resulting in higher component temperatures and temperature sensor temperatures.

FIG. 14 is a graph illustrating temperatures when a specific magnitude of current is applied in order to investigate trends in component temperatures and temperatures of the temperature sensor during energization in each of the dual-system drive mode and the single-system drive mode. The solid line illustrates the trend of the component temperature of the high-side FET in single-system drive mode, the dashed line illustrates the trend of the component temperature of the high-side FET in dual-system drive mode, the single-dotted chain line illustrates the trend of the temperature of the temperature sensor in single-system drive mode, and the double-dotted chain line illustrates the trend of the temperature of the temperature sensor in the dual-system drive mode.

As illustrated in FIG. 14, the component temperatures of the components during energization are higher in the case of the dual-system drive mode than the case of the single-system drive mode. The temperature of the temperature sensor is also higher in the dual-system drive mode than in the single-system drive mode.

Furthermore, the difference $\Delta 1$ in component temperatures between the dual-system drive mode and the single-system drive mode is smaller than the difference $\Delta 2$ in temperature of the temperature sensor between the dual-system drive mode and the single-system drive mode. It is because the components during energization generate heat by themselves, the temperature rise due to the influence of the ambient high temperature (for example, high temperature of the heat-dissipating member 37) is suppressed.

As a result, the difference obtained by subtracting the temperature of the temperature sensor from the component temperature is larger in the single-system drive mode than in the dual-system drive mode. FIG. 15 is a graph illustrating temperatures difference (the component temperature minus temperature sensor temperature) when a specific magnitude of current is applied in order to investigate trends in difference between component temperatures and temperatures of the temperature sensor in each of the dual-system drive mode and the single-system drive mode. The solid line illustrates the trend of the difference between the component temperature and the temperature of the temperature sensor in the single-system drive mode, and the dashed line illustrates the trend of the difference between the component temperature and the temperature of the temperature sensor in the dual-system drive mode. As illustrated in FIG. 15, the difference between the component temperature and the temperature of the temperature sensor in the single-system drive mode (solid line) is larger than the difference in the dual-system drive mode (dashed line).

Now, refer to the high-side FET temperature estimating unit 61a1 in FIG. 7. The gain multiplying unit 73 calculates a product ($G1 \times W$) of the power loss W and a predetermined conversion gain G1 and output the result to the first low-pass filter 74. The first low-pass filter 74 outputs a signal obtained by applying a low-pass filtering to the product ($G1 \times W$). The output of the first low-pass filter 74 may hereinafter be denoted as LPF ($G1 \times W$).

The second low-pass filter 75 outputs a signal obtained by applying the low-pass filtering to a detection signal of the temperature sensor (that is, the temperature of the temperature sensor) of the temperature detection circuit 45A to the adder 76 as a base temperature Tth. The output of the second low-pass filter 75 (base temperature Tth) may hereinafter be denoted as LPF (SdA). The high-side FET temperature estimating unit 61a1 estimates the sum of the output of the first low-pass filter 74 and the output of the second low-pass filter 75 (LPF ($G1 \times W$) + LPF(SdA)) as the component temperature of high-side FET Q1.

The FET component temperature in the graph in FIG. 14 corresponds to the sum (LPF ($G1 \times W$) + LPF(SdA)), which is an estimation result of the high-side FET temperature estimating unit 61a1, and the temperature of the temperature sensor in the graph in FIG. 14 corresponds to the output LPF(SdA) of the second low-pass filter 75. Therefore, the difference between the component temperature and the temperature of the temperature sensor in the graph in FIG. 15 corresponds to LPF($G1 \times W$), the difference obtained by subtracting LPF(SdA) from the sum (LPF ($G1 \times W$) + LPF(SdA)), that is, the output of the first low-pass filter 74.

Therefore, adjusting the output LPF ($G1 \times W$) of the first low-pass filter 74 so that the value for single-system drive mode is larger than the value for dual-system drive mode, as illustrated in FIG. 15 makes it possible to estimate the component temperatures according to the difference in drive modes, and achieve more accurate estimation of the component temperatures.

In dual-system drive mode, the distribution ratio of the drive current outputted from the first current control circuit 40A and the second current control circuit 40B to the motor 20 can be made different by varying the magnitude of the current command value calculated by the current command value calculating unit 50 of each of the control calculating apparatuses 31a and 31b. When the distribution ratio of these output currents is changed, the magnitude of the difference between the component temperatures and the temperature of the temperature sensor changes for the same reason as when switching between the dual-system drive mode and the single-system drive mode described above.

Therefore, the high-side FET temperature estimating unit 61A1 of the third embodiment sets the conversion gain G1 according to the distribution ratio between the output current of the first current control circuit 40A and the output current of the second current control circuit 40B. The same applies to the high-side FET temperature estimating units 61a2 and 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, the capacitor temperature estimating units 61f1 and 61f2, and the coil temperature estimating unit 61g.

In the following description, the high-side FET temperature estimating units 61a1 to 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, the capacitor temperature estimating units 61f1 and 61f2, and the coil temperature estimating unit 61g may be collectively referred to as "temperature estimating unit 61".

FIG. 16A illustrates an example of setting the conversion gain G1. The component temperature estimating unit 61 of the control calculating apparatus 31A of the first current control circuit 40A may set a larger conversion gain G1 for a higher distribution ratio of the first current control circuit 40A. Similarly, the component temperature estimating unit 61 of the control calculating apparatus 31b of the second current control circuit 40B may set a larger conversion gain G1 for a higher distribution ratio of the second current control circuit 40B.

For example, if the distribution ratio is 50%, the conversion gain G1 is set to the value "g0"; if the distribution ratio is 100%, the conversion gain G1 is set to a value "g1" larger than the value "g0"; and if the distribution ratio is 0%, the conversion gain G1 is set to a value "g2" smaller than the value "g0.

In the range of 0% to 50% of the distribution ratio, the conversion gain G1 is increased from "g2" to "g0" as the distribution ratio increases, and in the range of 50% to 100% of the distribution ratio, the conversion gain G1 is increased from "g0" to "g1" as the distribution ratio increases. For example, the value "g1" may be set to a value of about ($1.1 \times g0$) and the value "g2" may be set to a value of about ($0.9 \times g0$).

As a result, a larger conversion gain G1 is set in the single-system drive mode than in the dual-system drive mode.

Refer to FIG. 15. Focusing on the waveform in the part indicated by an arrow 77, the waveform of the difference between the component temperature and the temperature of the temperature sensor in the single-system drive mode has a slower response than the waveform of the difference in the dual-system drive mode.

Therefore, the component temperature estimating unit 61 of the third embodiment sets the first cutoff frequency fc1 of the first low-pass filter 74 according to the distribution ratio between the output current of the first current control circuit 40A and the output current of the second current control circuit 40B.

FIG. 16B illustrates an example of setting the first cutoff frequency fc1. The component temperature estimating unit 61 of the control calculating apparatus 31a of the first current control circuit 40A may set a lower first cutoff frequency fc1 as the distribution ratio of the first current control circuit 40A increases. Similarly, the component temperature estimating unit 61 of the control calculating apparatus 31b of the second current control circuit 40B may set a lower first cutoff frequency fc1 for a higher distribution ratio of the second current control circuit 40B.

For example, if the distribution ratio is 50%, the first cutoff frequency fc1 is set to the value "f0", if the distribution ratio is 100%, the first cutoff frequency fc1 is set to the value "f1", which is lower than the value "f0", and if the distribution ratio is 0%, the first cutoff frequency fc1 is set to the value "f2", which is higher than the value "f0.

In the range of 0% to 50% of the distribution ratio, the first cutoff frequency fc1 is decreased from "f2" to "f0" as the distribution ratio increases, and in the range of 50% to 100% of the distribution ratio, the conversion gain G1 is decreased from "f0" to "f1" as the distribution ratio increases.

This sets a lower first cutoff frequency fc1 in the single-system drive mode than in the dual-system drive mode.

FIGS. 17A to 17C are schematic illustrations illustrating the relationship between the output current distribution ratio between the first current control circuit 40A and the second current control circuit 40B and the conversion gain G1 and the first cutoff frequency fc1.

The solid line in FIG. 17A illustrates the distribution ratio of the output current of the first current control circuit 40A, and the single-dotted chain line illustrates the distribution ratio of the output current of the second current control circuit 40B.

FIG. 17A illustrates an example where the first current control circuit 40A and the second current control circuit 40B operate in dual-system drive mode during the period before time t1, and the first current control circuit 40A and the second current control circuit 40B operate in single-system drive mode during time t2 and later.

In the period before time t1, the distribution ratio of the output current of the first current control circuit 40A and the second current control circuit 40B is 50%, and between time t1 and time t2, the distribution ratio of the output current of the first current control circuit 40A increases to 100% and the distribution ratio of the output current of the second current control circuit 40B decreases to 0%. In the period after time t2, the distribution ratios of the output currents of the first current control circuit 40A and the second current control circuit 40B are 100% and 0%, respectively.

In this case, the value of the conversion gain G1 of the component temperature estimating unit 61 of the control calculating apparatus 31a of the first current control circuit 40A, illustrated in the solid line in FIG. 17B, is set to the value "g0" in the period before time t1, increases to the value "g1" between time t1 and t2, and is set to the value "g1" after time t2.

The value of conversion gain G1 of the component temperature estimating unit 61 of the control calculating apparatus 31b of the second current control circuit 40B, illustrated in the dashed line in FIG. 17B, is set to the value "g0" in the period before time t1, decreases to the value "g2" between time t1 and t2, and is set to the value "g2" after time t2.

The value of the first cutoff frequency fc1 of the component temperature estimating unit 61 of the control calculating apparatus 31a of the first current control circuit 40A illustrated in the solid line in FIG. 17C is set to the value "f0" in the period before time t1, decreases to the value "f1" between time t1 and time t2, and is set to the value "f1" after time t2.

The value of the first cutoff frequency fc1 of the component temperature estimating unit 61 of the control calculating apparatus 31b of the second current control circuit 40B illustrated in the dashed line in FIG. 17C is set to the value "f0" in the period before time t1, increases to the value "f2" between time t1 and time t2, and is set to the value "f2" after time t2.

(Effect of Third Embodiment)

(1) The component temperature estimating unit may set a predetermined gain according to the distribution ratio between the output currents of a pair of current control circuits, estimate the power loss generated in the electronic components for each of the plurality of electronic components, and estimate the component temperature for each of the plurality of electronic components based on the sum of a value according to the product of the power loss and the predetermined gain and a value according to the detected temperature detected by the temperature detection circuit.

For example, the component temperature estimating unit may estimate the component temperature of one of the current control circuits based on a predetermined gain that is larger the higher the distribution ratio of one of the pair of current control circuits.

The difference between the detected temperature detected by the temperature detection circuit and the actual component temperature varies according to the distribution ratio between the output currents of the pair of current control circuits. Estimating component temperatures based on predetermined gains set according to the distribution ratio makes it possible to estimate component temperatures in accordance with the distribution ratio and to estimate component temperatures more accurately.

(2) For example, the component temperature estimating unit may set a larger predetermined gain when only one of the pair of current control circuits is driven than when both are driven.

This enables more estimation of the component temperature according to the difference of the driving mode, and thus enables more accurate estimation of component temperatures.

(3) The component temperature estimating unit may obtain a value obtained by passing the product of the power loss and the predetermined gain through a first low-pass filter as a value according to the product of the power loss and the predetermined gain and set the cutoff frequency of the first low-pass filter according to the distribution ratio.

For example, the component temperature estimating unit may estimate the component temperature of one of the pair of current control circuits using the first low-pass filter with a lower cutoff frequency the higher the distribution ratio of one of the current control circuits.

The component temperature varies according to the distribution ratio between the output currents of a pair of current control circuits. Estimating component temperatures based on predetermined gains set according to the distribution ratio makes it possible to estimate component temperatures in accordance with the distribution ratio and to estimate component temperatures more accurately.

When the output current of the current control circuit changes, the heat generation rate of the electronic components changes, and the component temperature and the detected temperature detected by the temperature detection circuit also change accordingly. The waveform of the difference between the detected temperature detected by the temperature detection circuit and the actual component temperature has different responses according to the distribution ratio. Estimating component temperatures using a first low-pass filter with a cutoff frequency set according to the distribution ratio makes it possible to estimate component temperatures according to the distribution ratio and to estimate component temperatures with higher accuracy.

(4) The component temperature estimating unit may set the cutoff frequency of the first low-pass filter lower when only one of the pair of current control circuits is driven than when both are driven.

This enables more estimation of the component temperature according to the difference of the driving mode, and thus enables more accurate estimation of component temperatures.

Fourth Embodiment

FIG. 18 is a block diagram of a first example of the functional configuration of the high-side FET temperature estimating unit 61a1 according to the fourth embodiment.

In the first embodiment and the second embodiment, the component temperature is estimated based on the sum of a first value obtained by filtering the power loss generated in the electronic component by the first low-pass filter 74 and a second value obtained by filtering the detected temperature detected by the temperature detection circuit 45A and the temperature detection circuit 45B by the second low-pass filter 75.

In contrast, in the fourth embodiment, the component temperature is estimated for each of the plurality of electronic components based on the sum of the first value obtained by filtering the power loss by a plurality of first low-pass filters 74a and 74b connected in parallel and the second value obtained by filtering the detected temperature detected by the temperature detection circuit 45A and temperature detection circuit 45B by the second low-pass filter 75.

The plurality of first low-pass filters 74a and 74b connected in parallel input the signals obtained by low-pass filtering the multiplication result ($G1 \times W$) of the power loss W at the high-side FET Q1 of the first power conversion circuit 42A and the predetermined gain G1 to the adder 76, respectively. The adder 76 calculates the sum of the output of the first low-pass filter 74a, the output of the first low-pass filter 74b, and the output of the second low-pass filter 75 as the component temperature Teal of the high-side FET Q1.

Thus, calculating as the component temperature Teal of the high-side FET Q1 based on the first value obtained by filtering the power loss W in the high-side FETQ1 of the first power conversion circuit 42A by a plurality of first low-pass filters 74a and 74b connected in parallel makes it possible to improve the estimation accuracy of the component temperature Teal of the high-side FET Q1.

FIGS. 19A and 19B are schematic illustrations of the temperature estimation results in the first embodiment and the fourth embodiment, respectively, with the solid line illustrating the assumed actual component temperature of the high-side FET Q1 and the dashed line illustrating the estimated component temperature by the high-side FET temperature estimating unit 61a1. FIGS. 19C and 19D are schematic illustrations of the estimation error between the estimated value (dashed line) and the assumed value (solid line) in FIGS. 19A and 19B, respectively. As used herein the phrase "assumed value" of component temperature is used to mean the value of component temperature assumed based on past performance and experience.

As can be seen from FIGS. 19A to 19D, filtering through a plurality of first low-pass filters 74a and 74b connected in parallel improves the accuracy of estimation of component temperature.

FIG. 20A is a schematic illustration of an example of the heat dissipation paths from an electronic component to a heat sink. As described above, the electronic components in each of the first power conversion circuits 42A and the second power conversion circuit 42B, and the temperature sensors 45A1 and 45A2 in the temperature detection circuit 45A are mounted on the same circuit board 36. A surface f1 of the electronic component mounted on the front surface ff of the circuit board 36 on the opposite side from the circuit board 36 and surfaces f2 of the temperature sensors 45A1 and 45A2 of the temperature detection circuit 45A on the opposite side from the circuit board 36 are thermally connected to the same heat sink 37. For example, surfaces f1 and f2 are brought into contact with heat sink 37 via the thermal interface materials 38a and 38b, respectively. The temperature sensor of the temperature detection circuit 45B is also thermally connected to the heat sink 37 in the same configuration as the temperature sensors 45A1 and 45A2.

Therefore, the heat generated by the electronic components is transferred in parallel via a first heat dissipation path Pth1, in which the heat is directly transferred to the heat sink 37 via the thermal interface material 38a, and a second heat dissipation path Pth2, in which the heat is transferred to the heat sink 37 via the circuit board 36. The second heat dissipation path Pth2 has different thermal characteristics (for example, thermal conductivity and heat capacity) from the first heat dissipation path Pth1 because it is a path through the circuit board 36.

FIG. 20B is a schematic illustration of another example of the heat dissipation paths from the electronic components to the heat sink. The first electronic component and the second electronic component in each of the first power conversion circuit 42A and the second power conversion circuit 42B are mounted on the same circuit board 36. The sides f1a and f1b of these electronic components mounted on the front surface ff of the circuit board 36, which are opposite from the circuit board 36, are thermally connected to the same heat sink 37. In this structure as well, the heat generated in the first electronic component is transferred in parallel via the first heat dissipation path Pth1 that transfers the heat directly to the heat sink 37 via the thermal interface material 38a and via the second heat dissipation path Pth2 that transfers the heat to the heat sink 37 via the circuit board 36 having different thermal characteristics from the first heat dissipation path Pth1.

FIG. 20C is an equivalent circuit diagram that schematically represents the delayed response of component temperature when there are a plurality of heat dissipation paths Pth1 and Pth2 that transfer heat generated by electronic components in parallel.

The first heat dissipation path Pth1 and the second heat dissipation path Pth2 have different heat transfer characteristics. Therefore, it is difficult for a single first low-pass filter 74 to reproduce the delayed response of the temperature change of the electronic components that are dissipated by these heat dissipation paths Pth1 and Pth2.

Therefore, in the fourth embodiment, the respective delayed responses of the temperature change of the electronic component caused by the heat generated in the electronic component and transferred through the plurality of heat dissipation paths Pth1 and Pth2 are reproduced by the plurality of first low-pass filters 74a and 74b connected in parallel to each other, respectively.

This enables accurate estimation of the temperature of the electronic component by reproducing the delayed response of the temperature change of the electronic component when the heat generated by the electronic component is dissipated through the plurality of heat dissipation paths Pth1 and Pth2 to the heat sink 37 by the plurality of first low-pass filters 74a and 74b, respectively.

FIG. 21 is a block diagram of a second example of the functional configuration of the high-side FET temperature estimating unit 61a1 according to the fourth embodiment. In this example, the sum of the values obtained by filtering a plurality of multiplication results obtained by multiplying the power loss W by a plurality of different predetermined gains, respectively, through a plurality of first low-pass filters is calculated as the first value. In the example in FIG. 21, when values obtained by filtering the a plurality of multiplication results G1a × W and G1b × **W,** obtained by multiplying the power loss W by different predetermined gains G1a and G1b, respectively, through the plurality of first low-pass filters 74a and 74b, respectively, are represented as LPF1a (G1a × W) and LPF1b (G1b × W), respectively, the sum of these values, LPF1a (G1a × W) + LPF1b (G1b × W), is calculated as the first value.

In this manner, by setting different values of gains G1a and G1b for the first low-pass filters 74a and 74b, respectively, it is possible to reflect differences in the thermal characteristics of heat dissipation paths Pth1 and Pth2 on the estimated values. As a result, the accuracy of component temperature estimation can be improved.

Of the first heat dissipation path Pth1 and the second heat dissipation path Pth2 schematically illustrated in FIGS. 20A and 20B, the second heat dissipation path Pth2 dissipates heat generated by the electronic components through both a plurality of materials (circuit board 36 and heat sink 37) that are made of materials with significantly different thermal characteristics. Therefore, the delayed response of the temperature change of the electronic component when dissipating heat through the second heat dissipation path Pth2 may be reproduced by a second-order or higher low-pass filter equivalent to a series connection of a plurality of first-order low-pass filters.

For this reason, any of the plurality of first low-pass filters 74a and 74b connected in parallel may be a second-order or higher low-pass filter.

Other component temperature estimating units such as the high-side FET temperature estimating units 61a2 and 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, and the coil temperature estimating unit 61g may have the same configuration as the high-side FET temperature estimating unit 61a1 illustrated in FIG. 18 or FIG. 21.

For electronic components mounted on the back surface fr of the circuit board 36, the first heat dissipation path Pth1 where heat generated by the electronic components is directly transferred to the heat sink 37 via the thermal interface material does not exist. Therefore, the temperature estimating unit that estimates the component temperature of electronic components mounted on the back surface fr of the circuit board 36 does not have to employ the configuration illustrated in FIG. 18 or FIG. 21. For example, if the electrolytic capacitors CA1 and CA2 are mounted on the back surface fr of the circuit board 36, the capacitor temperature estimating units 61f1 and 61f2 do not have to employ the configuration illustrated in FIG. 18 or FIG. 21.

(Effect of Fourth Embodiment)

(1) The current control apparatus according to the fourth embodiment includes: a current control circuit including a plurality of electronic components; a temperature detection circuit having a temperature detecting element disposed in the vicinity of the current control circuit; a current detecting unit configured to detect or estimate current values flowing to each of the plurality of electronic components; a component temperature estimating unit configured to estimate a component temperature, which is the temperature of the electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient.

The component temperature estimating unit estimates the power loss generated in each electronic component for each of the plurality of electronic components, and estimates the component temperature for each of the plurality of electronic components based on the sum of the first value obtained by filtering the power loss through a plurality of first low-pass filters connected in parallel with each other and a second value obtained by filtering the detected temperature detected by a temperature detection circuit through a second low-pass filter. For example, the first value may be obtained by filtering the result of multiplying the power loss by a predetermined gain through a plurality of first low-pass filters.

This allows accurate estimation of component temperatures in cases where heat generated in one electronic component is dissipated by transferring heat through a plurality of heat dissipation paths that exist in parallel.

(2) The plurality of electronic components and the temperature detecting element may be mounted on the same circuit board, and the surface opposite from the circuit board side of a first component, which is one of the plurality of electronic components, and a surface opposite from the circuit board side of the temperature detecting element or a second component other than the first component of the plurality of electronic components may be thermally coupled to the same heat sink.

This allows each delayed response of temperature change of electronic components that are dissipated by a heat dissipation path that dissipates heat at the heat sink without passing through the circuit board and a heat dissipation path that dissipates heat while passing through the circuit board, respectively, to be reproduced by a plurality of first low-pass filters that are connected in parallel to each other.

(3) The component temperature estimating unit may acquire the sum of the values obtained by filtering a plurality of multiplication results obtained by multiplying the power loss W by a plurality of different predetermined gains, respectively, through a plurality of first low-pass filters as the first value.

In this manner, setting different values of the predetermined gain for the different first low-pass filters enables reflection of differences in the thermal characteristics of the heat dissipation paths in the estimated values. As a result, the accuracy of component temperature estimation can be improved.

(4) At least one of the plurality of first low-pass filters may be a second-order or higher low-pass filter.

This allows accurate estimation of the delayed response of temperature change of electronic components that are dissipated through a plurality of members made of materials with significantly different thermal characteristics.

Fifth Embodiment

For example, the high-side FET temperature estimating unit 61a1 of the fourth embodiment estimates the component temperatures of the electronic components included in the current control apparatus and are mounted on the front surface ff of the circuit board 36, as illustrated in FIGS. 20A and 20B. The electronic component is disposed between the circuit board 36 and the heat sink 37, and the side f1 facing away from the circuit board 36 is thermally connected to the heat sink 37. The heat generated by the electronic component is dissipated to the heat sink 37 directly or through the thermal interface material 38a.

On the other hand, some of the electronic components included in the current control apparatus are mounted on the back surface fr on the opposite the front surface ff facing the heat sink 37 out of the front surface ff and the back surface fr of the circuit board 36.

In the following description, for example, a case where the electrolytic capacitors CA1 and CA2, which connect a positive pole wire and a negative pole wire of the inverter, are mounted on the back surface fr will be exemplified. However, the present invention is not intended to limit the electronic components mounted on the back surface fr of the circuit board 36 to electrolytic capacitors CA1 and CA2. Which of the electronic components included in the current control apparatus will be mounted on the face fr of the circuit board 36 facing away from the heat sink 37 depends on the individual product.

In the case of electronic components mounted on the back surface fr of the circuit board 36, the heat generated by the electronic components is dissipated to the heat sink 37 through the circuit board 36 and also through the components interposed between the circuit board 36 and the heat sink 37 (such as other electronic components and temperature sensors mounted on the front surface ff) and interposers (such as a thermal interface material applied on the front surface ff, etc.). This complicates the heat transfer paths and may make it difficult for a first-order low-pass filter alone to accurately estimate the amount of rise in component temperature of electronic components from the power loss of the electronic components.

Therefore, in the fifth embodiment, the amount of rise in component temperature due to heat generation of electronic components is estimated by filtering the power loss by a plurality of first low-pass filters connected in series.

FIG. 22 is a block diagram of a first example of the functional configuration of a capacitor temperature estimating unit 61f1 according to a fifth embodiment. The capacitor temperature estimating unit 61f1 estimates the component temperature of the electrolytic capacitor CA1 of the first power conversion circuit 42A mounted on the back surface fr of the circuit board 36. The capacitor temperature estimating unit 61f2, which estimates the component temperature of the electrolytic capacitor CA2 mounted on the back surface fr of the circuit board 36, may also have the same functional configuration as illustrated in FIG. 22.

The capacitor temperature estimating unit 61f1 of the fifth embodiment estimates the component temperature for each of the plurality of electronic components based on the sum of the first value obtained by filtering the power loss W calculated by the power loss calculating unit 72 through the plurality of first low-pass filters 74a and 74c connected in series, and the second value obtained by filtering the detected temperature detected by the temperature detection circuits 45A and 45B through the second low-pass filter 75.

The power loss calculating unit 72 of the capacitor temperature estimating unit 61f1 of the fifth embodiment calculates the power loss W of the electrolytic capacitor CA1 based on the phase A current I1ad, the phase B current I1bd and the phase C current I1cd according to the following calculation formula.

$$W = Ga \times I1ad^2 + Gb \times I1bd^2 + Gc \times I1cd^2$$

In other words, the capacitor temperature estimating unit 61f1 of the fifth embodiment calculates the power loss W based on the weighted sum of the squared values of each of the phase A current I1ad, the phase B current I1bd, and the phase C current I1cd.

Note that in the capacitor temperature estimating unit 61f1 of the fifth embodiment, the power loss W of the electrolytic capacitor CA1 may be calculated based on the following calculation formula as in the capacitor temperature estimating unit 61f1 of the first embodiment to the fourth embodiment.

$$W = Rf \times (Id^2 + Iq^2)$$

Among a plurality of first low-pass filters 74a and 74c connected in series, the first low-pass filter 74a in the first stage performs low-pass filtering on the multiplication results (G1 × W) of the power loss W in the electrolytic capacitor CA and the predetermined gain G1. The first low-pass filter 74c in the second stage inputs the signals obtained by low-pass filtering the output of the first low-pass filter 74a in the first stage to the adder 76, respectively. The adder 76 calculates the sum of the output of the first low-pass filter 74c and the output of the second low-pass filter 75 as the component temperature Tef1 of the electrolytic capacitor CA.

In this manner, the estimation accuracy of the component temperature Tef1 of the electrolytic capacitor CA mounted on the back surface fr of the circuit board 36 can be improved by calculating the power loss W of the electrolytic capacitor CA1 based on the phase A current I1ad, the phase B current I1bd, and the phase C current I1cd, and calculating the component temperature Tef1 of the electrolytic capacitor CA based on the first value obtained by filtering the calculated power loss W through the plurality of first low-pass filters 74a and 74c connected in series.

FIGS. 23A and 23B are schematic illustrations of the temperature estimation results in the first embodiment and the fifth embodiment, respectively, with the solid line illustrating the assumed value of the actual component temperature of the electrolytic capacitor CA and the dashed line illustrating the estimated value of the component temperature by the capacitor temperature estimating unit 61f1. FIGS. 23C and 23D are schematic illustrations of the estimation error between the estimated value (dashed line) and the assumed value (solid line) in FIGS. 23A and 23B, respectively.

As can be seen from FIGS. 23A to 23D, it is understood that the accuracy of estimation of component temperature is found to be improved by calculating the power loss W of the electrolytic capacitor CA1 based on the phase A current I1ad, the phase B current I1bd, and the phase C current I1cd, and by filtering the power loss W through the a plurality of first low-pass filters 74a and 74c connected in series.

Next, referring to FIGS. 24A to 24F, the reason the accuracy of estimation of component temperature is improved by calculating the power loss W of electrolytic capacitor CA1 based on the phase A current I1ad, the phase B current I1bd, and the phase C current I1cd will be described.

FIGS. 24A to 24C are image diagrams of the waveforms of the estimated value of the component temperature by the capacitor temperature estimating unit 61f1 (dashed line) and the waveforms of the assumed value of the actual component temperature of the electrolytic capacitor CA (solid line) when the power loss W of the electrolytic capacitor CA1 is calculated based on d-axis current id and q-axis current iq.

FIGS. 24D to 24F are image diagrams of the waveforms of the estimated value of the component temperature by the capacitor temperature estimating unit 61f1 (dashed line) and the waveforms of the assumed value of the actual component temperature of the electrolytic capacitor CA (solid line) when the power loss W of the electrolytic capacitor CA1 is calculated based on the phase A current I1ad, the phase B current I1bd, and the phase C current I1cd.

The waveforms in FIGS. 24A and 24D are obtained when the duty ratio Da of the phase A is set to the maximum among the duty ratios Da to Dc of the phase A to the phase C. The waveforms in FIG. 24G below are similar. Periods of rising and falling component temperatures indicate periods when the component is energized and deenergized, respectively. Such a waveform can be reproduced, for example, by controlling the rotational angle of the rotating shaft of the motor 20 to be fixed at a specific angle.

The waveforms in FIGS. 24B, 24E and 24H are obtained when the duty ratio Db of the phase B is set to maximum, and the waveforms in FIGS. 24C, 24F and 24I are obtained when the duty ratio Dc of the phase C is set to maximum.

Referring to FIGS. 24A to 24C, the assumed value of the actual component temperatures (solid lines) of the electrolytic capacitors CA are lower when the phase B duty ratio Db is maximum (FIG. 24B) than when the phase A duty ratio Da is maximum (FIG. 24A), and it is higher when the phase C duty ratio Dc is maximum (FIG. 24C) than when the phase A duty ratio Da is maximum (FIG. 24A).

This is considered to be because the components that generate heat when the phase A current I1ad, the phase B current I1bd, and the phase C current I1cd flow (electronic components and power line wiring) differ in their respective distances to the electrolytic capacitor CA and the heat generated by these components has a different effect on the electrolytic capacitor CA.

Therefore, when calculating the power loss W of the electrolytic capacitor CA1, the power loss W is calculated based on the phase A current I1ad, the phase B current I1bd and the phase C current I1cd, and the weighting coefficients Ga, Gb and Gc are adjusted to compensate differences in the respective distances from each of the high-side FETs Q1, Q3, and Q5 to the electrolytic capacitor CA, so that the magnitude of the waveform of the estimated value of the component temperature by the capacitor temperature estimating unit 61f1 (dashed line) can be brought closer to the magnitude of the waveform of the assumed value of the actual component temperature of the electrolytic capacitor CA (solid line) as illustrated in the dashed lines in FIG. 24D through FIG. 24F.

However, simply by adjusting the weighting coefficients Ga, Gb and Gc, the maximum value of the waveform of the estimated value (dashed line) can be matched to the maximum value of the waveform of the assumed value (solid line) of the actual component temperature of electrolytic capacitor CA, but the shape deviation between the shape of the waveform of the estimated value (dashed line) and the shape of the waveform of the assumed value (solid line) cannot be adjusted.

Therefore, the reproducibility of the waveform of the estimated value by the capacitor temperature estimating unit 61f1 can be improved by filtering the power loss W through a plurality of first low-pass filters 74a and 74c connected in series. Here, for example, the characteristics of the first low-pass filters 74a and 74c are adjusted so that the estimation error of the shape of the waveform of the estimated value (dashed line) relative to the shape of the waveform of the assumed value (solid line) is minimized.

FIGS. 24G to 24I are image diagrams of the waveform of the estimated value of the component temperature by the capacitor temperature estimating unit 61f1 (dashed line) and the waveform of the assumed value of the actual component temperature of the electrolytic capacitor CA (solid line) when the power loss W is filtered by the plurality of first low-pass filters 74a and 74c connected in series. As illustrated in FIGS. 24G to 24I, the waveform of the estimated value of the component temperature by the capacitor temperature estimating unit 61f1 (dashed line) is closer to the waveform of the assumed value (solid line), that is, reproducibility is improved.

Next, the reason the use of the plurality of first low-pass filters 74a and 74c connected in series improves the reproducibility of the waveform of the estimated value by the capacitor temperature estimating unit 61f1 will be discussed. FIG. 25A is a schematic illustration of an example of the heat dissipation path from the electronic component ecr mounted on the back surface fr of the circuit board 36 to the heat sink.

The electronic components ecr are mounted on the back surface fr of the circuit board 36, and the electronic components ecf and temperature sensors 45A1 and 45A2 are mounted on the front surface ff on the opposite side of the circuit board 36 from the back surface fr and are thermally coupled to the heat sink 37 via the thermal interface materials 38a and 38b.

For example, the surface f1 of the electronic component ecf on the opposite side from the circuit board 36 is thermally coupled to the heat sink 37 via the thermal interface material 38a, so that the front surface ff of the circuit board 36 is thermally coupled to the heat sink 37 via the electronic component ecf. The surface f2 of the temperature sensors 45A1 and 45A2 opposite from the circuit board 36 side is thermally coupled to the heat sink 37 via the thermal interface material 38b, so that the front surface ff of the circuit board 36 is thermally coupled to the heat sink 37 via the temperature sensors 45A1 and 45A2. The front surface ff of the circuit board 36 is thermally coupled to the heat sink 37 via a thermal interface material 38a interposed between the circuit board 36 and the heat sink 37.

Therefore, the heat generated by the electronic component ecr mounted on the back surface fr of the circuit board 36 is dissipated from the electronic component ecr to the circuit board 36 via the heat dissipation path Pth3, and then pass from the circuit board 36 to the heat sink 37 through the heat dissipation path Pth1 passing through the electronic component ecf and the thermal interface material 38a interposed therebetween and is dissipated to the heat sink 37. The heat dissipation path Pth3 and the heat dissipation path Pth1 have different thermal characteristics (for example, thermal conductivity and heat capacity), which complicates the path of heat transfer from the electronic component ecr to the heat sink 37.

FIG. 25B is an equivalent circuit diagram that schematically represents the delayed response of component temperature when the heat generated in the electronic component ecr is transferred in series through the heat dissipation paths Pth3 and Pth1.

Heat transfer characteristics are different between heat dissipation path Pth3 and heat dissipation path Pth1. Therefore, it is difficult for a single first low-pass filter 74 to reproduce the delayed response of the temperature change of the electronic components that are dissipated by these heat dissipation paths Pth3 and Pth1.

Therefore, in the fifth embodiment, the respective delayed responses of the temperature change of the electronic component caused by the heat generated in the electronic component ecr and transferred through the heat dissipation paths Pth3 and Pth1 are reproduced by the plurality of first low-pass filters 74a and 74c connected in series to each other, respectively.

This reproduces the delayed response of the temperature change of the electronic component ecr when the heat generated in the electronic component ecr is transferred in series through the heat dissipation paths Pth3 and Pth1 to the heat sink 37 by the plurality of first low-pass filters 74a and 74c, respectively, so that the temperature of the electronic component ecr on the back surface fr of the circuit board 36 can be estimated with high accuracy.

Heat dissipation paths through which heat generated in the electronic component ecr is transferred from the circuit board 36 to the heat sink 37 also include a heat dissipation path Pth4 through which the heat is transferred through, other than the electronic component ecf, other electronic components mounted on the front surface ff of the circuit board 36, the temperature sensors 45A1 and 45A2, the thermal interface material 38a, 38b in parallel with the heat dissipation path Pth1.

For this purpose, a first low-pass filter 74d may be connected in parallel to the first low-pass filter 74c to reproduce the delayed response of the temperature change of the electronic component ecr due to heat dissipation via the heat dissipation path Pth4 as illustrated in FIG. 25C.

However, in the example in FIG. 25A, from the perspective of the electronic component ecf, both heat dissipation paths Pth1 and Pth4 dissipate heat via circuit board 36. Therefore, the characteristics of the first low-pass filter 74c and the first low-pass filter 74d are considered to be closer, and the first low-pass filter 74c and the first low-pass filter 74d may be realized with a single first low-pass filter 74c.

If the effect of the first low-pass filter 74c is dominant, the first low-pass filter 74d may be omitted because the effect of connecting the first low-pass filter 74d in parallel to the first low-pass filter 74c is reduced.

Furthermore, the arrangement of electronic components in current control apparatuses can take various forms depending on the actual product, and the heat dissipation paths for the heat generated by these electronic components can also take various forms. Therefore, a plurality of first low-pass filters 74 connected in various connection configurations may be used as the first low-pass filter 74 that filters the power loss W calculated by the power loss calculating unit 72, depending on the arrangement configuration of the electronic components.

Now, for the sake of convenience of explanation, the high-side FET temperature estimating units 61a1 to 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, the capacitor temperature estimating units 61f1 and 61f2, and the coil temperature estimating unit 61g may be collectively referred to as "component temperature estimating unit 61".

For example, the first reduction coefficient setting unit 60 of the fifth embodiment may have both the component temperature estimating unit 61 configured similar to the high-side FET temperature estimating unit 61a1 illustrated in FIG. 18 or FIG. 21 and a component temperature estimating unit 61 configured similarly to the capacitor temperature estimating unit 61f1 illustrated in FIG. 22 or FIG. 25C.

For example, the component temperature estimating unit 61, configured similarly to the high-side FET temperature estimating unit 61a1 illustrated in FIG. 18 or FIG. 21, may estimate the electronic components mounted on the front surface ff of the circuit board 36, and the component temperature estimating unit 61, configured similarly to the capacitor temperature estimating unit 61f1, illustrated in FIG. 22 or FIG. 25C may estimate the electronic components mounted on the back surface fr of the circuit board 36.

FIGS. 26A and 26B illustrate block diagrams of the first modification and the second modification of the component temperature estimating unit 61.

In FIGS. 26A and 26B, illustration of the input signals to the power loss calculating unit 72 is omitted. This is because the calculation formula of the power loss W in the power loss calculating unit 72 differs depending on the high-side FET temperature estimating units 61a1 to 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1, 61e2, the capacitor temperature estimating units 61f1 and 61f2, and the coil temperature estimating unit 61g.

For example, the component temperature estimating unit 61 may include a parallel-series connection of first low-pass filters 74, consisting of a plurality of first low-pass filters 74 connected in parallel, with other first low-pass filters 74 connected in series. For example, the component temperature estimating unit 61 illustrated in FIG. 26A may filter the power loss W computed by the power loss calculating unit 72 by a parallel-series connection of the first low-pass filters 74a to 74d formed by connecting in series the first low-pass filters 74a and 74b connected in parallel with the first low-pass filters 74c and 74d connected in parallel.

Alternatively, for example, the component temperature estimating unit 61 may include a series-parallel connection of first low-pass filters 74, consisting of a plurality of first low-pass filters 74 connected in series, with other first low-pass filters 74 connected in parallel. For example, the component temperature estimating unit 61 illustrated in FIG. 26B may filter the power loss W calculated by the power loss calculating unit 72 by a series-parallel connection of the first low-pass filters 74a to 74d formed by connecting in parallel the first low-pass filters 74a and 74c connected in series with the first low-pass filters 74b and 74d in series.

(Effect of Fifth Embodiment)

(1) The current control apparatus according to the embodiment includes: a current control circuit including a plurality of electronic components; a temperature detection circuit having a temperature detecting element disposed in the vicinity of the current control circuit; a current detecting unit configured to detect or estimate current values flowing to each of the plurality of electronic components; a component temperature estimating unit configured to estimate a component temperature, which is the temperature of the electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient.

The component temperature estimating unit estimates the power loss generated in each electronic component for each of the plurality of electronic components, and estimates the component temperature for any one of the plurality of electronic components based on the sum of the first value obtained by filtering the power loss through a plurality of first low-pass filters connected in series with each other and a second value obtained by filtering the detected temperature detected by a temperature detection circuit through a second low-pass filter. For example, the first value may be obtained by filtering the result of multiplying the power loss by a predetermined gain through a plurality of first low-pass filters. This allows accurate estimation of component temperatures when heat generated in electronic components is dissipated via various members and interposers between the electronic component and the heat-dissipating member.

(2) Either electronic component may be mounted on a first side of the circuit board, and a second side of the circuit board opposite the first side may be thermally coupled to a heat sink. This allows accurate estimation of component temperatures of electronic components mounted on the first side of the circuit board facing away from the heat sink.

(3) At least one of the plurality of first low-pass filters may be a second-order or higher low-pass filter. This allows accurate estimation of the delayed response of temperature change of electronic components that are dissipated through a plurality of members made of materials with significantly different thermal characteristics.

(4) The component temperature estimating unit may estimate the component temperature of other electronic components other than any of the electronic components based on the sum of a third value obtained by filtering the power loss through a plurality of second low-pass filters connected in parallel with each other and a second value obtained by filtering the detected temperature detected by the temperature detection circuit through the second low-pass filter. This allows accurate estimation of component temperatures in cases where heat generated in other electronic components is dissipated by transferring heat through a plurality of heat dissipation paths that exist in parallel.

(5) Either electronic component may be mounted on the first side of the circuit board, the other electronic components may be mounted on the second side of the circuit board opposite the first side, the side opposite from the circuit board of the other electronic components may be thermally coupled to the heat sink, and the second side of the circuit board may be thermally coupled to the heat sink via other electronic components, a temperature detecting element mounted on the second side, or a thermal interface material. This allows accurate estimation of the component temperatures of the respective electronic components mounted on the first and second sides of the circuit board.

(6) The component temperature estimating unit may estimate the component temperature of each of the plurality of electronic components based on the sum of a first value obtained by filtering the power loss through the plurality of first low-pass filter connected in parallel-series or connected in series-parallel and a second value obtained by filtering the detected temperature detected by the temperature detection circuit through the second low-pass filter for each of a plurality of electronic components. This allows the selection of a first low-pass filter 74 with various delay characteristics according to the arrangement configuration of electronic components included in the current control apparatus.

(7) The current control circuit is an inverter circuit, and any of the electronic components may be a smoothing capacitor connecting the positive pole wire and the negative pole wire of the inverter circuit. This allows accurate estimation of the component temperature of the smoothing capacitor when the heat generated by the smoothing capacitor is dissipated through various members and interposers between the smoothing capacitor and the heat-dissipating member.

(8) The current control circuit is an inverter circuit, the plurality of electronic components includes a smoothing capacitor connecting the positive pole wire and the negative pole wire of the inverter circuit, and the component temperature estimating unit may estimate the power loss generated in the smoothing capacitor based on the magnitude of the phase current of the inverter circuit. This reduces the variation in the estimated values of the component temperatures that occurs as a result of differences in the distance between the switching and smoothing capacitors in the inverter circuit.

Sixth Embodiment

The high-side FET temperature estimating unit 61a1 illustrated in FIG. 7 has a first low-pass filter 74 for estimating the component temperature Teal of the high-side FET Q1. The first low-pass filter 74 is composed of an integrating circuit, and when the ECU 30 stops operation (that is, when the first current control circuit 40A and the second current control circuit 40B stop), the delay element of the integrating circuit is reset. In the following description, the first current control circuit 40A and the second current control circuit 40B may be collectively referred to as the current control circuit 40.

The resetting of the delay element of the integrating circuit is caused, for example, by momentary fluctuations in the battery voltage of the battery 13, a failure of the connector of the battery 13, a forced resetting of the control calculating apparatuses 31a and 31b by the system check function of the ECU 30, or the ignition switch 11 being turned off, which causes the first reduction coefficient setting unit 60 stops functioning and the temperature estimation of the component temperature Teal of the high-side FET Q1 cannot be continued.

When the delay element of the integrating circuit are reset, the high-side FET temperature estimating unit 61a1 cannot estimate the proper component temperature Tea unless the integrating circuit is operated after setting an appropriate initial value for the delay element of the first low-pass filter 74.

Therefore, the high-side FET temperature estimating unit 61a1 of the sixth embodiment sets the initial value of the component temperature estimated by the high-side FET temperature estimating unit 61a1 based on the first detected temperature Td1 and the second detected temperature Td2 detected at two locations in the vicinity of the current control circuit 40 when resuming operation after the stop of the ECU 30.

In the following description, the high-side FET temperature estimating unit 61a1 is exemplified, but the high-side FET temperature estimating units 61a2 and 61a3, the low-side FET temperature estimating units 61b1 to 61b3, the shunt resistance temperature estimating units 61c1 to 61c3, the phase cutoff FET temperature estimating units 61d1 to 61d3, the power cutoff FET temperature estimating units 61e1 and 61e2, the capacitor temperature estimating units 61f1 and 61f2, and the coil temperature estimating unit 61g may be considered to have the similar configuration as the high-side FET temperature estimating unit 61a1.

The temperature detecting elements for detecting the first detected temperature Td1 and the second detected temperature Td2 should be installed at a sufficient distance from each other so that a temperature difference occurs between the first detected temperature Td1 and the second detected temperature Td2, and the installation position is not particularly limited.

Refer to FIG. 27. For example, temperature detectors 46A and 46B in the IC packages of control calculating apparatuses 31a and 31b may be used as temperature detecting elements for detecting one of the first detected temperature Td1 and the second detected temperature Td2.

The temperature detection circuit 45A or 45B may be used as a temperature detecting element for the other one of the first detected temperature Td1 or the second detected temperature Td2

In this manner, the temperature detecting elements for detecting the first detected temperature Td1 and the second detected temperature Td2 may be provided in the IC package of any of the ICs constituting the ECU 30 or may be provided in the vicinity of the current control circuit 40 separately from the IC package.

FIG. 28 is a block diagram of an example of the functional configuration of the high-side FET temperature estimating unit 61a1 according to the sixth embodiment. The high-side FET temperature estimating unit 61a1 of the sixth embodiment has an initial value setting unit 78 and a subtractor 79.

The initial value setting unit 78 calculates the initial value Tini of the estimated value of the component temperature Teal at the time when the ECU 30 resumes operation based on the first detected temperature Td1 and the second detected temperature Td2 at the time when the ECU 30 stops operation, the estimated value of the component temperature Teal outputted by the high-side FET temperature estimating unit 61a1 at the time when the ECU 30 stops operation, the first detected temperature Td1 and the second detected temperature Td2 at the time when the ECU 30 resumes operation.

Hereinafter, the first detected temperature Td1 and the second detected temperature Td2 at the time when ECU 30 stopped operation are referred to as "first detected temperature Td1e and second detected temperature Td2e at the time of stop," the estimated value of the component temperature Teal outputted by the high-side FET temperature estimating unit 61a1 at the time when ECU 30 stopped operation is referred to as "estimated value Teale of the component temperature Teal at the time of stop" and the first detected temperature Td1 and the second detected temperature Td2 at the time when ECU 30 resumes operation may be referred to as "first detected temperature Td1r and second detected temperature Td2r at the time of resumption".

In the following explanation, the case in which the detection signal SdA of the temperature of ECU 30 outputted by temperature detection circuit 45A is used as the first detected temperature Td1 is exemplified, but the detection signal SdA of the temperature of ECU 30 outputted by temperature detection circuit 45A may be used as the second detected temperature Td2.

When the ECU 30 stops operation, the initial value setting unit 78 stores the first detected temperature Td1 and the second detected temperature Td2, which were last inputted when the ECU 30 stopped operation, as the first detected temperature Td1e and the second detected temperature Td2e at the time of stop. The estimated value of the component temperature Teal last outputted by the high-side FET temperature estimating unit 61a1 when the ECU 30 operation is stopped is stored as the estimated value Teale of the component temperature Teal at the time of stop.

When the ECU 30 resumes operation, the initial value setting unit 78 acquires the first detected temperature Td1r and the second detected temperature Td2r at the time of resumption.

The initial value setting unit 78 calculates the ratio of the temperature difference between the first detected temperature Td1e and the second detected temperature Td2e at the time of stop (Td2e-Td1e) to the temperature difference between the first detected temperature Td1r and the second detected temperature Td2r at the time of resumption (Td2r-Td1r) as the first estimated gain Ge1 = (Td2r-Td1r)/(Td2e-Td1e).

FIG. 29A is a schematic illustration of the first detected temperature Td1 (solid line) and the second detected temperature Td2 (dashed line) and the assumed value of the component temperature Teal of the high-side FET Q1 to be estimated (single-dotted chain line) after ECU 30 stops operation at time t = 0. FIG. 29B is a schematic illustration of the first estimated gain Ge1 calculated based on the first detected temperature Td1 and the second detected temperature Td2 in FIG. 29A.

FIG. 29A illustrates an example where the delayed response of the temperature drop of the component temperature Teal to be estimated after ECU 30 stops operation is slower than the delayed response of the temperature drop of the second detected temperature Td2.

For example, Patent No. 6569447 describes a temperature estimation method for calculating the estimated value of the component temperature Teal at the time of resumption (Ge1 $\times$ (Tea1e-Td1e)) by multiplying the temperature difference between the first detected temperature Td1e at the time of stop, which is susceptible to the first component temperature of the first electronic component and the estimated component temperature Teale of the component temperature Teal at the time of stop (Tea1e-Td1e) by the first estimated gain Ge1.

However, if the delayed response of the temperature drop of the component temperature Teal to be estimated is different from the delayed response of the temperature drop of the second detected temperature Td2, estimating the component temperature Teal using the first estimated gain Ge1 as it will produce an error in the estimated value of the component temperature Teal.

The dashed line in FIG. 29C indicates the estimated value of component temperature Teal based on the first estimated gain Ge1 (Ge1 $\times$ (Tea1e-Td1e)), and the single-dotted chain line in FIG. 29C indicates the assumed value of component temperature Teal. FIG. 29D is a schematic illustration illustrating an error between the estimated value and the assumed value.

When the delayed response of the temperature drop of the component temperature Teal is slower than the delayed response of the temperature drop of the second detected temperature Td2, as illustrated in FIGS. 29C and 29D, the estimated value based on the first estimated gain Ge1 (dashed line) is estimated to be lower than the assumed value (single-dotted chain line) and the error is largest at time t10. If the component temperature Teal is underestimated, limitation of the current command value will be insufficient, and thus the estimation errors in FIGS. 29C and 29D are errors that have occurred on the dangerous side.

If the delayed response of the temperature drop of the component temperature Teal to be estimated is different from the delayed response of the temperature drop of the first detected temperature Td1 as well, estimating the component temperature Teal using the first estimated gain Ge1 as it will produce an error in the estimated value.

Therefore, in the sixth embodiment, the temporal variation of the component temperature Teal that occurs when the ECU 30 stops operation (that is, when the current control circuit 40 stops) is actually measured in advance. The initial value setting unit 78 then sets the second estimated gain Ge2 by calibrating the first estimated gain Ge1 based on the temperature data of the temporal variation of the component temperature Teal obtained from the measurement results. Hereafter, the temperature data of the temporal variation of component temperature Teal obtained by actually measuring in advance the temporal variation of the component temperature Teal when ECU 30 stops operation may be referred to as "actual measured temperature data".

For example, a function to convert from the first estimated gain Ge1 to the second estimated gain Ge2 may be set in advance based on the actual measured temperature data. The initial value setting unit 78 may set the second estimated gain Ge2 by assigning the first estimated gain Ge1 into a preset function.

For example, the initial value setting unit 78 may set the second estimated gain Ge2 = $Ge1^x$ using an x power exponent set based on the actual measured temperature data and the power function with the first estimated gain Ge1 at the base. This is because the error in the estimated value based on the first estimated gain Ge1 described above is considered to be caused by the difference in time constant between the time constant of the delayed response of the temperature drop of the component temperature Teal and the time constant of the delayed response of the temperature drop of the second detected temperature Td2.

FIG. 30A is a schematic illustration of an example of the second estimated gain Ge. For example, if the delayed response of the temperature drop of the component temperature Teal to be estimated is slower than the delayed response of the temperature drop of the second detected temperature Td2, a power exponent x of a value smaller than 1 may be set.

The initial value setting unit 78 calculates the initial value Tini = (Ge2 $\times$ (Teale -Td1e)) of the estimated value of the component temperature Teal at the time of resumption by multiplying the temperature difference (Tea1e-Td1e) between the first detected temperature Td1e at the time of stop and the estimated value Teale of the component temperature Teal at the time of stop by the second estimated gain Ge2.

FIG. 30B is a schematic illustration of the estimated component temperature based on the second estimated gain Ge2. The estimated value can be brought closer to the assumed value by using the second estimated gain Ge2 to estimate the component temperature Teal. This avoids insufficient limitation of the current command value caused by an underestimate of the component temperature Teal.

The initial value setting unit 78 may convert from the first estimated gain Ge1 to the second estimated gain Ge2 based on a look-up table set in advance based on actual measured temperature data.

Refer to FIG. 28. The subtractor 79 sets the difference (Tini - Tth), which is the result of subtracting the base temperature Tth from the initial value Tini to the first low-pass filter 74 as an initial value of the output of the first low-pass filter 74 when the ECU 30 resumes operation. For example, subtractor 79 may assign the difference (Tini-Tth) to the delay element of the first low-pass filter 74.

As a result, the difference (Tini-Tth) is outputted from the first low-pass filter 74 when the ECU 30 resumes operation. Adder 76 adds the base temperature Tth to the difference (Tini-Tth). As a result, the initial value Tini is outputted from the high-side FET temperature estimating unit 61a1.

FIG. 31A is a schematic illustration illustrating the first detected temperature Td1 (solid line) and the second detected temperature Td2 (dashed line) when the delayed response of the temperature drop of the component temperature Teal to be estimated after ECU 30 stops operation is faster than the delayed response of the temperature drop of the second detected temperature Td2 and an assumed value (single-dotted chain line) of the component temperature Teal of high-side FET Q1 to be estimated.

The dashed line in FIG. 31B indicates the estimated value of component temperature Teal calculated based on the first estimated gain Ge1 obtained from the first detected temperature Td1 and the second detected temperature Td2 in FIG. 31A, and the single-dotted chain line in FIG. 31B indicates the assumed value of component temperature Teal. FIG. 31C is a schematic illustration illustrating an error between the estimated value and the assumed value.

If the delayed response of the component temperature Teal is faster than the delayed response of the second detected temperature Td2, the estimated value based on the first estimated gain Ge1 (dashed line) is estimated higher than the assumed value (single-dotted chain line) as illustrated in FIGS. 31B and 31C. As a result, the current command value may be unnecessarily limited.

Therefore, if the delayed response of the component temperature Teal is faster than the delayed response of the second detected temperature Td2, the power exponent x of the power function to convert from the first estimated gain Ge1 to the second estimated gain Ge2 may be set to a value greater than 1.

FIG. 31D is a schematic illustration of an example of the first estimated gain Ge1 and the second estimated gain Ge, respectively, and FIG. 31E is a schematic illustration of the estimated value of the component temperature based on the second estimated gain Ge2. The estimated value can be brought closer to the assumed value by using the second estimated gain Ge2 to estimate the component temperature Teal. This avoids unnecessary limitation of the current command value caused by an overestimation of the component temperature Teal.

(Effect of Sixth Embodiment)

(1) The current control apparatus includes a current control circuit including an electronic component; a temperature detection circuit having a temperature detecting element disposed in the vicinity of the current control circuit; a current detecting unit configured to detect or estimate a current value flowing to the electronic components, a component temperature estimating unit configured to estimate a component temperature, which is the temperature of an electronic component based on the current value detected or estimated by the current detecting unit and the detected temperature detected by the temperature detection circuit, and a current limiting unit configured to limit output current outputted from the current control circuit to a load based on the component temperature.

The component temperature estimating unit includes an initial value setting unit configured to set the initial value of the estimated value of the component temperature when the current control circuit resumes operation after the current control circuit stops the operation.

The initial value setting unit acquires the first detected temperature and the second detected temperature detected at two locations at a distance from each other in the vicinity of the current control circuit, stores the estimated temperature, the first detected temperature, and the second detected temperature of the component temperature when the current control circuit is stopped, calculates the ratio of the temperature difference between the first detected temperature and the second detected temperature at the time of stop and the temperature difference between the first detected temperature and the second detected temperature when the current control circuit resumes operation as the first estimated gain, sets the second estimated gain by calibrating the first estimated gain based on temperature data obtained by actually measuring in advance the temporal variation of the component temperature when the current control circuit stops, and sets the initial value based on the temperature difference obtained by multiplying the temperature difference between the first detected temperature and the estimated component temperature at the time of stop by the second estimated gain.

This improves the estimation accuracy of the electronic components when the current control circuit resumes operation, even if the time constant of the delayed response of the drop in the second detected temperature after the stop of the current control circuit differs from the time constant of the delayed response of the drop in the component temperature of the electronic component to be estimated. As a result, when the current control circuit stops and then resumes operation, the accuracy of component temperature estimation at the time of resumption can be improved.

(2) The initial value setting unit may convert the first estimated gain to the second estimated gain by a function of the first estimated gain set based on temperature data. The above function may be a power function with a constant set based on temperature data as the power exponent and the first estimated gain as the base or may be a look-up table set based on the temperature data. This allows the second estimated gain to be set appropriately based on the temperature data obtained by actually measuring the temporal variation of the component temperature in advance and the first estimated gain.

(3) A power exponent smaller than 1 may be set when the delayed response of the component temperature obtained based on the temperature data is slower than the delayed response of the second detected temperature when the current control circuit is stopped, and a power exponent greater than 1 may be set when the delayed response of the component temperature obtained based on the temperature data is faster than the delayed response of the second detected temperature when the current control circuit is stopped. This allows the power function to convert the first estimated gain to the second estimated gain to be set appropriately according to the delayed response characteristics of the temperature drop of the component temperature when the current control circuit is stopped.

(4) The component temperature estimating unit may obtain a value obtained by passing the detected temperature detected by the temperature detection circuit through the second low-pass filter 75 as a value corresponding to the detected temperature detected by the temperature detection circuit. In this manner, by applying low-pass filtering to the detected temperature detected by the temperature detection circuit, an estimated value of the ambient temperature in the proximity of individual electronic components can be obtained. For example, by suppressing the effect of heat generated by electronic components in the vicinity of the temperature detection circuit, the ambient temperature in the proximity of other electronic components can be estimated with high accuracy. If the electronic component is thermally connected to a heat sink, the heat sink temperature in the proximity of the electronic component can be obtained.

Seventh Embodiment

FIGS. 32A to 32E illustrate an example of the change in the assumed values of the component temperature of the choke coil La, power cutoff FETs QC2, QD2, QC1, and QD1 when the ECU 30 operates in the dual-system drive mode in which both the first system coil and the second system coil of motor 20 are driven, and the distribution ratio of the drive current outputted from the first current control circuit 40A and the second current control circuit 40B to the motor 20 is substantially equal.

In dual-system drive mode, both battery currents Ibat1 and Ibat2 flowing from battery 13 to the first system coil and the second system coil, respectively, flow in the choke coil La. Therefore, the choke coil La easily becomes hot, and the component temperature of the choke coil La is high at time t1, as illustrated in FIG. 32A.

In contrast, the component temperatures of power cutoff FETs QC1 and QC2 through which only battery current Ibat1 (FIGS. 32D and 32B) flows and the heat generation rate of power cutoff FETs QD1 and QD2 through which only battery current Ibat2 (FIGS. 32E and 32C) flow are less than the heat generation rate of the choke coil La.

Furthermore, if the distribution ratios of the drive currents outputted from the first current control circuit 40A and the second current control circuit 40B to the motor 20 are substantially equal, the magnitudes of the battery currents Ibat1 and Ibat2 are substantially equal. Therefore, the difference in component temperatures near time t1 between the power cutoff FET QC1 (FIG. 32D), through which the battery current Ibat1 flows, and the power cutoff FET QD1 (FIG. 32E), through which the battery current Ibat2 flows, is small.

On the other hand, the difference in component temperatures between the power cutoff FET QC2 (FIG. 32B), through which the battery current Ibat1 flows, and the power cutoff FET QD2 (FIG. 32C), through which the battery current Ibat2 flows, is expected to be small. However, comparing FIGS. 32B and 32C, the component temperature of power cutoff FET QD2 is significantly higher than the component temperature of power cutoff FET QC2 at around time t1.

This is thought to be because the power cutoff FET QD2 is placed closer to the choke coil La than the power cutoff FETs QC1, QC2, and QD1, so the amount of heat propagated from the hot choke coil La affects the component temperature of power cutoff FET QD2.

FIG. 33A is a schematic illustration of the first example of a heat dissipation path from the choke coil La. In the example in FIG. 33A, the power cutoff FET QD2, temperature sensors 45B1 and 45B2, and the choke coil La are mounted on the front surface ff of the circuit board 36 and are in contact with the heat sink 37 via the thermal interface materials 38a to 38c, respectively.

In this case, the heat dissipation path Pth5, where the heat from the choke coil La is dissipated through the thermal interface material 38c to the heat sink 37, and a heat dissipation path Pth6, where the heat from the choke coil La is dissipated through the circuit board 36, the power cutoff FET QD2 and the thermal interface material 38a to the heat sink 37 are assumed. Therefore, the heat propagating from the choke coil La through the heat dissipation path Pth6 is expected to cause a rise in the component temperature of the power cutoff FET QD2.

FIG. 33B is a schematic illustration of the second example of the heat dissipation path from the choke coil La. In the example in FIG. 33B, the power cutoff FET QD2 and the temperature sensors 45B1 and 45B2 are mounted on the front surface ff of the circuit board 36 and are in contact with the heat sink 37 via the thermal interface materials 38a and 38b, respectively. The choke coil La, on the other hand, is electrically connected to the circuit board 36 with connection wiring W and is in contact with the heat sink 37 via the thermal interface material 38c.

In this case, the heat dissipation path Pth5, where the heat from choke coil La is dissipated through the thermal interface material 38c to the heat sink 37, and a heat dissipation path Pth7, where heat from the choke coil La is dissipated through the connection wiring W, the circuit board 36, the power cutoff FET QD2, and the thermal interface material 38a to the heat sink 37, are assumed. Therefore, the heat propagating from the choke coil La through the heat dissipation path Pth7 is expected to cause a rise in the component temperature of the power cutoff FET QD2.

FIG. 33C is a schematic illustration of a third example of a heat dissipation path from the choke coil La. In the example in FIG. 33C, the power cutoff FET QD2 and the temperature sensors 45B1 and 45B2 are mounted on the front surface ff of the circuit board 36 and are in contact with the heat sink 37 via the thermal interface materials 38a and 38b, respectively. The choke coil La, on the other hand, is mounted on the back surface fr of the circuit board 36 and is thermally connected to the heat sink 37 via a via through the circuit board 36 and a thermal interface material 38c.

In this case, a heat dissipation path Pth8, where the heat from the choke coil La is dissipated through the via and the thermal interface material 38c to the heat sink 37, and a heat dissipation path Pth9, where the heat from the choke coil La is dissipated through the circuit board 36, the power cutoff FET QD2 and the thermal interface material 38a to the heat sink 37 are assumed. Therefore, heat propagating from the choke coil La through the heat dissipation path Pth9 is expected to cause a rise in the component temperature of the power cutoff FET QD2.

Thus, if the power cutoff FET QD2 is disposed in proximity to the choke coil La, which is susceptible to high temperature, the power cutoff FET QD2 may be affected by the high temperature of the choke coil La. As a result, the actual component temperature of the power cutoff FET QD2 may be higher than the value estimated by the power cutoff FET temperature estimating units 61e2, which may reduce the accuracy of the component temperature estimation. In the following description, electronic components that are susceptible to high temperatures are sometimes referred to as the "first electronic components" and electronic components that are easily affected by the component temperature of the first electronic component are sometimes referred to as the "second electronic components. The choke coil La is an example of the "first electronic component" and the power cutoff FET QD2 is an example of the "second electronic component.

For convenience of explanation, in the following description, for the component temperatures of the high-side FETs Q1, Q3 and Q5, the low-side FETs Q2, Q4 and Q6, and the shunt resistors of the current detection circuits 39A2, 39B2 and 39C2 of the second power conversion circuit 42B, the phase cutoff FETs QB1, QB2 and QB3, the power cutoff FETs QD1 and QD2, and electrolytic capacitors CB1 and CB2, which constitute the current control circuit that controls current driving the second system coil, the same signs as the component temperatures of the electronic components constituting the current control circuit that controls the current driving the first system coil (that is, Teal to Tea3, Teb1 to Teb3, Tec1 to Tec3, Ted1 to Ted3, Tee1 and Tee2, and Tef1 and Tef2) are used.

In the seventh embodiment, in addition to the power loss W of the second electronic component and the detection signal SdB of the ECU 30 temperature outputted by the temperature detection circuit 45B, the second component temperature of the second electronic component is estimated based on the first component temperature of the first electronic component. For example, the component temperature Tee2 of the power cutoff FET QD2 is estimated based on the power loss W of the power cutoff FET QD2, the detection signal SdB, and the component temperature Teg of the choke coil La.

This makes it possible to correct the estimated temperature of the second component based on the estimated temperature of the first component in a configuration where the second component temperature of the second electronic component is easily affected by the first component temperature of the first electronic component, thereby improving the estimation accuracy of the second component temperature.

FIG. 34A is a block diagram of a first example of the functional configuration of the power cutoff FET temperature estimating unit 61e2 in the first reduction coefficient setting unit 60 of the control calculating apparatus 31b in the seventh embodiment. The power off FET temperature estimating unit 61e2 receives the detected values I2ad, I2bd, and I2cd of the phase A current, the phase B current, and the phase C current detected by the current detection circuits 39A2, 39B2, and 39C2, respectively, the detection signal SdB of the temperature of the ECU 30 detected by the temperature detection circuit 45B, and the estimated value of the component temperature Teg of the choke coil La estimated by the coil temperature estimating unit 61g.

The power loss calculating unit 72 estimates the on-resistance Rf of the power cutoff FET QD2 based on the previous value of the component temperature Tee2 of the power cutoff FET QD2 calculated in the previous control cycle. The battery current Ibat2 flowing from the battery 13 to the second system coil is then calculated based on the on-resistance Rf and the detected values I2ad, I2bd, and I2cd of the phase A current, the phase B current, and the phase C current. Then, the power loss W of the power cutoff FET QD2 is calculated based on the following calculation formula.

$$W = Rf \times Ibat2^2$$

The gain multiplying unit 73 calculates a product of the power loss W and a predetermined gain G1 (G1 × W) and outputs the result to the first low-pass filter 74.

The first low-pass filter 74 outputs a signal obtained by applying a low-pass filtering to the product (G1 × W) to the adder 76. The second low-pass filter 75 outputs a signal obtained by applying the low-pass filtering to a detection signal SdB of the temperature of the ECU 30 outputted by the temperature detection circuit 45B to the adder 76.

The gain multiplying unit 81 calculates the product (G2 × Teg) of a predetermined gain G2, which is different from the above gain G1, and the component temperature Teg of the choke coil La, and outputs it to the third low-pass filter 82. The third low-pass filter 82 outputs a signal obtained by applying a low-pass filtering to the product (G2 × Teg) to the adder 76.

The adder 76 calculates the sum of the output of the first low-pass filter 74, the output of the second low-pass filter 75, and the output of the third low-pass filter 82 as the component temperature Tee2 of the power cutoff FET QD2.

In this specification, the choke coil La is exemplified as the "first electronic component" and the power cutoff FET QD2 is exemplified as the "second electronic component," but this embodiment is not limited to these specific examples. This embodiment is widely applicable to a combination of a plurality of electronic components in a current control circuit that are susceptible to heat generation and other components disposed in close proximity to this electronic component.

FIG. 34B is a block diagram of a second example of the functional configuration of the power cutoff FET temperature estimating unit 61e2 in the first reduction coefficient setting unit 60 of the control calculating apparatus 31b in the seventh embodiment.

The operating state (operating mode) of a current control circuit includes an operating state in which the electronic components in the current control circuit are susceptible to heat generation (that is, easily become hot) and an operating state in which the heat generation is moderate. In the following description, the operating state in which electronic components generate heat relatively easily (that is, easily become hot) is denoted as "first state," while the operating state in which heat generation is relatively moderate is denoted as "second state".

For example, the first state may be a state in which the time average of the heat generation rate of the electronic component or the time average of the current flowing to the electronic component is equal to or above the threshold value, and the second state may be a state in which the time average of the heat generation rate of the electronic component or the time average of the current flowing to the electronic component is below the threshold value. For example, the first state may be a state in which the battery current Ibat = (Ibat1 + Ibat2) flowing from battery 13 or its time average is equal to or above the threshold value, and the second state may be a state in which the battery current Ibat or its time average is below the threshold value.

A switch 83 determines whether the current control circuit is in the first state or the second state of operation.

For example, when the battery current Ibat or its time average is equal to or above the threshold value, the switch 83 may determine that the operating state of the current control circuit is in the first state and when the battery current Ibat or its time average is below the threshold value, the switch 83 may determine that the operating state of the current control circuit is in the second state.

For example, when the present invention is applied to a current control apparatus that supplies drive current to a motor 20, it is determined to be in the first state when the rotation speed of the motor rotating shaft of the motor 20 is equal to or above a threshold value, and to be in the second state when the rotation speed is below the threshold value. The state in which the current of any one particular phase of a multiphase motor continues to be higher than the currents of the other phases and the rotation of the motor rotating shaft has stopped may be determined to be the second state, and the state in which the motor rotating shaft is rotating may be determined to be the first state.

The switch 83 outputs the output of the third low-pass filter 82 to the adder 76 when the operating state of the current control circuit is in the first state. The adder 76 calculates the sum of the output of the first low-pass filter 74, the output of the second low-pass filter 75, and the output of the third low-pass filter 82 as the component temperature Tee2 of the power cutoff FET QD2.

On the other hand, when the operating state of the current control circuit is the second state, switch 83 outputs the value "0" to adder 76. The adder 76 calculates the sum of the output of the first low-pass filter 74 and the output of the second low-pass filter 75 as the component temperature Tee2 of the power cutoff FET QD2. In other words, the component temperature Tee2 of the power cutoff FET Q2 is estimated without being based on the component temperature Teg of the choke coil La.

(Effect of Seventh Embodiment)

(1) The current control apparatus includes: a current control circuit including a plurality of electronic components; a temperature detection circuit having a temperature detecting element disposed in the vicinity of the current control circuit; a current detecting unit configured to detect or estimate current values flowing to each of the plurality of electronic components; a component temperature estimating unit configured to estimate a component temperature, which is the temperature of an electronic component, for each of the plurality of electronic components based on the current value detected or estimated by the current detecting unit and the detected temperature detected by the temperature detection circuit; a reduction coefficient setting unit configured to set a plurality of different reduction coefficients for a plurality of different component temperatures included in the component temperature estimated for each of the plurality of electronic components; a selecting unit configured to select any one of the plurality of reduction coefficients; and a current limiting unit configured to limit output current outputted from the current control circuit to a load based on the selected reduction coefficient.

The plurality of electronic components includes at least the first electronic component and the second electronic component, and the component temperature estimating unit estimates the first component temperature, which is the component temperature of the first electronic component, based on the current value detected or estimated by the current detecting unit and the detected temperature detected by the temperature detection circuit, and estimates the second component temperature, which is the component temperature of the second electronic component, based on the current value detected or estimated by the current detecting unit, the detected temperature detected by the temperature detection circuit, and the first component temperature. For example, the first electronic component and the second electronic component may be components disposed in close proximity to each other.

This makes it possible to correct the estimated temperature of the second component based on the estimated temperature of the first component in a configuration where the second component temperature of the second electronic component is easily affected by the first component temperature of the first electronic component, thereby improving the estimation accuracy of the second component temperature.

(2) The component temperature estimating unit may estimate a first power loss, which is a power loss generated in the first electronic component, and a second power loss, which is a power loss generated in the second electronic component, and may estimate the first component temperature based on the sum of the value obtained by low-pass filtering the product of the first power loss and the predetermined gain and the value obtained by low-pass filtering the detected temperature detected by the temperature detection circuit, and estimate the second component temperature based on the sum of the value obtained by low-pass filtering the product of the second power loss and the predetermined gain and the value obtained by low-pass filtering the detected temperature detected by the temperature detection circuit, and the value obtained by low-pass filtering the product of the first component temperature and the predetermined gain.

The component temperature can be estimated with high accuracy by estimating the component temperature based on the value obtained by low-pass filtering of the power loss. An estimated value of the ambient temperature in the proximity of individual electronic components can be obtained by applying a low-pass filtering to the detected temperature detected by the temperature detection circuit. If the electronic component is thermally connected to a heat sink, the heat sink temperature in the proximity of the electronic component can be obtained. The effect of the propagation of heat generated by the first electronic component on the second component temperature can be estimated with high accuracy by estimating the component temperature based on the value obtained by low-pass filtering the first component temperature.

(3) The component temperature estimating unit may estimate the second component temperature based on the first component temperature when the current control apparatus is in the first state and may estimate the second component temperature without being based on the first component temperature when the current control apparatus is in the second state.

This allows switching whether or not the first component temperature is reflected in the estimation of the second component temperature, depending on the operating state of the current control apparatus.

(4) For example, the first state may be a state in which the heat generation rate of the first electronic component is equal to or above the threshold value, and the second state may be a state in which the heat generation rate of the first electronic component is below the threshold value. For example, the first state may be a state in which the supply current flowing from the DC power source supplying DC power to the current control circuit is equal to or above the threshold value, and the second state may be a state in which the supply current is below the threshold value.

This allows switching whether or not the first component temperature is reflected in the estimation of the second component temperature, depending on whether or not the first electronic component is susceptible to high temperature.

(Modifications)

(1) FIG. 35 is a configuration diagram illustrating an overview of the first modification of ECU 30. The electric power steering apparatus may separately include, as the battery 13, a first battery that supplies power to the first power conversion circuit 42A via the first power line PWa and a second battery that supplies power to the second power conversion circuit 42B via the second power line PWb.

The positive-side power line Lpa of the first power line PWa is connected to the control calculating apparatus 31a via a noise filter circuit formed by the choke coil La and ceramic capacitors Ca1 and Ca2, and to the first power cutoff circuit 44A.

One end of the choke coil La is connected to the positive-side power line Lpa and one end of the ceramic capacitor Ca1, the other end of the choke coil La is connected to one end of the ceramic capacitor Ca2 and the control calculating apparatus 31a, and the other ends of the ceramic capacitors Ca1 and Ca2 are grounded. On the other hand, a negative-side line of the first power line PWa is connected to a ground line of the ECU 30.

The positive-side power line Lpb of the second power line PWb is connected to the control calculating apparatus 31b via a noise filter circuit formed by the choke coil Lb and ceramic capacitors Cb1 and Cb2, and to the second power cutoff circuit 44B.

One end of the choke coil Lb is connected to the positive-side power line Lpb and one end of the ceramic capacitor Cb1 and the other end of the choke coil Lb is connected to one end of the ceramic capacitor Cb2 and the control calculating apparatus 31b, and the other ends of the ceramic capacitors Cb1 and Cb2 are grounded. On the other hand, a negative-side line of the second power line PWb is connected to a ground line of the ECU 30.

In the first modification of the control calculating apparatus 31b, the coil reduction coefficient Kg is set by estimating the coil temperature Teg of the choke coil Lb instead of the choke coil La.

The third reduction coefficient setting unit 71 also sets the battery reduction coefficient K4 based on the battery voltage Vbat2, which is a voltage between output terminals of the second battery.

When the initial value setting unit 78 is provided as in the sixth embodiment, the temperature detectors 46A and 46B may be provided in the control calculating apparatuses 31a and 31b. Alternatively, temperature detectors other than temperature detection circuits 45A and 45B may be provided elsewhere in the ECU 30. The same is true for the second modification of ECU 30 in FIG. 36.

(2) FIG. 36 is a configuration diagram illustrating an overview of the second modification of ECU 30. The second modification of ECU 30 uses a single inverter to drive motor 20. Therefore, of the first motor current cutoff circuit 33A and the second motor current cutoff circuit 33B, the first gate drive circuit 41A and the second gate drive circuit 41B, the first power conversion circuit 42A and the second power conversion circuit 42B, the first power cutoff circuit 44A and the second power cutoff circuit 44B, and the temperature detection circuits 45A and 45B included in the configuration illustrated in FIG. 2, only the first motor current cutoff circuit 33A, the first gate drive circuit 41A, the first power conversion circuit 42A, the first power cutoff circuit 44A, and the temperature detection circuit 45A are provided.

(3) The above description describes an example of applying the current control apparatus of the present invention to a column assist electric power steering apparatuses of a so-called upstream assist system. However, the current control apparatus of the present invention may be applied to a so-called downstream assist electric power steering apparatus. The following is a configuration example of the application of the electric power steering apparatus of the present invention to the single-pinion assist, rack assist, and dual-pinion assist current control apparatus of the present invention as examples of the downstream assist electric power steering apparatus.

In the case of the downstream assist system, the motor 20, the rotational angle sensor 23a, and the ECU 30 may be integrated into an MCU (Motor Control Unit) with an integrated structure as illustrated by the dashed lines in FIGS. 37 to 39, instead of being separate units for waterproofing.

FIG. 37 illustrates an example of a configuration in which the current control apparatus of the present invention is applied to an electric power steering apparatus of a single-pinion assist system. The steering wheel 1 is connected to the universal joint 4a on one of intermediate shafts via the steering shaft 2. The input-side shaft 4c of the torsion bar (not illustrated) is connected to the other universal joint 4b.

The pinion rack mechanism 5 has a pinion gear (pinion) 5a, a rack bar (rack) 5b, and a pinion shaft 5c. The input-side shaft 4c and the pinion rack mechanism 5 are connected by a torsion bar (not illustrated) that twists due to the rotational angle shift between the input-side shaft 4c and the pinion rack mechanism 5. The torque sensor 10 electromagnetically measures the torsion angle of the torsion bar as steering torque Th of the steering wheel 1.

Motor 20, which assists the steering force of steering wheel 1, is connected to pinion shaft 5c via reduction gear 3, and rotational angle sensor 23a calculates the rotational angle information of the motor rotating shaft of motor 20.

(4) FIG. 38 illustrates a configuration example of applying the current control apparatus of the present invention to an electric power steering apparatus of a rack-assist system. A helical groove (not illustrated) is formed on the outer surface of a rack bar 5b, and a similar lead helical groove (not illustrated) is formed on the inner surface of nut 91. A ball screw is formed by being disposed a plurality of rolling elements in the rolling paths formed by these helical grooves.

A belt 94 is wound around a drive pulley 92 connected to the rotating shaft 20a of the motor 20 that assists the steering force of the steering wheel 1 and a driven pulley 93 connected to a nut 91, thereby converting the rotational motion of the rotating shaft 20a into a linear motion of the rack bar 5b. The rotational angle sensor 23a calculates the rotational angle information of the motor rotating shaft of the motor 20.

(5) FIG. 39 illustrates a configuration example in which the current control apparatus of the present invention is applied to an electric power steering apparatus of a dual-pinion assist system. In addition to the pinion shaft 5c and pinion gear 5a, the dual-pinion assist electric power steering apparatus has a second pinion shaft 95 and a second pinion gear 96, and the rack bar 5b has first rack teeth (not illustrated) that mesh with the pinion gear 5a and the second rack teeth (not illustrated) that mesh with the second pinion gear 96.

The motor 20, which assists the steering force of steering wheel 1, is connected to the second pinion shaft 95 via reduction gear 3 and the rotational angle sensor 23a calculates the rotational angle information of the motor rotating shaft of motor 20.

(6) Each of the first low-pass filter 74 and the second low-pass filter 75 may be replaced by a second-order delay filter.

Reference Signs List

1...Steering wheel
2...Steering shaft
3...Reduction gear
4a, 4b... Universal joint
4c... Input-side shaft
5... Pinion rack mechanism
5a... Pinion gear (pinion)
5b... Rack bar (rack)
5c... Pinion shaft
6a, 6b... Tie rod
7a, 7b... Hub unit
8L, 8R... Steered wheel
10... Torque sensor
11... Ignition switch
12... Vehicle speed sensor
13... Battery
14... Steering angle sensor
20... Motor
20a... Rotating shaft
23... Motor rotational angle detection circuit
23a... Rotational angle sensor
30... Electronic control unit (ECU)
31a, 31b... Control calculating apparatus
33A... First motor current cutoff circuit
33B ... Second motor current cutoff circuit
34A, 34B... Voltage detection circuit
35... Communication line
36... Circuit board
37... Heat-dissipating member (heat sink)
38a to 38c... Thermal interface material
39A1, 39A2, 39B1, 39B2, 39C1, 39C2... Current detection circuit
41A... First gate drive circuit
41B... Second gate drive circuit
42A... First power conversion circuit
42B... Second power conversion circuit
44A... First power cutoff circuit

44B... Second power cutoff circuit
45A, 45B... Temperature detection circuit
46A, 46B... Temperature detector
50... Current command value calculating unit
51... Current limiting unit
52, 53... Subtractor
54... Proportional integral (PI) control unit
55... 2-phase/3-phase converting unit
56... 3-phase/2-phase converting unit
57... Angular speed converting unit
60... First reduction coefficient setting unit
61a1, 61a2, 61a3... High-side FET temperature estimating unit
61b1, 61b2, 61b3... Low-side FET temperature estimating unit
61c1, 61c2, 61c3... Shunt resistance temperature estimating unit
61d1, 61d2, 61d3... Phase cutoff FET temperature estimating unit
61e1, 61e2... Power cutoff FET temperature estimating unit
61f1, 61f2... Capacitor temperature estimating unit
61g... Coil temperature estimating unit
62a, 62b, 62c, 62d, 62e, 62f, 64... Selector
63a, 63a1, 63a2, 63a3... High-side FET temperature estimating unit
63b, 63b1, 63b2, 63b3... Low-side FET reduction coefficient setting unit
63c, 63c1, 63c2, 63c3... Shunt resistance reduction coefficient setting unit
63d, 63d1, 63d2, 63d3... Phase cutoff FET reduction coefficient setting unit
63e, 63e1, 63e2... Power cutoff FET reduction coefficient setting unit
63f, 63f1, 63f2... Capacitor reduction coefficient setting unit
63g... Coil reduction coefficient setting unit
70... Second reduction coefficient setting unit
71... Third reduction coefficient setting unit
72... Power loss calculating unit
73, 73a, 73b... Gain multiplying unit
74, 74a, 74b, 74c, 74d... First low-pass filter
75... Second low-pass filter
76... Adder
78... Initial value setting unit
79... Subtractor
81... Gain multiplying unit
82... Third low-pass filter
83... Switch
91... Nut
92... Drive pulley
93... Driven pulley
94... Belt
95... Second pinion shaft
96... Second pinion gear
Ca1, Ca2, Cb1, Cb2... Ceramic capacitor
CA1, CA2, CB1, CB2... Electrolytic capacitor
CNT... Connector
Ct1, Ct2...Capacitor
Q1, Q3, Q5... High-side FET
Q2, Q4, Q6... Low-side FET
QA1, QA2, QA3, QB1, QB2, QB3... Phase cutoff FET
QC1, QC2, QD1, QD2... Power cutoff FET
La, Lb... Choke coil
Lpa, Lpb... Positive-side power line
PWa... First power line
PWb... Second power line
SWAa, SWAb, SWAc, SWBa, SWBb, SWBc... Switching arm

## Claims

1. A current control apparatus comprising:

   a current control circuit (40A, 40B) including a plurality of electronic components;
   a temperature detection circuit (45A, 45B) having a temperature detecting element disposed in the vicinity of the current control circuit (40A, 40B);
   a current detecting unit (39A1, 39A2, 39B1, 39B2, 39C1, 39C2) configured to detect or estimate a current value flowing to each of the plurality of electronic components;
   a component temperature estimating unit (61) configured to estimate a component temperature, which is a temperature of the electronic component, for each of the plurality of electronic components based on the current value detected or estimated by the current detecting unit (39A1, 39A2, 39B1, 39B2, 39C1, 39C2) and the detected temperature detected by the temperature detection circuit (45A, 45B);
   a reduction coefficient setting unit (60, 70, 71) configured to set a plurality of different reduction coefficients for a plurality of different component temperatures included in the component temperature estimated for each of the plurality of electronic components;
   a selecting unit (62a, 62b, 62c, 62d, 62e, 62f, 64) configured to select any one of the plurality of reduction coefficients; and
   a current limiting unit (51) configured to limit output current outputted from the current control circuit (40A, 40B) to a load based on the selected reduction coefficient, wherein
   the component temperature estimating unit (61)
   estimates a power loss generated in the electronic component for each of the plurality of electronic components, and
   estimates the component temperature of any of the plurality of electronic components based on a sum of a first value obtained by filtering the power loss through a plurality of first low-pass filters (74) connected in parallel with each other or connected in series with each other, and a second value obtained by filtering the detected temperature detected by the temperature detection circuit (45A, 45B) through a second low-pass filter (75), **characterized in that**
   the component temperature estimating unit (61) acquires the first value by filtering the result of the multiplication of the power loss with the predetermined gain through the plurality of first low-pass filters (74), and **in that**
   at least one of the plurality of first low-pass filters (74) is a second-order or higher low-pass filter.

2. The current control apparatus according to claim 1, **characterized in that**

   the plurality of first low-pass filters (74) are connected in parallel with each other,
   the plurality of electronic components and the temperature detecting element are mounted on the same circuit board, and
   a surface of a first component, which is the any of the plurality of electronic components, opposite from the circuit board side and a surface of the temperature detecting element or a second component other than the first component out of the plurality of electronic components, opposite from the circuit board side, are thermally coupled to an identical heat sink.

3. The current control apparatus according to claim 1, **characterized in that** the plurality of first low-pass filters (74) are connected in series with each other,

   the any of the electronic components is mounted on a first side of the circuit board, and
   a second side of the circuit board, opposite from the first side, is thermally coupled to a heat sink.

4. The current control apparatus according to claim 1, **characterized in that** the plurality of first low-pass filters (74) are connected in parallel with each other, and
   the component temperature estimating unit (61) acquires a sum of values obtained by filtering a plurality of multiplication results obtained respectively by multiplying the power loss by a different plurality of the predetermined gains through the plurality of first low-pass filters (74) as the first value.

5. The current control apparatus according to claim 1, **characterized in that** the plurality of first low-pass filters (74) are connected in series with each other,
   the component temperature estimating unit (61) estimates the component temperature of other electronic components other than the any of the plurality of electronic components based on a sum of a third value obtained by filtering the power loss through a plurality of second low-pass filters (75) connected in parallel with each other and a second value obtained by filtering the detected temperature detected by the temperature detection circuit (45A, 45B) through the second low-pass filter (75).

6. The current control apparatus according to claim 5, **characterized in that** the any of the electronic components is mounted on a first side of the circuit board, and

   the other electronic components are mounted on a second surface of the circuit board opposite from the first side, a surface of the other electronic component opposite from the circuit board is thermally coupled to a heat sink, and the second side of the circuit board is thermally coupled to the heat sink via the other electronic components, the temperature detecting element mounted on the second side or a thermal interface material.

7. The current control apparatus according to claim 1, **characterized in that** the component temperature estimating unit (61) estimates the component temperature for each of the plurality of electronic components based on a sum of a first value obtained by filtering the power loss through a plurality of first low-pass filters (74) connected in parallel-series or series-parallel with each other and a second value obtained by filtering the detected temperature detected by the temperature detection circuit (45A, 45B) through the second low-pass filter (75).

8. The current control apparatus according to claim 1, **characterized in that** the current control circuit (40A, 40B) is an inverter circuit,
   the any of the electronic components is a smoothing capacitor that connects a positive wire and a negative wire of the inverter circuit.

9. The current control apparatus according to claim 1, **characterized in that** the current control circuit (40A, 40B) is an inverter circuit,

   the plurality of electronic components include a smoothing capacitor that connects a positive wire and a negative wire of the inverter circuit, and
   the component temperature estimating unit (61) estimates a power loss generated in the smoothing capacitor based on a magnitude of phase current of the inverter circuit.

10. The current control apparatus according to claim 8, **characterized in that** the any of the electronic components is the smoothing capacitor.

11. A motor control apparatus **characterized in that** current supplied to an electric motor as a load is controlled by the current control apparatus according to any one of claims 1 to 10.

12. An electric power steering apparatus comprising:

   the motor control apparatus according to claim 11, and
   an electric motor controlled by the motor control apparatus, **characterized in that**
   a steering assist force is applied to a steering system of a vehicle by the electric motor.

## Patentansprüche

1. Stromsteuervorrichtung, umfassend:

   eine Stromsteuerschaltung (40A, 40B), enthaltend mehrere elektronische Bauteile;
   eine Temperaturerfassungsschaltung (45A, 45B) mit einem Temperaturerfassungselement, welches in der Nähe der Stromsteuerschaltung (40A, 40B) angeordnet ist;
   eine Stromerfassungseinheit (39A1, 39A2, 39B1, 39B2, 39C1, 39C2), konfiguriert zur Erfassung oder Schätzung eines Wertes des Stroms, der zu jedem der elektronischen Bauteile fließt;
   eine Bauteiltemperatur-Schätzeinheit (61), konfiguriert zur Schätzung einer Bauteiltemperatur, welche eine Temperatur des elektronischen Bauteils ist, für jedes der mehreren elektronischen Bauteile auf Basis des von der Stromerfassungseinheit (39A1, 39A2, 39B1, 39B2, 39C1, 39C2) erfassten oder geschätzten Wertes des Stromes und der von der Temperaturerfassungsschaltung (45A, 45B) erfassten Temperatur;
   eine Reduktionskoeffizienten-Einstelleinheit (60, 70, 71), konfiguriert zum Einstellen mehrerer unterschiedlicher Reduktionskoeffizienten für mehrere unterschiedliche Bauteiltemperaturen, die in der für jedes der mehreren elektronischen Bauteile geschätzten Bauteiltemperatur enthalten sind;
eine Auswahleinheit (62a, 62b, 62c, 62d, 62e, 62f, 64), konfiguriert zum Auswählen eines der mehreren Reduktionskoeffizienten; und
eine Strombegrenzungseinheit (51), konfiguriert zum Begrenzen eines von dem Stromsteuerkreis (40A, 40B) an eine Last abgegebenen Ausgangsstromes basierend auf dem ausgewählten Reduktionskoeffizienten, wobei die Bauteiltemperatur-Schätzeinheit (61)
für jedes der mehreren elektronischen Bauteile eine in dem Bauteil erzeugte Verlustleistung schätzt und
die Bauteiltemperatur eines der mehreren elektronischen Bauteile auf Basis der Summe eines ersten Wertes, der durch Filtern der Verlustleistung mittels mehrerer parallel miteinander oder in Reihe miteinander geschalteter erster Tiefpassfilter (74) erhalten wird, und eines zweiten Wertes, der durch Filtern der vom Temperaturerfassungskreis (45A, 45B) erfassten Temperatur mittels eines zweiten Tiefpassfilters (75) erhalten wird, schätzt,
**dadurch gekennzeichnet, dass**
die Bauteiltemperatur-Schätzeinheit (61) den ersten Wert durch Filtern des Ergebnisses der Multiplikation der Verlustleistung mit der vorgegebenen Verstärkung mittels der mehreren ersten Tiefpassfilter (74) ermittelt und dass
mindestens einer der mehreren ersten Tiefpassfilter (74) ein Tiefpassfilter zweiter oder höherer Ordnung ist.

**2.** Stromsteuervorrichtung nach Anspruch 1, **dadurch gekennzeichnet, dass** die mehreren ersten Tiefpassfilter (74) parallel zueinander geschaltet sind,

die mehreren elektronischen Bauteile und das Temperaturerfassungselement auf derselben Schaltplatte montiert sind und
eine Oberfläche eines ersten Bauteils, welches das eine der mehreren elektronischen Bauteile ist, welche von der Schaltplattenseite abgewandt ist, und eine Oberfläche des Temperaturerfassungselements oder eines zweiten Bauteils, welches von den mehreren elektronischen Bauteilen nicht das erste Bauteil ist, welche von der Schaltplattenseite abgewandt ist, thermisch mit einer identischen Wärmesenke gekoppelt sind.

**3.** Stromsteuervorrichtung nach Anspruch 1, **dadurch gekennzeichnet, dass** die mehreren ersten Tiefpassfilter (74) in Reihe zueinander geschaltet sind,

das eine der elektronischen Bauteile auf einer ersten Seite der Schaltplatte montiert ist und
eine zweite Seite der Schaltplatte, welche der ersten Seite abgewandt ist, thermisch mit einer Wärmesenke gekoppelt ist.

**4.** Stromsteuervorrichtung nach Anspruch 1, **dadurch gekennzeichnet, dass** die mehreren ersten Tiefpassfilter (74) parallel zueinander geschaltet sind und
die Bauteiltemperatur-Schätzeinheit (61) eine Summe der Werte, die durch Filterung mehrerer Multiplikationsergebnisse erhalten werden, welche jeweils durch Multiplikation des Leistungsverlusts mit einer unterschiedlichen Mehrzahl der vorbestimmten Verstärkungen durch die Mehrzahl erster Tiefpassfilter (74) erhalten werden, als den ersten Wert erfasst.

**5.** Stromsteuervorrichtung nach Anspruch 1, **dadurch gekennzeichnet, dass** die mehreren ersten Tiefpassfilter (74) in Reihe geschaltet sind,
wobei die Bauteiltemperatur-Schätzeinheit (61) die Bauteiltemperatur anderer elektronischer Bauteile, welche nicht das eine von der Mehrzahl elektronischer Bauteile sind, auf der Grundlage einer Summe eines dritten Wertes, der durch Filterung der Verlustleistung mittels mehrerer parallel zueinander geschalteter zweiter Tiefpassfilter (75) erhalten wird, und eines zweiten Wertes schätzt, der durch Filterung der vom Temperaturerfassungsschaltkreis (45A, 45B) erfassten Temperatur mittels des zweiten Tiefpassfilters (75) erhalten wird.

**6.** Stromsteuervorrichtung nach Anspruch 5, **dadurch gekennzeichnet, dass** das eine der elektronischen Bauteile auf einer ersten Seite der Schaltplatte montiert ist und die anderen elektronischen Bauteile auf einer zweiten Oberfläche der Schaltplatte montiert sind, welche von der ersten Seite abgewandt ist,

eine Oberfläche der anderen elektronischen Komponente, welche von der Schaltplatte abgewandt ist, thermisch mit einer Wärmesenke gekoppelt ist und
die zweite Seite der Schaltplatte über die anderen elektronischen Bauteilethermisch, das auf der zweiten Seite montierte Temperaturerfassungselement oder ein Wärmeleitmaterial mit der Wärmesenke gekoppelt ist.

7. Stromsteuervorrichtung nach Anspruch 1, **dadurch gekennzeichnet, dass** die Bauteiltemperatur-Schätzeinheit (61) die Bauteiltemperatur für jedes der mehreren elektronischen Bauteile auf der Grundlage einer Summe eines ersten Wertes, der durch Filterung der Verlustleistung mittels mehrerer erster Tiefpassfilter (74) erhalten wird, welche parallel-seriell oder seriell-parallel zu einander geschaltet sind, und eines zweiten Wertes schätzt, der durch Filterung der von der Temperaturerfassungsschaltung (45A, 45B) erfassten Temperatur mittels des zweiten Tiefpassfilters (75) erhalten wird.

8. Stromsteuervorrichtung nach Anspruch 1, **dadurch gekennzeichnet, dass** die Stromsteuerschaltung (40A, 40B) eine Wechselrichterschaltung ist,
und das eine der elektronischen Bauteile ein Glättungskondensator ist, der eine positive Leitung und eine negative Leitung der Wechselrichterschaltung verbindet.

9. Stromsteuervorrichtung nach Anspruch 1, **dadurch gekennzeichnet, dass** die Stromsteuerschaltung (40A, 40B) eine Wechselrichterschaltung ist,

   und die mehreren elektronischen Bauteile einen Glättungskondensator enthalten, der eine positive Leitung und eine negative Leitung der Wechselrichterschaltung verbindet, und
   die Bauteiltemperatur-Schätzeinheit (61) die im Glättungskondensator entstehende Verlustleistung auf Basis einer Magnitude des Phasenstroms der Wechselrichterschaltung schätzt.

10. Stromsteuervorrichtung nach Anspruch 8, **dadurch gekennzeichnet, dass** das eine der elektronischen Bauteile der Glättungskondensator ist.

11. Motorsteuerungsvorrichtung, **dadurch gekennzeichnet, dass** ein Strom, der einem Elektromotor als Last zugeführt wird, durch die Stromsteuervorrichtung nach einem der Ansprüche 1 bis 10 gesteuert wird.

12. Elektrische Servolenkvorrichtung, umfassend:

   die Motorsteuerungsvorrichtung nach Anspruch 11 und
   einen von der Motorsteuerungsvorrichtung gesteuerten Elektromotor, **dadurch gekennzeichnet, dass** eine Lenkunterstützungskraft auf ein Lenksystem eines Fahrzeugs durch den Elektromotor ausgeübt wird.

## Revendications

1. Dispositif de commande de courant comprenant :

   un circuit de commande de courant (40A, 40B) comprenant une pluralité de composants électroniques ;
   un circuit de détection de température (45A, 45B) comportant un élément de détection de température disposé à proximité du circuit de commande de courant (40A, 40B) ;
   une unité de détection de courant (39A1, 39A2, 39B1, 39B2, 39C1, 39C2) configurée pour détecter ou estimer une valeur de courant circulant vers chacun de la pluralité des composants électroniques ;
   une unité d'estimation de température de composant (61) configurée pour estimer une température de composant, qui est une température du composant électronique, pour chacun de la pluralité des composants électroniques sur la base de la valeur de courant détectée ou estimée par l'unité de détection de courant (39A1, 39A2, 39B1, 39B2, 39C1, 39C2) et de la température détectée par le circuit de détection de température (45A, 45B) ;
   une unité de réglage de coefficient de réduction (60, 70, 71) configurée pour régler une pluralité de coefficients de réduction différents pour une pluralité de températures de composants différentes incluses dans la température de composant estimée pour chacun de la pluralité de composants électroniques ;
   une unité de sélection (62a, 62b, 62c, 62d, 62e, 62f, 64) configurée pour sélectionner l'un quelconque de la pluralité de coefficients de réduction ; et
   une unité de limitation de courant (51) configurée pour limiter le courant de sortie émis par le circuit de commande de courant (40A, 40B) vers une charge sur la base du coefficient de réduction sélectionné, dans lequel
   l'unité d'estimation de température de composant (61) estime une perte de puissance générée dans le composant électronique pour chacun de la pluralité de composants électroniques, et
   estime la température de composant de l'un quelconque de la pluralité de composants électroniques sur la base d'une somme d'une première valeur obtenue en filtrant la perte de puissance à travers une pluralité de premiers filtres passe-bas (74) connectés en parallèle les uns avec les autres ou connectés en série les uns avec les autres, et une deuxième valeur obtenue en filtrant la température détectée, détectée par le circuit de détection de température (45A, 45B) à travers un deuxième filtre passe-bas (75), **caractérisé en ce que**

l'unité d'estimation de température de composant (61) acquiert la première valeur en filtrant le résultat de la multiplication de la perte de puissance par le gain prédéterminé à travers la pluralité de premiers filtres passe-bas (74), et **en ce que**

au moins un de la pluralité des premiers filtres passe-bas (74) est un filtre passe-bas du deuxième ordre ou supérieur.

**2.** Dispositif de commande de courant selon la revendication 1, **caractérisé en ce que**

la pluralité de premiers filtres passe-bas (74) sont connectés en parallèle les uns avec les autres,

la pluralité de composants électroniques et l'élément de détection de température sont montés sur la même carte de circuit imprimé, et

une surface d'un premier composant, qui est l'un quelconque de la pluralité de composants électroniques, opposée au côté de la carte de circuit imprimé et une surface de l'élément de détection de température ou d'un deuxième composant autre que le premier composant parmi la pluralité de composants électroniques, opposée au côté de la carte de circuit imprimé, sont couplées thermiquement à un dissipateur thermique identique.

**3.** Dispositif de commande de courant selon la revendication 1, **caractérisé en ce que** la pluralité de premiers filtres passe-bas (74) sont connectés en série les uns avec les autres,

l'un quelconque des composants électroniques est monté sur un premier côté de la carte de circuit imprimé et un deuxième côté de la carte de circuit imprimé, opposé au premier côté, est couplé thermiquement à un dissipateur thermique.

**4.** Dispositif de commande de courant selon la revendication 1, **caractérisé en ce que** la pluralité de premiers filtres passe-bas (74) sont connectés en parallèle les uns avec les autres, et
l'unité d'estimation de température de composant (61) acquiert une somme de valeurs obtenues en filtrant une pluralité de résultats de multiplication obtenus respectivement en multipliant la perte de puissance par une pluralité différente de gains prédéterminés à travers la pluralité de premiers filtres passe-bas (74) comme première valeur.

**5.** Dispositif de commande de courant selon la revendication 1, **caractérisé en ce que** la pluralité de premiers filtres passe-bas (74) sont connectés en série les uns avec les autres,
l'unité d'estimation de température de composant (61) estime la température de composant d'autres composants électroniques autres que ceux de la pluralité de composants électroniques sur la base d'une somme d'une troisième valeur obtenue en filtrant la perte de puissance à travers une pluralité de seconds filtres passe-bas (75) connectés en parallèle les uns avec les autres et d'une seconde valeur obtenue en filtrant la température détectée, détectée par le circuit de détection de température (45A, 45B) à travers le deuxième filtre passe-bas (75).

**6.** Dispositif de commande de courant selon la revendication 5, **caractérisé en ce que** l'un quelconque des composants électroniques est monté sur un premier côté de la carte de circuit imprimé, et

les autres composants électroniques sont montés sur une deuxième surface de la carte de circuit imprimé opposée au premier côté,

une surface de l'autre composant électronique opposée à la carte de circuit imprimé est couplée thermiquement à un dissipateur thermique, et

le deuxième côté de la carte de circuit imprimé est couplé thermiquement au dissipateur thermique via les autres composants électroniques, l'élément de détection de température monté sur le deuxième côté ou un matériau d'interface thermique.

**7.** Dispositif de contrôle de courant selon la revendication 1, **caractérisé en ce que** l'unité d'estimation de température de composant (61) estime la température de composant de chacun de la pluralité de composants électroniques sur la base d'une somme d'une première valeur obtenue en filtrant la perte de puissance à travers une pluralité de premiers filtres passe-bas (74) connectés en parallèle-séries ou en séries-parallèle les uns avec les autres et d'une deuxième valeur obtenue en filtrant la température détectée, détectée par le circuit de détection de température (45A, 45B) à travers le deuxième filtre passe-bas (75).

**8.** Dispositif de commande de courant selon la revendication 1, **caractérisé en ce que** le circuit de commande de courant (40A, 40B) est un circuit inverseur,
l'un quelconque des composants électroniques est un condensateur de lissage qui relie un fil positif et un fil négatif du circuit inverseur.

**9.** Dispositif de commande de courant selon la revendication 1, **caractérisé en ce que** le circuit de commande de courant (40A, 40B) est un circuit inverseur,

la pluralité de composants électroniques comprend un condensateur de lissage qui relie un fil positif et un fil négatif du circuit inverseur, et
l'unité d'estimation de température de composant (61) estime une perte de puissance générée dans le condensateur de lissage sur la base d'une amplitude de courant de phase du circuit inverseur.

**10.** Dispositif de commande de courant selon la revendication 8, **caractérisé en ce que** l'un quelconque des composants électroniques est le condensateur de lissage.

**11.** Dispositif de commande de moteur **caractérisé en ce que** le courant fourni à un moteur électrique en tant que charge est contrôlé par le dispositif de commande de courant selon l'une quelconque des revendications 1 à 10.

**12.** Dispositif de direction assistée électrique comprenant :

le dispositif de commande de moteur selon la revendication 11, et
un moteur électrique commandé par le dispositif de commande de moteur, **caractérisé en ce que**
une force d'assistance à la direction est appliquée à un système de direction d'un véhicule par le moteur électrique.

FIG. 1

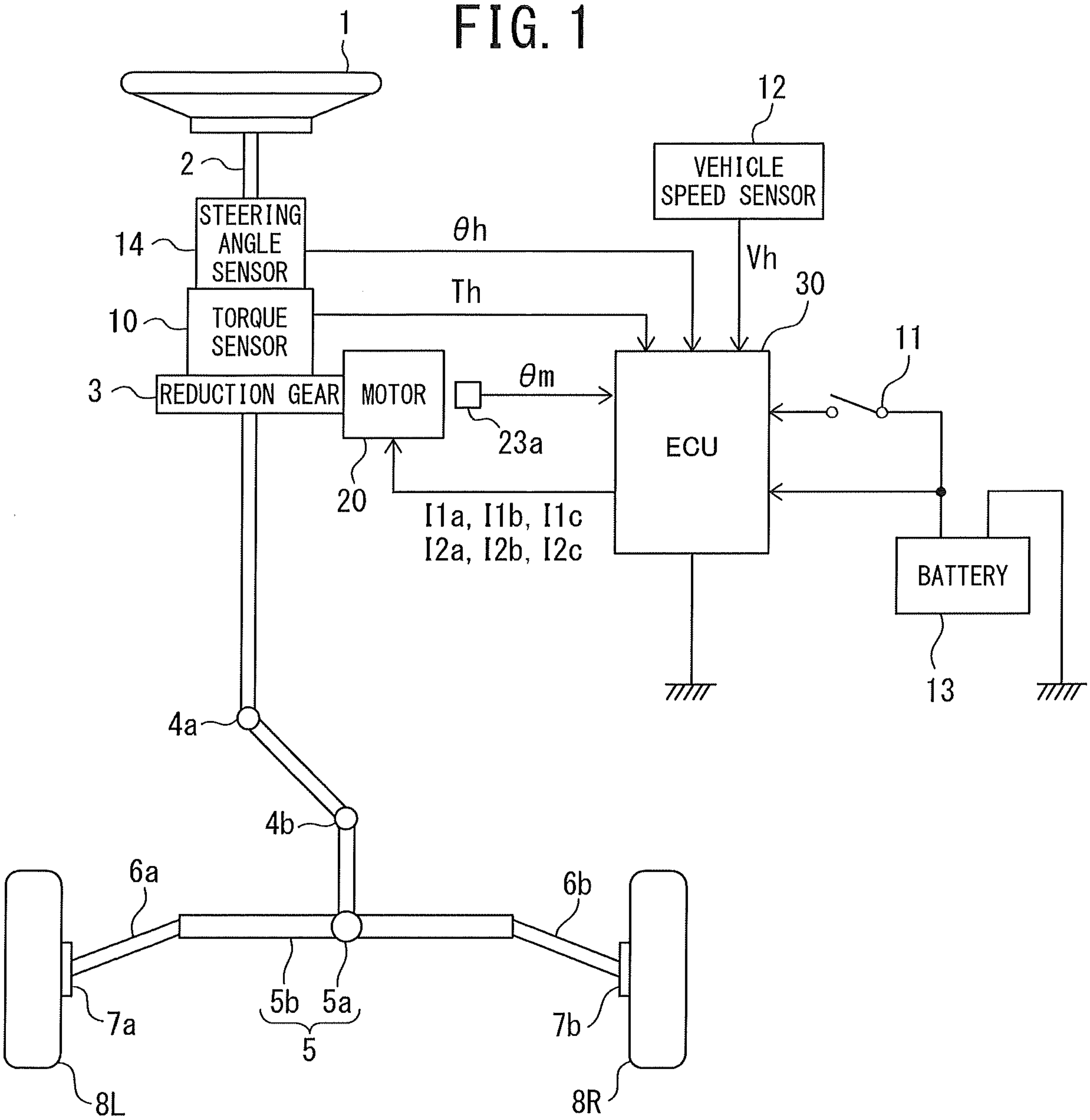
1
12
VEHICLE SPEED SENSOR
2
STEERING ANGLE SENSOR
14
θh
Vh
30
TORQUE SENSOR
10
Th
11
3
REDUCTION GEAR
MOTOR
θm
ECU
23a
20
I1a, I1b, I1c
I2a, I2b, I2c
BATTERY
13
4a
4b
6a
6b
5b
5a
5
7a
7b
8L
8R

FIG. 2

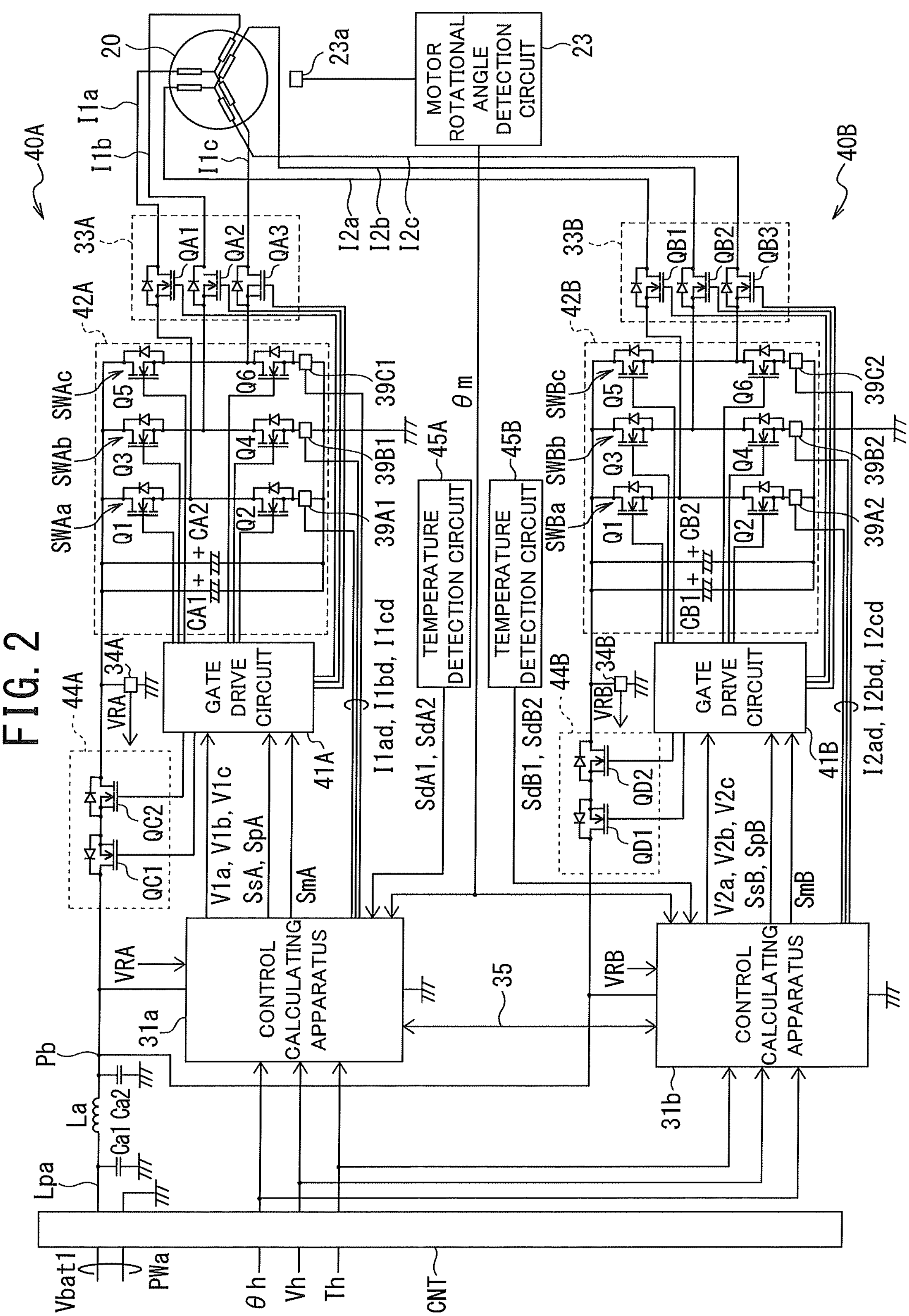

40A
20
I1a
I1b
I1c
23a
MOTOR ROTATIONAL ANGLE DETECTION CIRCUIT
23
33A
QA1
QA2
QA3
I2a
I2b
I2c
42A
SWAa
SWAb
SWAc
Q1
Q3
Q5
Q2
Q4
Q6
CA1
CA2
39A1
39B1
39C1
θm
45A
45B
TEMPERATURE DETECTION CIRCUIT
TEMPERATURE DETECTION CIRCUIT
44A
34A
VRA
GATE DRIVE CIRCUIT
41A
QC1
QC2
V1a, V1b, V1c
SsA, SpA
SmA
I1ad, I1bd, I1cd
SdA1, SdA2
SdB1, SdB2
CONTROL CALCULATING APPARATUS
31a
35
Pb
La
Ca1
Ca2
Lpa
Vbat1
PWa
θh
Vh
Th
CNT
40B
33B
QB1
QB2
QB3
42B
SWBa
SWBb
SWBc
CB1
CB2
39A2
39B2
39C2
44B
34B
VRB
QD1
QD2
41B
V2a, V2b, V2c
SsB, SpB
SmB
I2ad, I2bd, I2cd
31b

FIG. 3

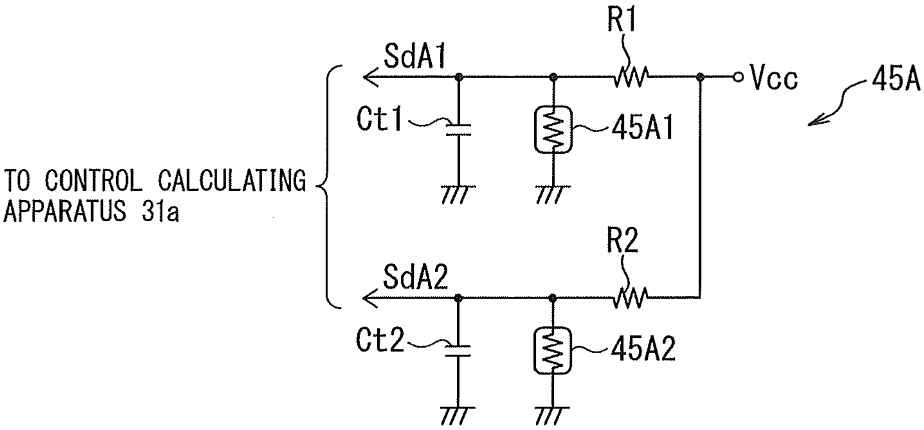
R1
SdA1
Vcc
45A
Ct1
45A1
TO CONTROL CALCULATING
APPARATUS 31a
R2
SdA2
Ct2
45A2

FIG. 4

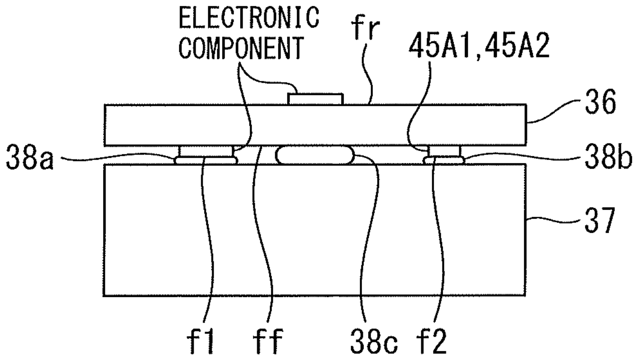
ELECTRONIC
COMPONENT
fr
45A1,45A2
36
38a
38b
37
f1
ff
38c
f2

FIG. 5

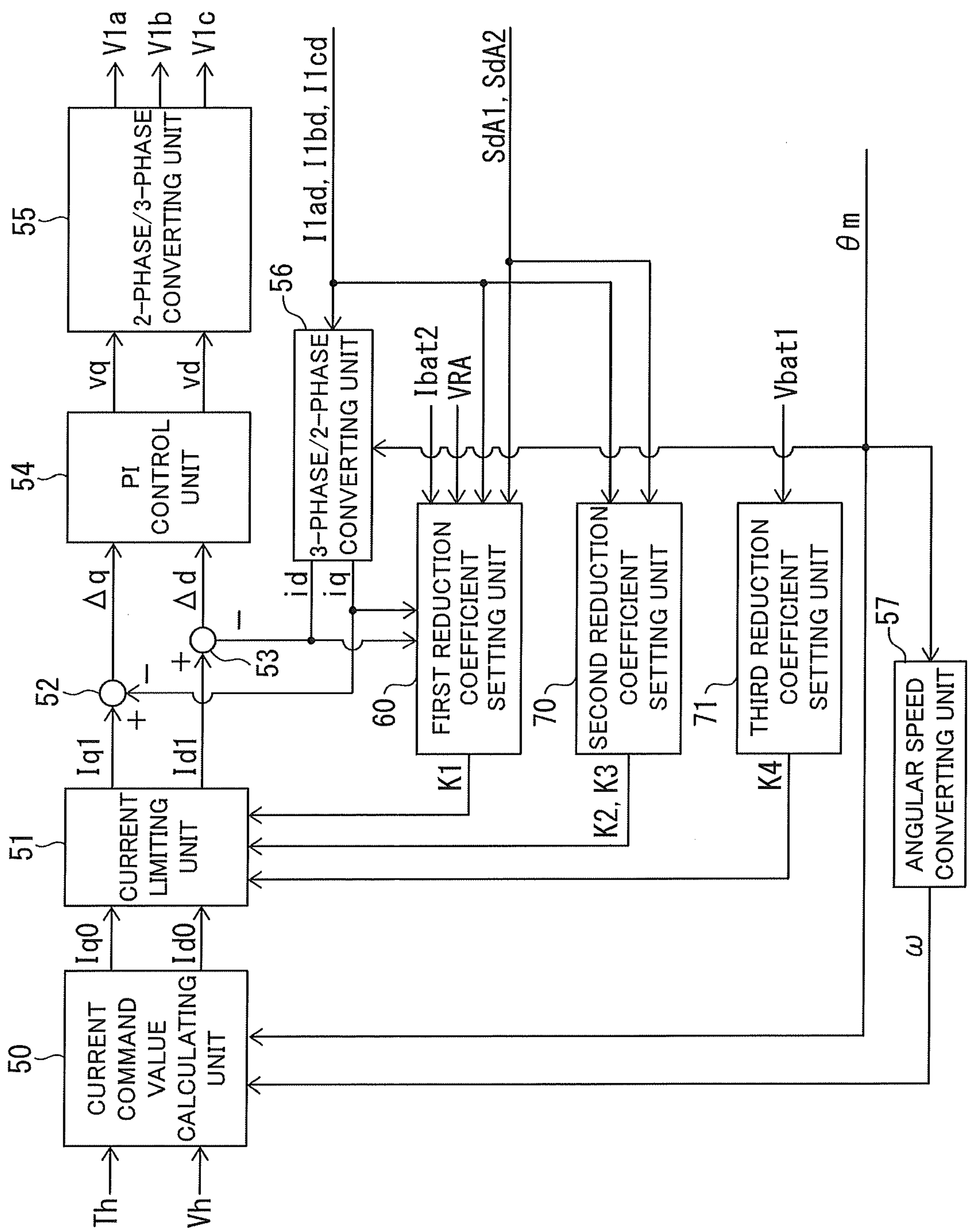
50
CURRENT COMMAND VALUE CALCULATING UNIT
Th
Vh
Iq0
Id0
51
CURRENT LIMITING UNIT
Iq1
Id1
52
53
+
−
Δq
Δd
54
PI CONTROL UNIT
vq
vd
55
2-PHASE/3-PHASE CONVERTING UNIT
V1a
V1b
V1c
56
3-PHASE/2-PHASE CONVERTING UNIT
id
iq
I1ad, I1bd, I1cd
SdA1, SdA2
Ibat2
VRA
60
FIRST REDUCTION COEFFICIENT SETTING UNIT
K1
70
SECOND REDUCTION COEFFICIENT SETTING UNIT
K2, K3
71
THIRD REDUCTION COEFFICIENT SETTING UNIT
Vbat1
K4
θm
57
ANGULAR SPEED CONVERTING UNIT
ω

FIG. 6

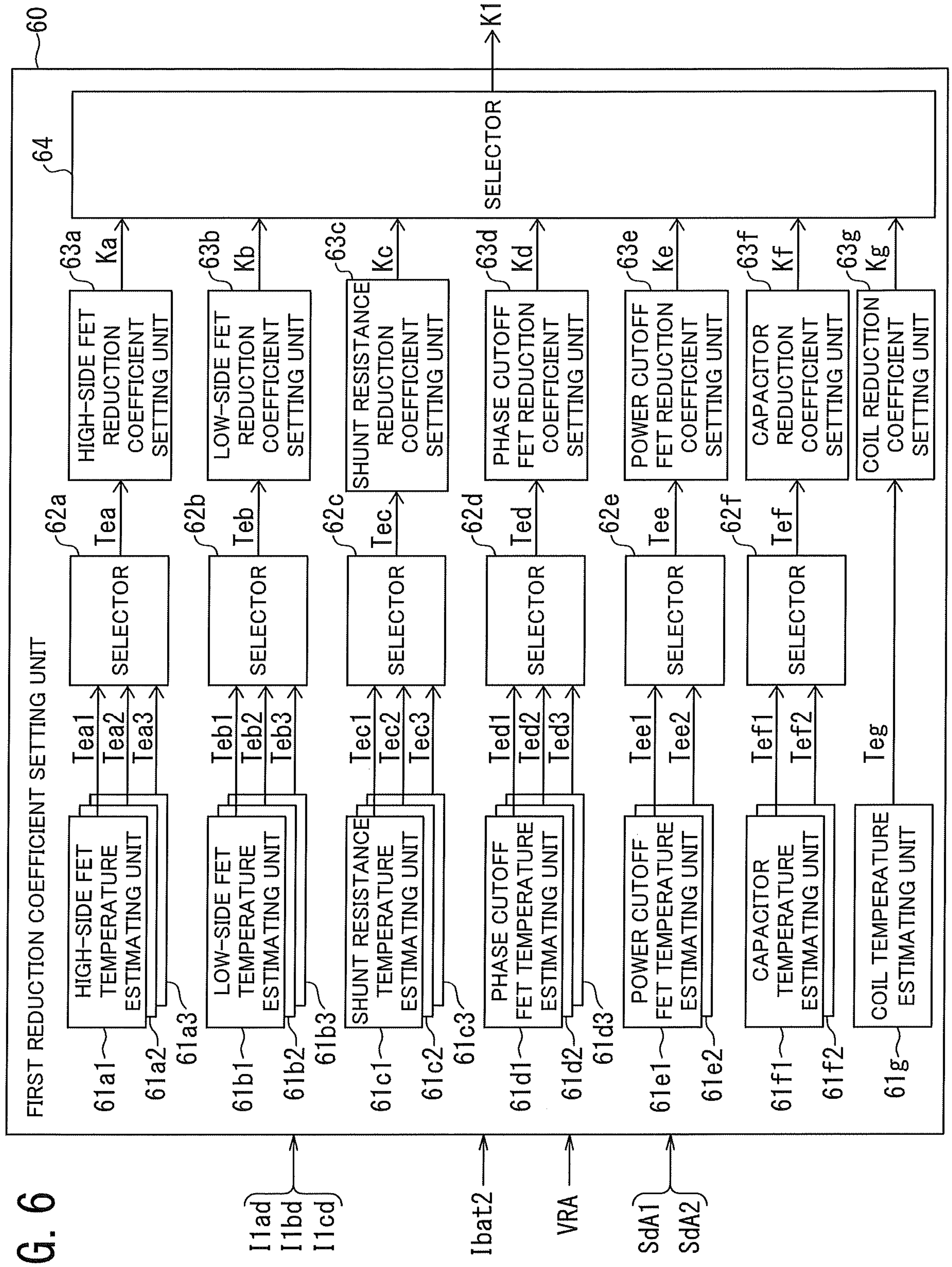
60
FIRST REDUCTION COEFFICIENT SETTING UNIT
HIGH-SIDE FET TEMPERATURE ESTIMATING UNIT
61a1
61a2
61a3
Tea1
Tea2
Tea3
SELECTOR
62a
Tea
HIGH-SIDE FET REDUCTION COEFFICIENT SETTING UNIT
63a
Ka
LOW-SIDE FET TEMPERATURE ESTIMATING UNIT
61b1
61b2
61b3
Teb1
Teb2
Teb3
SELECTOR
62b
Teb
LOW-SIDE FET REDUCTION COEFFICIENT SETTING UNIT
63b
Kb
SHUNT RESISTANCE TEMPERATURE ESTIMATING UNIT
61c1
61c2
61c3
Tec1
Tec2
Tec3
SELECTOR
62c
Tec
SHUNT RESISTANCE REDUCTION COEFFICIENT SETTING UNIT
63c
Kc
PHASE CUTOFF FET TEMPERATURE ESTIMATING UNIT
61d1
61d2
61d3
Ted1
Ted2
Ted3
SELECTOR
62d
Ted
PHASE CUTOFF FET REDUCTION COEFFICIENT SETTING UNIT
63d
Kd
POWER CUTOFF FET TEMPERATURE ESTIMATING UNIT
61e1
61e2
Tee1
Tee2
SELECTOR
62e
Tee
POWER CUTOFF FET REDUCTION COEFFICIENT SETTING UNIT
63e
Ke
CAPACITOR TEMPERATURE ESTIMATING UNIT
61f1
61f2
Tef1
Tef2
SELECTOR
62f
Tef
CAPACITOR REDUCTION COEFFICIENT SETTING UNIT
63f
Kf
COIL TEMPERATURE ESTIMATING UNIT
61g
Teg
COIL REDUCTION COEFFICIENT SETTING UNIT
63g
Kg
SELECTOR
64
K1
I1ad
I1bd
I1cd
Ibat2
VRA
SdA1
SdA2

FIG. 7

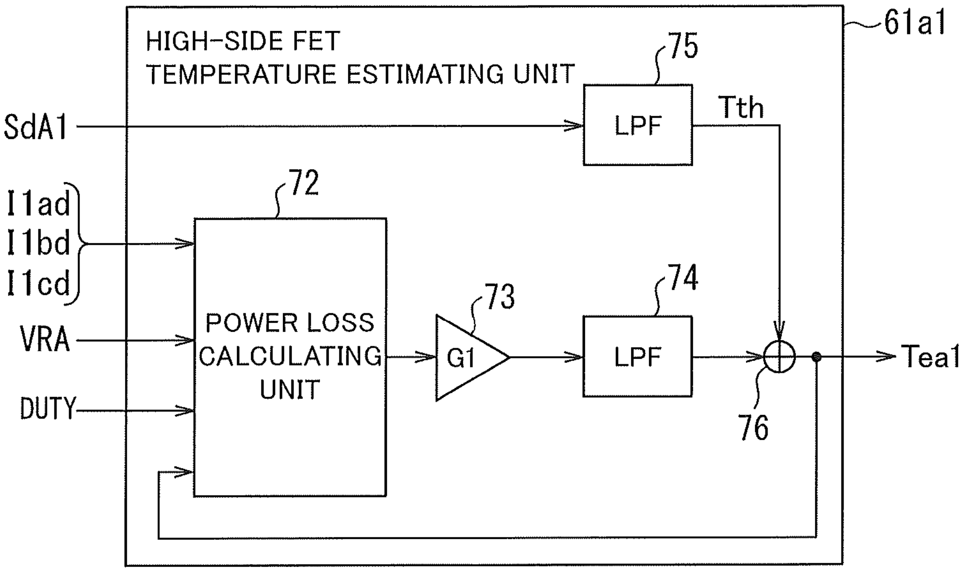
HIGH-SIDE FET
TEMPERATURE ESTIMATING UNIT
61a1
75
LPF
Tth
SdA1
72
I1ad
I1bd
I1cd
VRA
DUTY
POWER LOSS
CALCULATING
UNIT
73
G1
74
LPF
76
Tea1

FIG. 8

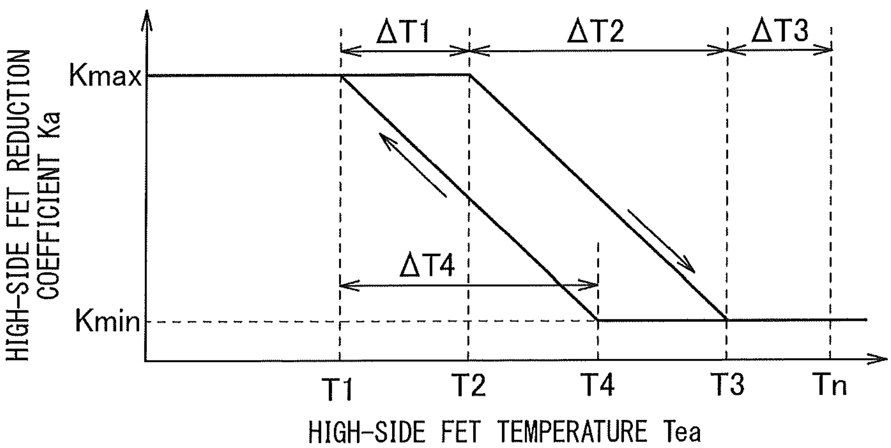
HIGH-SIDE FET REDUCTION
COEFFICIENT Ka
Kmax
Kmin
ΔT1
ΔT2
ΔT3
ΔT4
T1
T2
T4
T3
Tn
HIGH-SIDE FET TEMPERATURE Tea

FIG. 9A

FIG. 9B

FIG. 9C

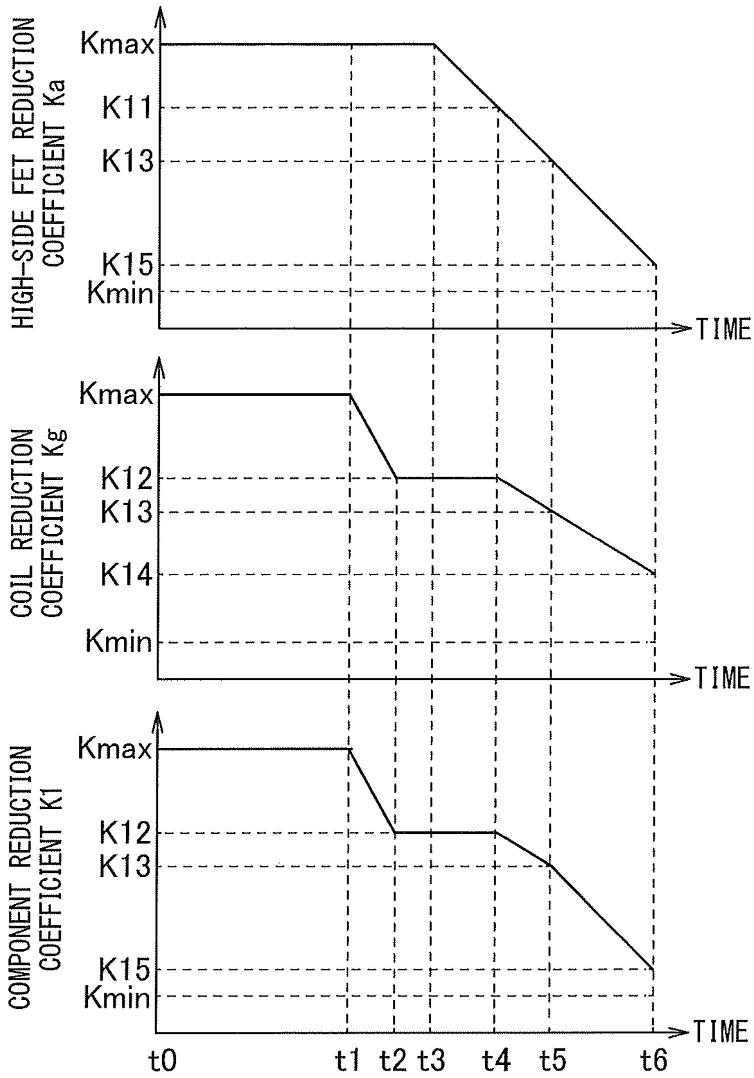


FIG. 10

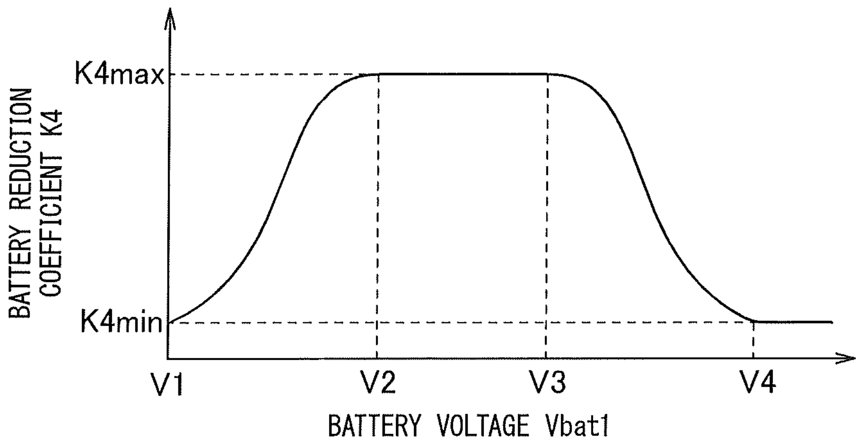

FIG. 11

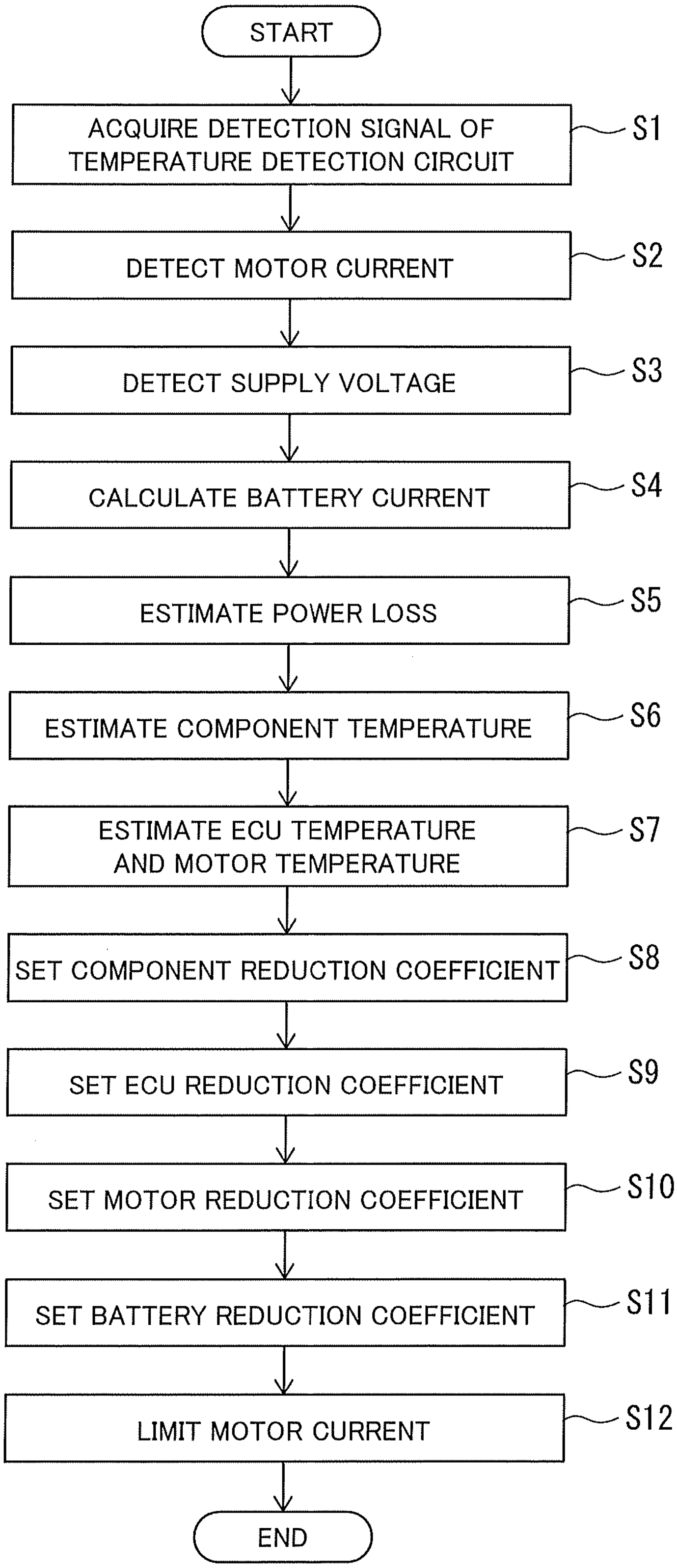
START
ACQUIRE DETECTION SIGNAL OF TEMPERATURE DETECTION CIRCUIT
S1
DETECT MOTOR CURRENT
S2
DETECT SUPPLY VOLTAGE
S3
CALCULATE BATTERY CURRENT
S4
ESTIMATE POWER LOSS
S5
ESTIMATE COMPONENT TEMPERATURE
S6
ESTIMATE ECU TEMPERATURE AND MOTOR TEMPERATURE
S7
SET COMPONENT REDUCTION COEFFICIENT
S8
SET ECU REDUCTION COEFFICIENT
S9
SET MOTOR REDUCTION COEFFICIENT
S10
SET BATTERY REDUCTION COEFFICIENT
S11
LIMIT MOTOR CURRENT
S12
END

FIG. 12

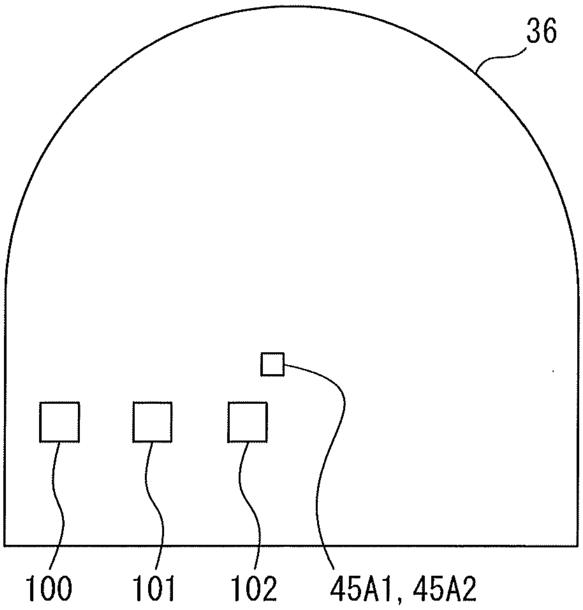

FIG. 13

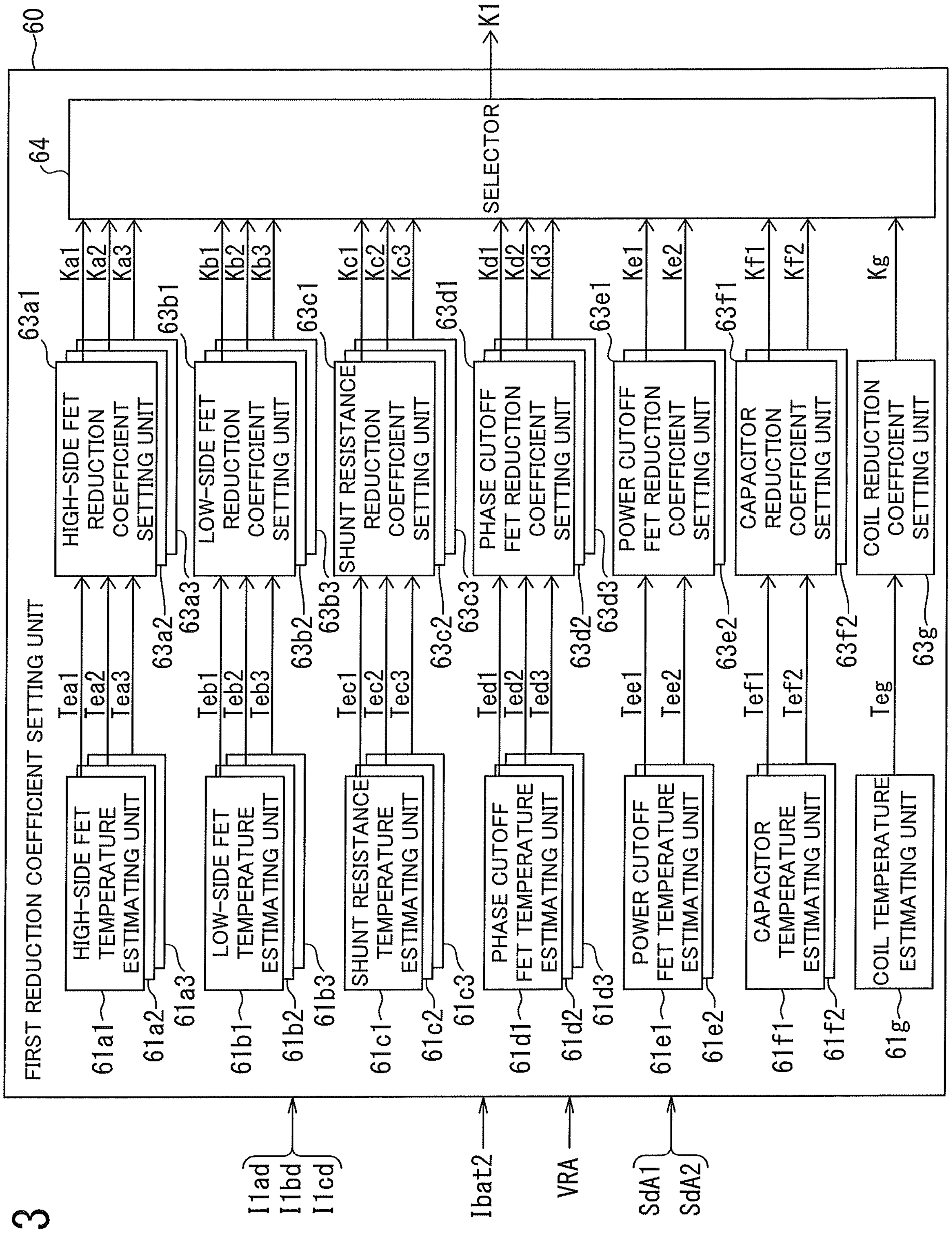
60
FIRST REDUCTION COEFFICIENT SETTING UNIT
HIGH-SIDE FET TEMPERATURE ESTIMATING UNIT
LOW-SIDE FET TEMPERATURE ESTIMATING UNIT
SHUNT RESISTANCE TEMPERATURE ESTIMATING UNIT
PHASE CUTOFF FET TEMPERATURE ESTIMATING UNIT
POWER CUTOFF FET TEMPERATURE ESTIMATING UNIT
CAPACITOR TEMPERATURE ESTIMATING UNIT
COIL TEMPERATURE ESTIMATING UNIT
61a1 61a2 61a3 61b1 61b2 61b3 61c1 61c2 61c3 61d1 61d2 61d3 61e1 61e2 61f1 61f2 61g
Tea1 Tea2 Tea3 Teb1 Teb2 Teb3 Tec1 Tec2 Tec3 Ted1 Ted2 Ted3 Tee1 Tee2 Tef1 Tef2 Teg
HIGH-SIDE FET REDUCTION COEFFICIENT SETTING UNIT
LOW-SIDE FET REDUCTION COEFFICIENT SETTING UNIT
SHUNT RESISTANCE REDUCTION COEFFICIENT SETTING UNIT
PHASE CUTOFF FET REDUCTION COEFFICIENT SETTING UNIT
POWER CUTOFF FET REDUCTION COEFFICIENT SETTING UNIT
CAPACITOR REDUCTION COEFFICIENT SETTING UNIT
COIL REDUCTION COEFFICIENT SETTING UNIT
63a1 63a2 63a3 63b1 63b2 63b3 63c1 63c2 63c3 63d1 63d2 63d3 63e1 63e2 63f1 63f2 63g
Ka1 Ka2 Ka3 Kb1 Kb2 Kb3 Kc1 Kc2 Kc3 Kd1 Kd2 Kd3 Ke1 Ke2 Kf1 Kf2 Kg
64
SELECTOR
K1
I1ad I1bd I1cd
Ibat2
VRA
SdA1 SdA2

FIG. 14

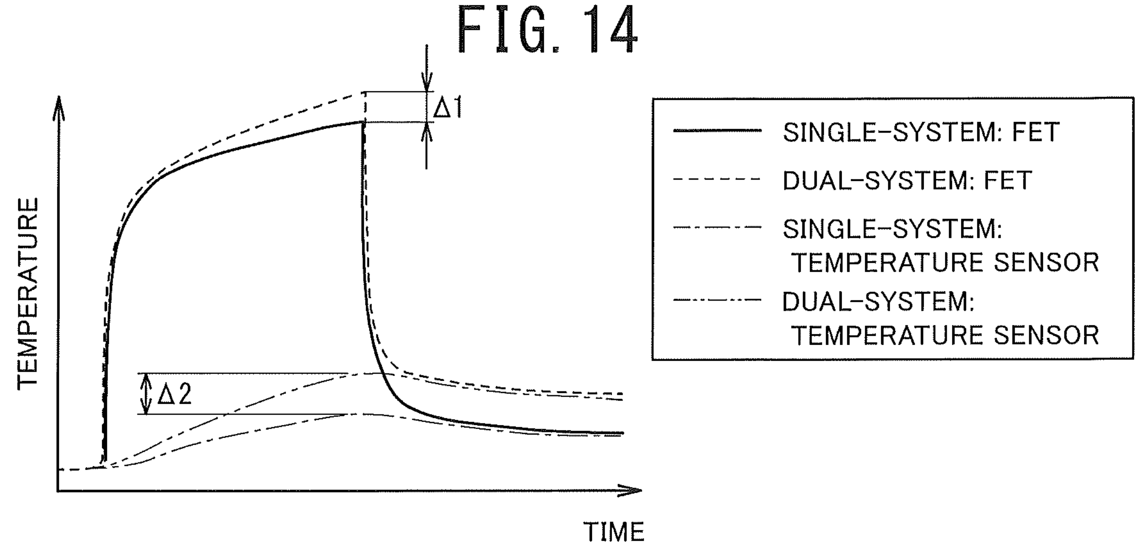


FIG. 15

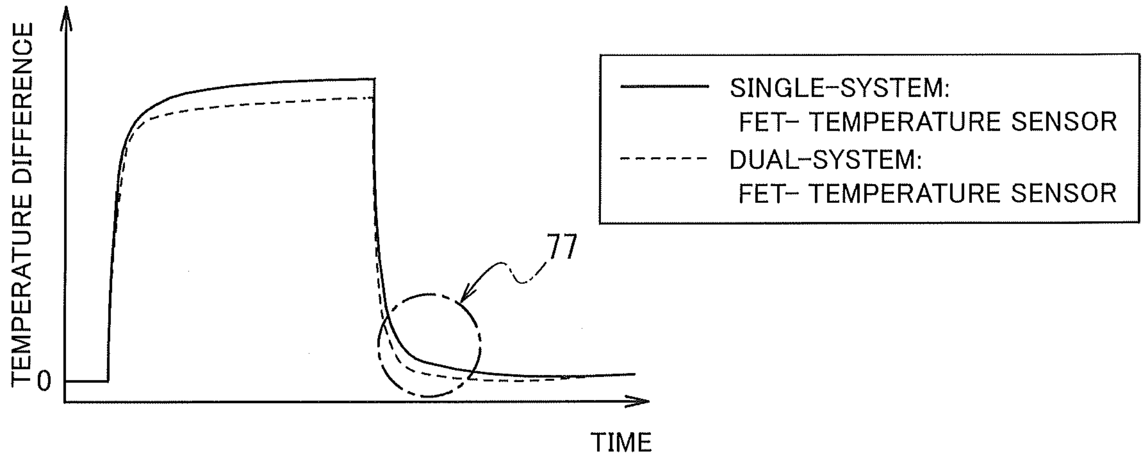


FIG. 16A

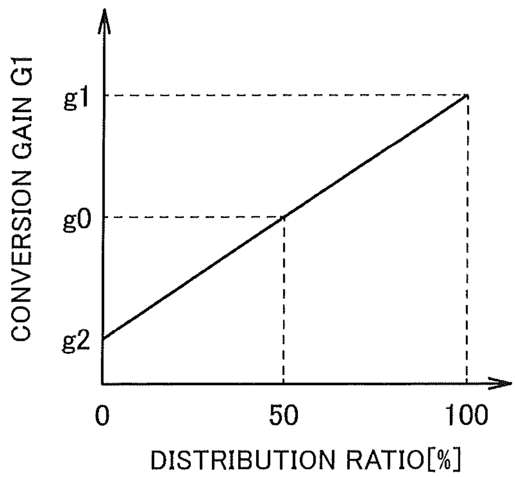


FIG. 16B

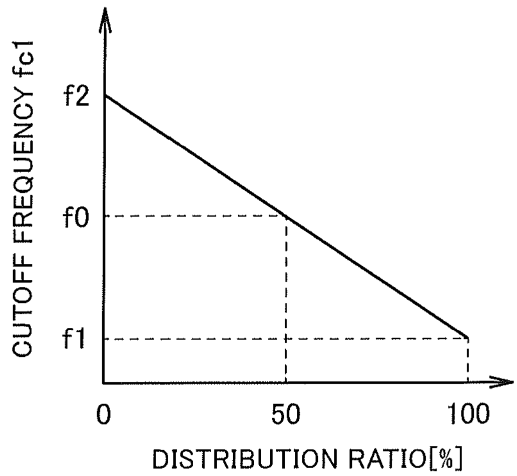

FIG. 17A

FIG. 17B

FIG. 17C

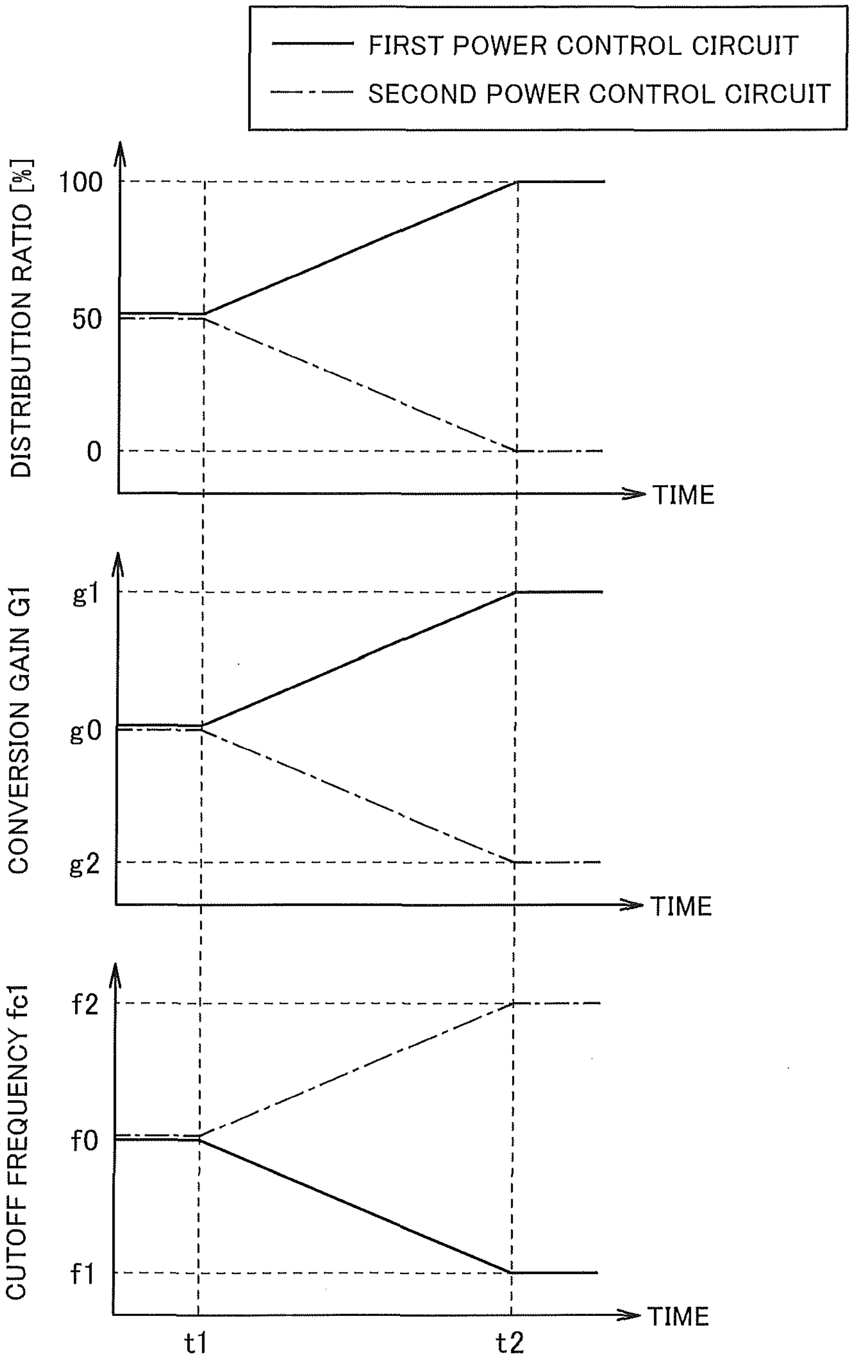

FIG. 18

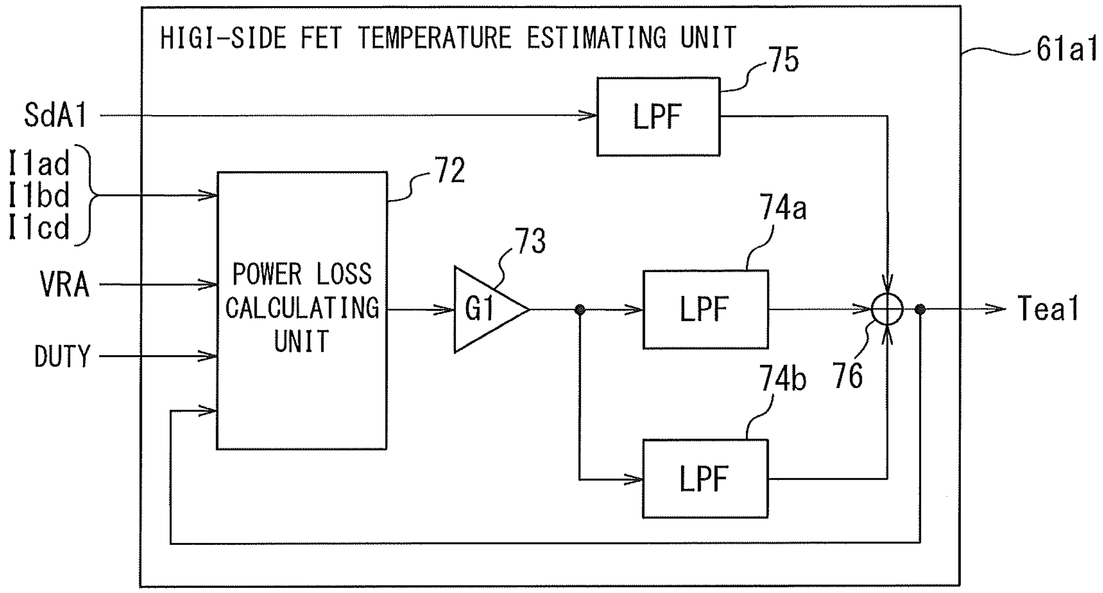


FIG. 19A

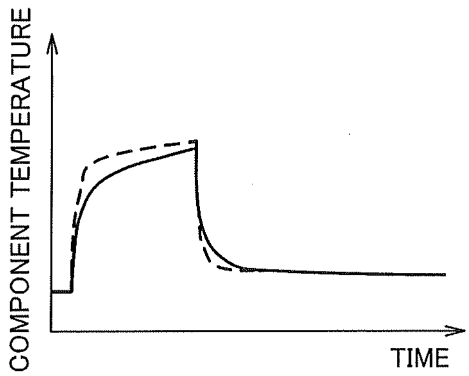


FIG. 19C

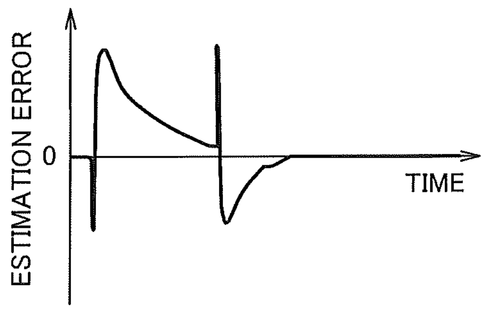


FIG. 19B

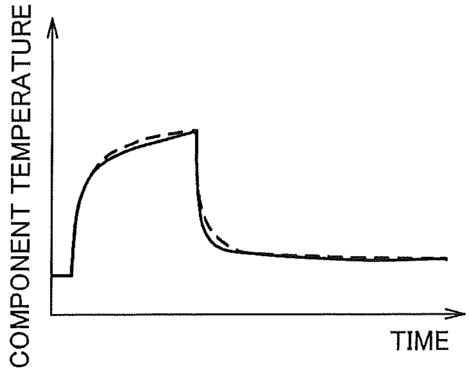


FIG. 19D

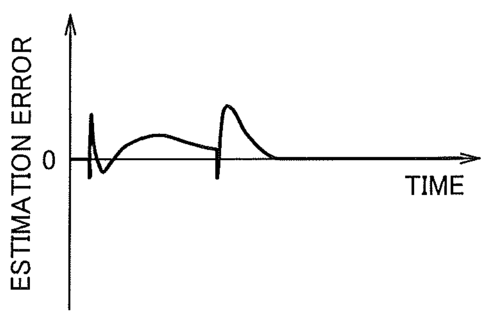

FIG. 20A

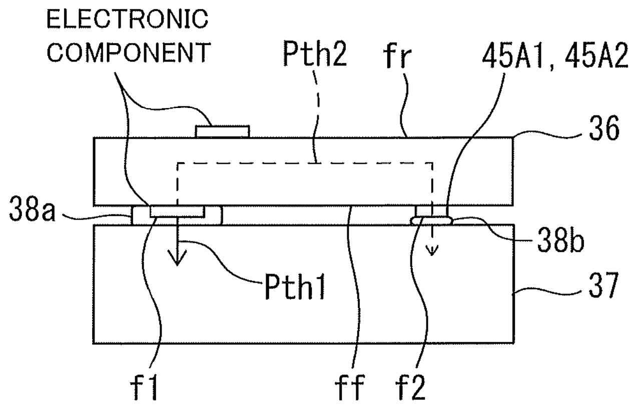


FIG. 20B

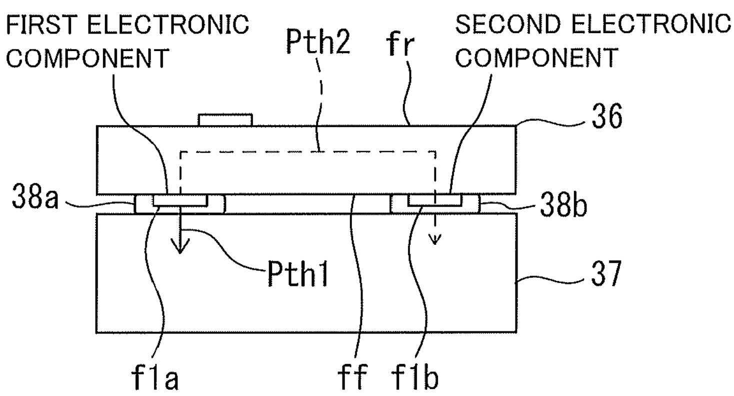


FIG. 20C

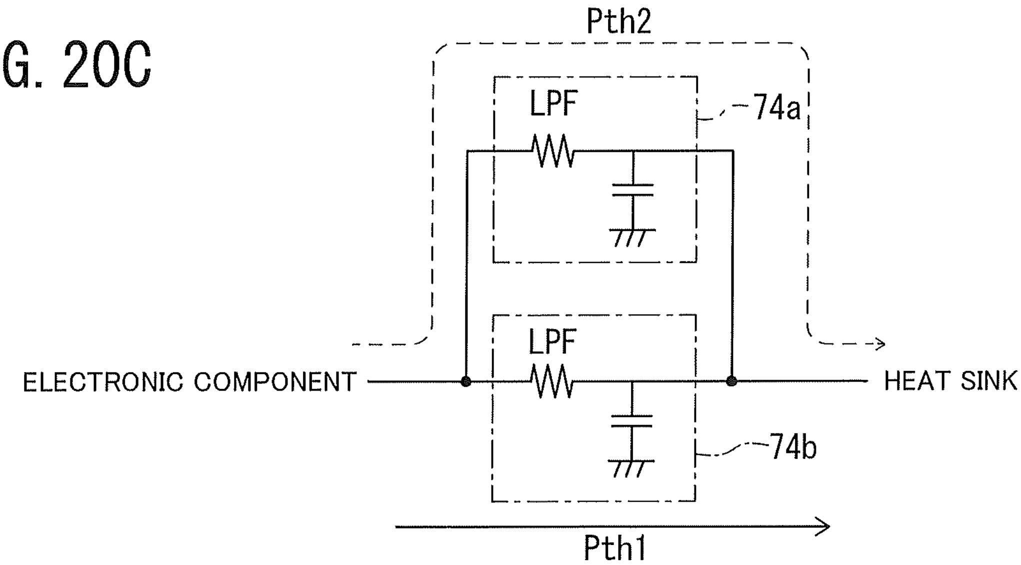

FIG. 21

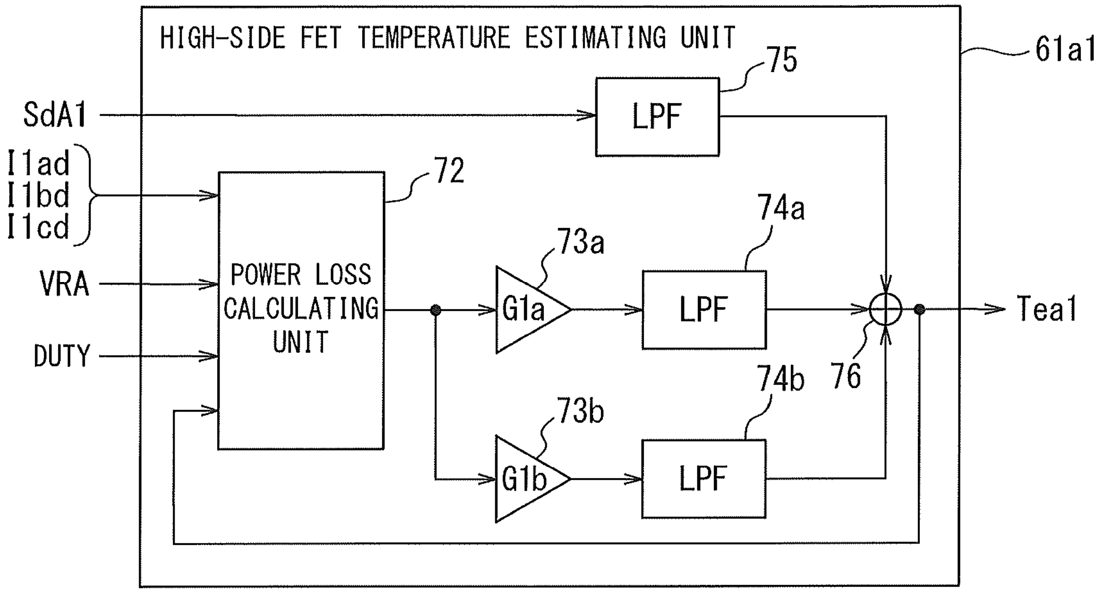
HIGH-SIDE FET TEMPERATURE ESTIMATING UNIT
61a1
75
LPF
SdA1
I1ad
I1bd
I1cd
72
POWER LOSS CALCULATING UNIT
VRA
DUTY
73a
G1a
74a
LPF
Tea1
74b
76
73b
G1b
LPF

FIG. 22

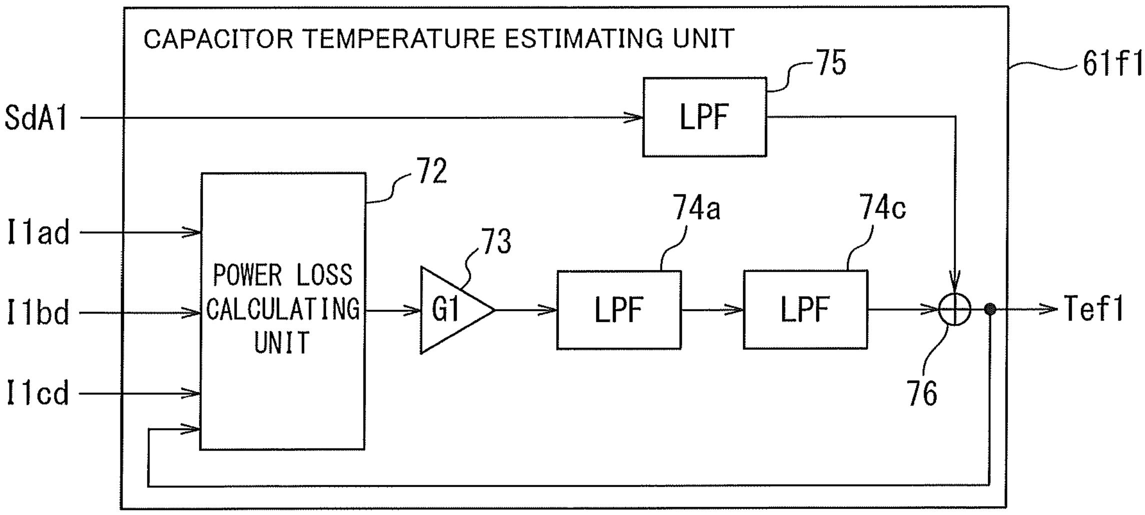
CAPACITOR TEMPERATURE ESTIMATING UNIT
61f1
75
LPF
SdA1
72
I1ad
I1bd
I1cd
POWER LOSS CALCULATING UNIT
73
G1
74a
LPF
74c
LPF
Tef1
76

FIG. 23A

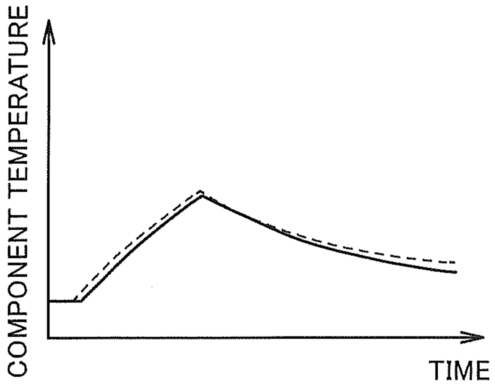


FIG. 23B

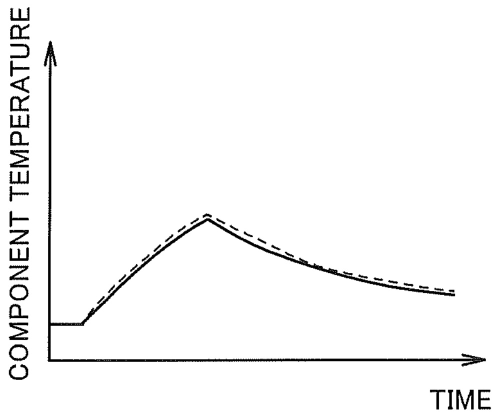


FIG. 23C

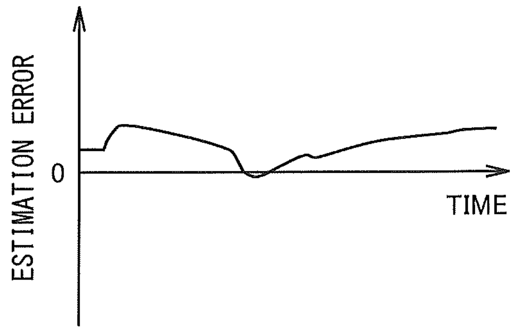


FIG. 23D

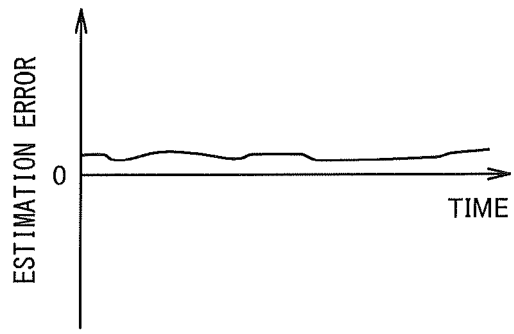

FIG. 24A

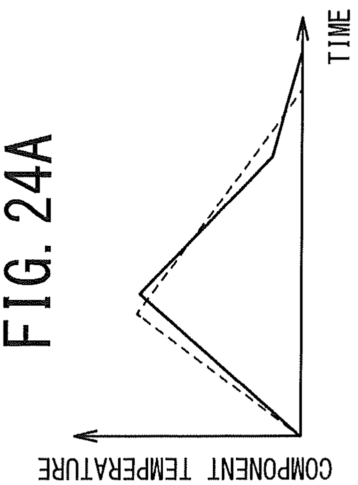


FIG. 24B

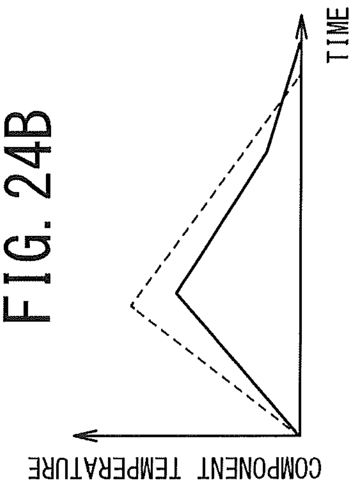


FIG. 24C

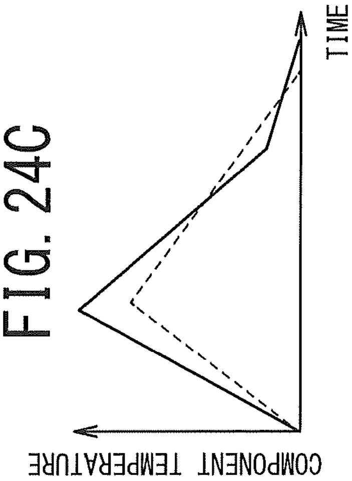


FIG. 24D

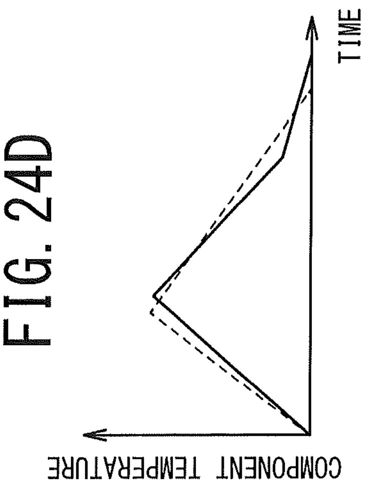


FIG. 24E

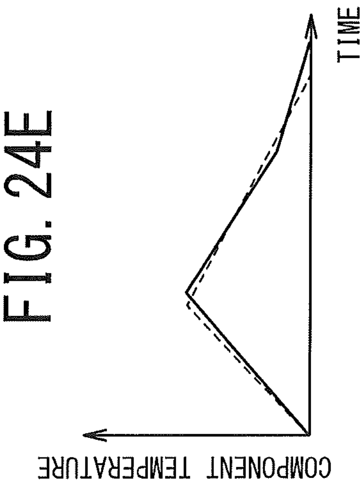


FIG. 24F

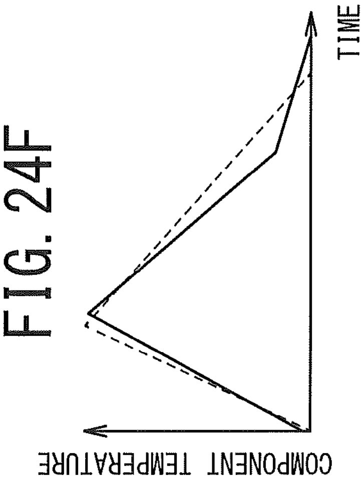


FIG. 24G

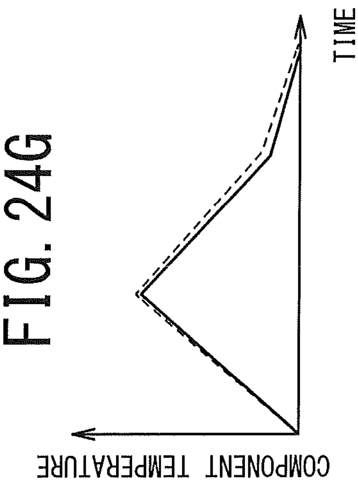


FIG. 24H

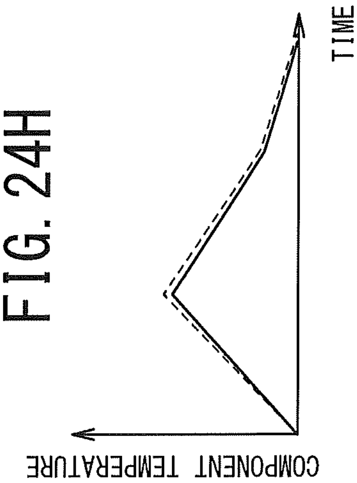


FIG. 24I

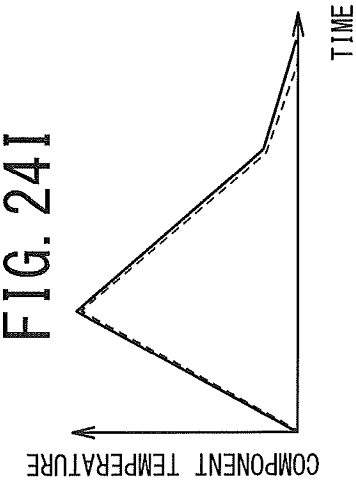

FIG. 25A

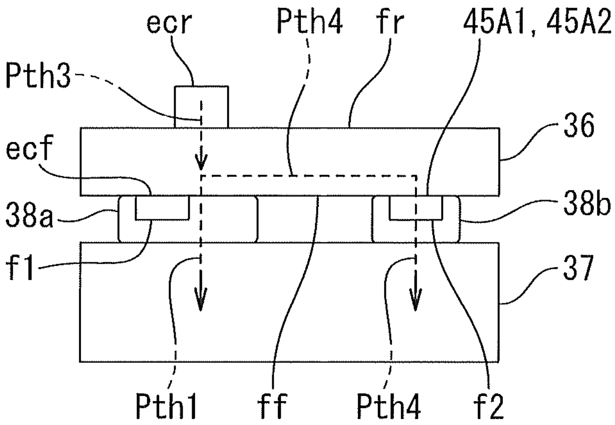


FIG. 25B

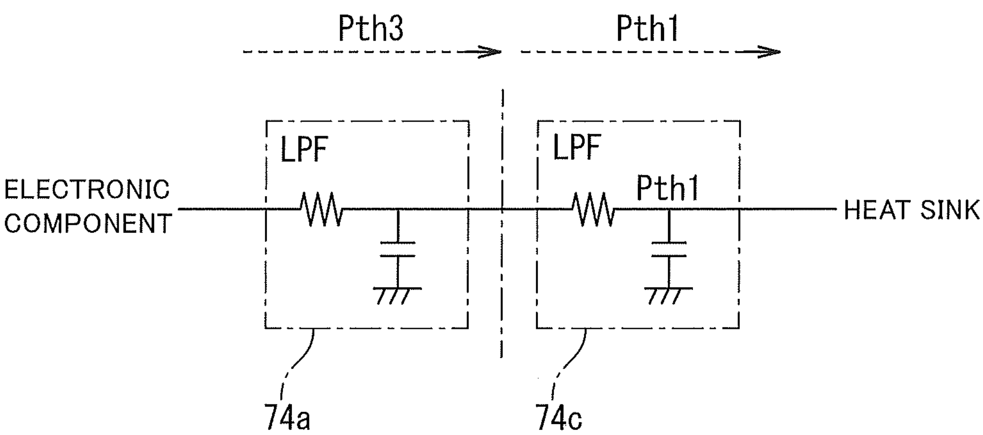


FIG. 25C

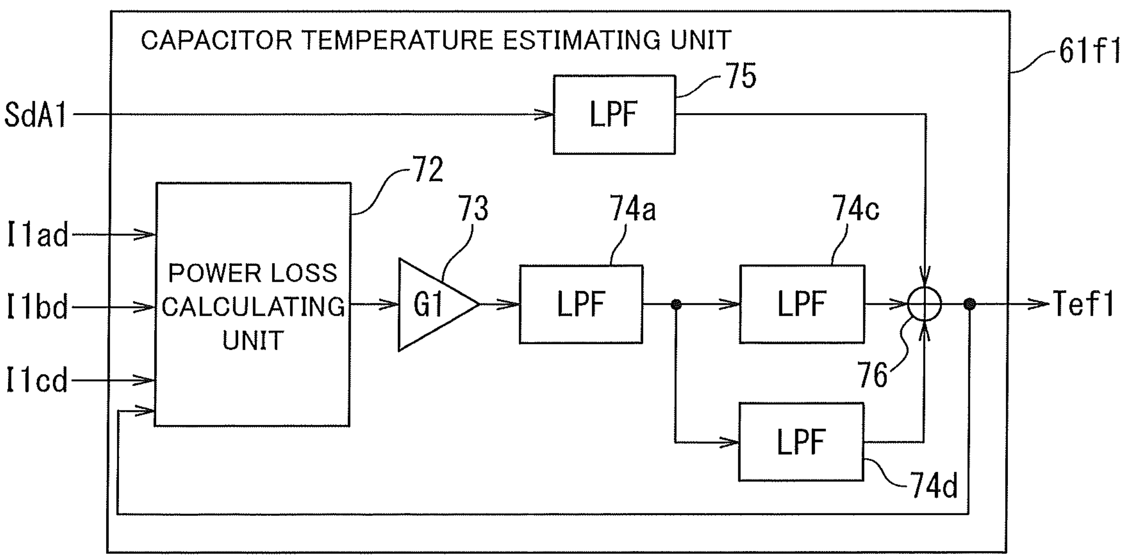

FIG. 26A

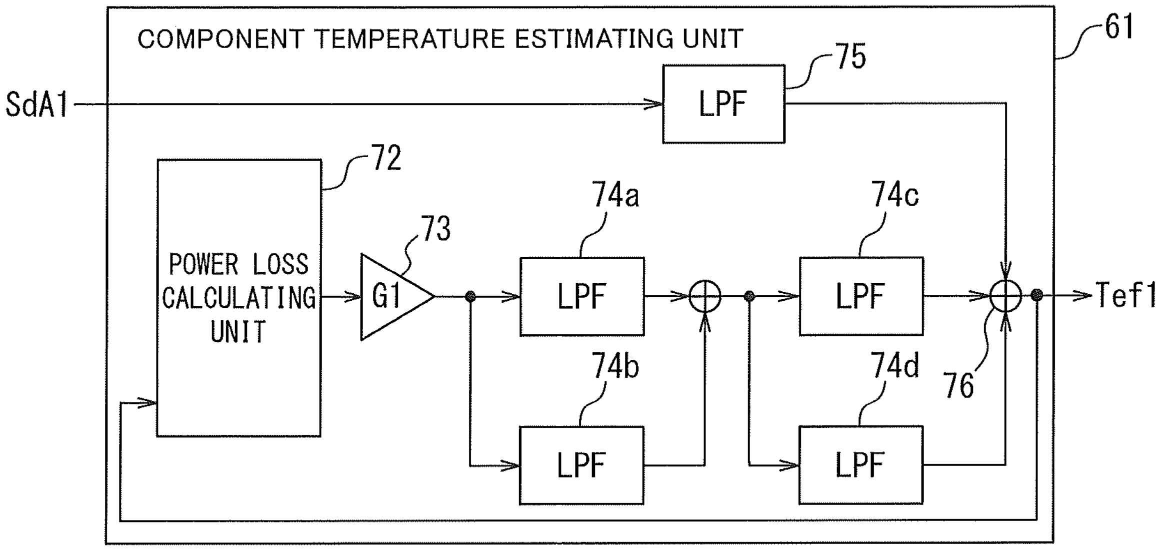


FIG. 26B

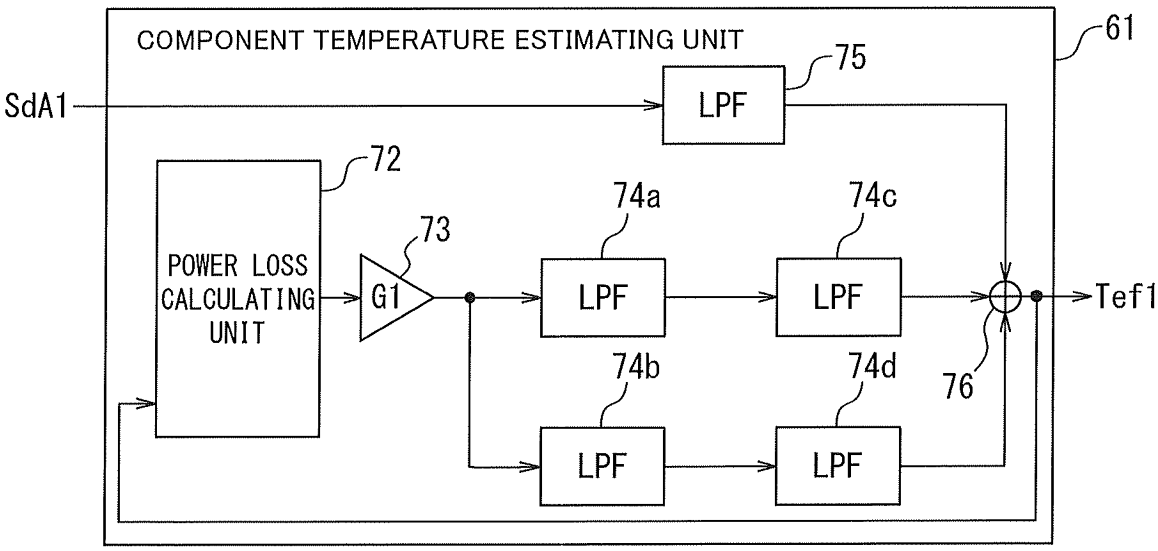

FIG. 27

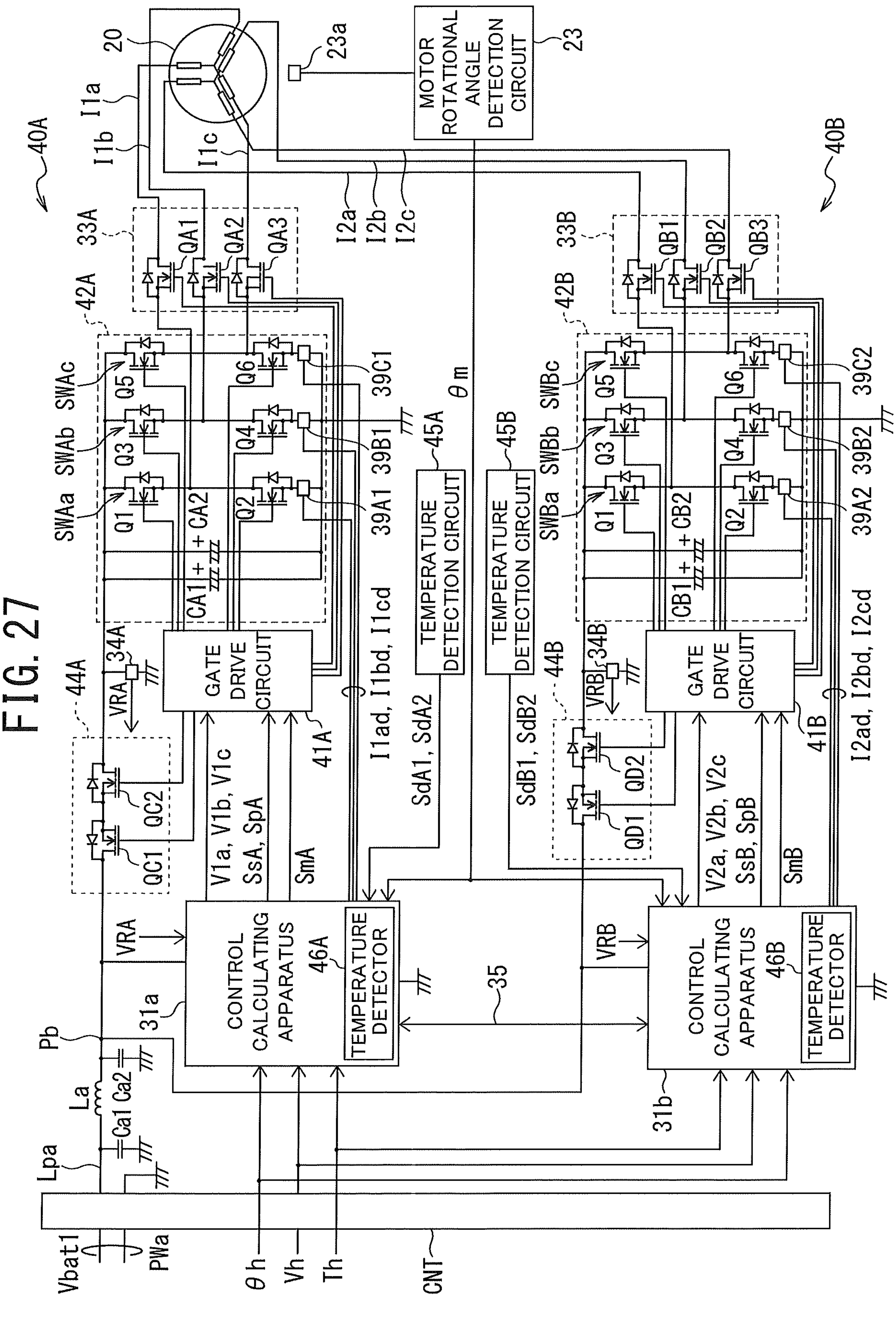
40A
40B
20
I1a
I1b
I1c
23a
MOTOR ROTATIONAL ANGLE DETECTION CIRCUIT
23
I2a
I2b
I2c
33A
QA1
QA2
QA3
33B
QB1
QB2
QB3
42A
42B
SWAa SWAb SWAc
SWBa SWBb SWBc
Q1
Q2
Q3
Q4
Q5
Q6
CA1
CA2
CB1
CB2
39A1 39B1 39C1
39A2 39B2 39C2
θ m
45A
45B
TEMPERATURE DETECTION CIRCUIT
TEMPERATURE DETECTION CIRCUIT
44A
44B
34A
34B
VRA
VRB
GATE DRIVE CIRCUIT
41A
41B
I1ad, I1bd, I1cd
I2ad, I2bd, I2cd
SdA1, SdA2
SdB1, SdB2
QC1
QC2
QD1
QD2
V1a, V1b, V1c
SsA, SpA
SmA
V2a, V2b, V2c
SsB, SpB
SmB
CONTROL CALCULATING APPARATUS
46A
TEMPERATURE DETECTOR
46B
35
31a
31b
Pb
La
Ca1 Ca2
Lpa
Vbat1
PWa
θ h
Vh
Th
CNT

FIG. 28

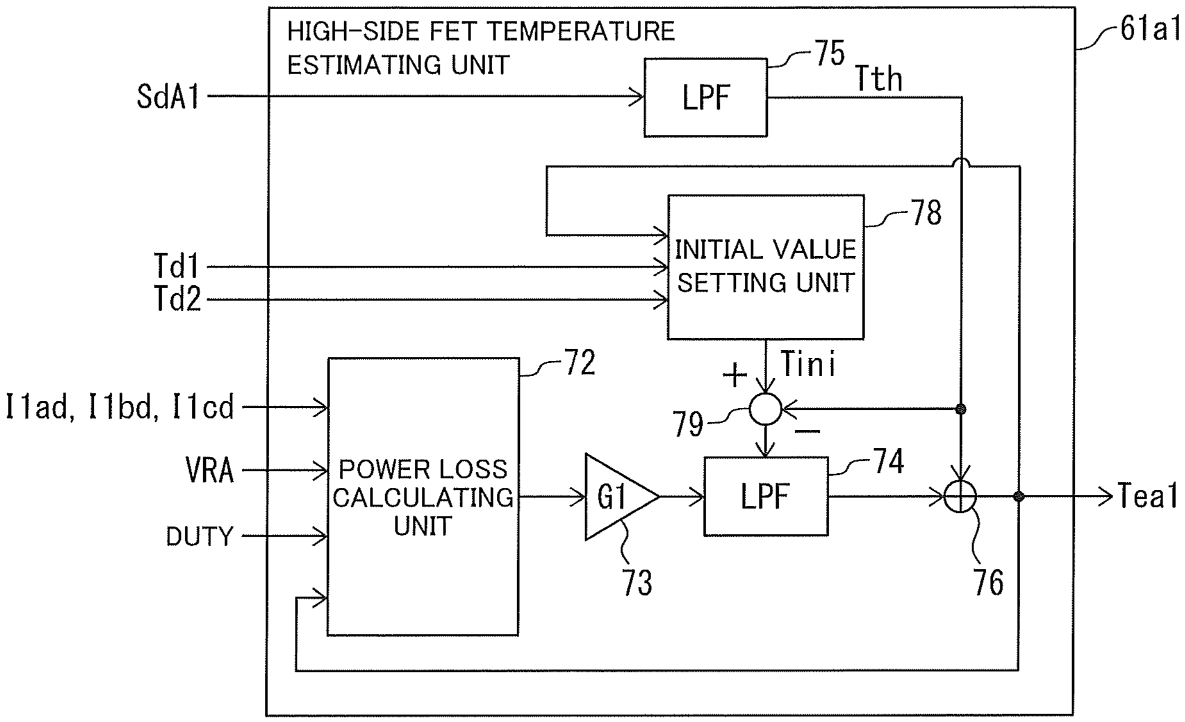


FIG. 29A

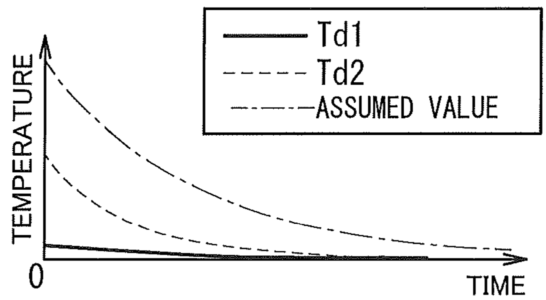


FIG. 29B

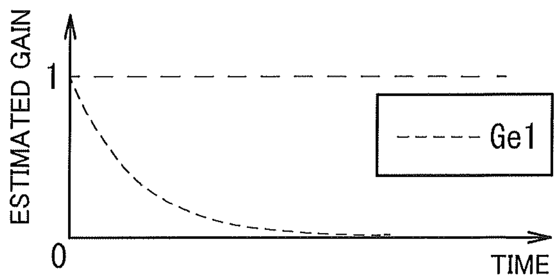


FIG. 29C

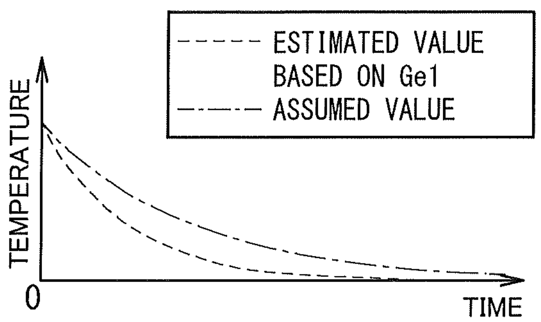


FIG. 29D

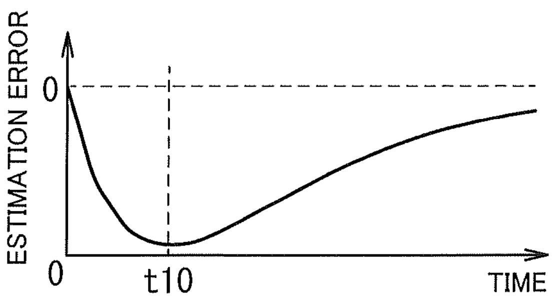

FIG. 30A

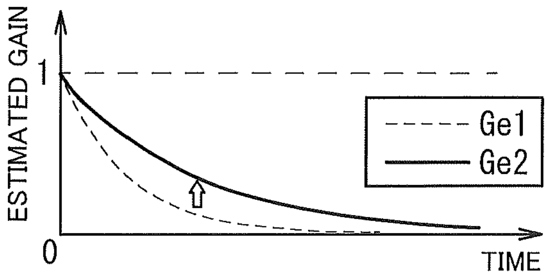


FIG. 30B

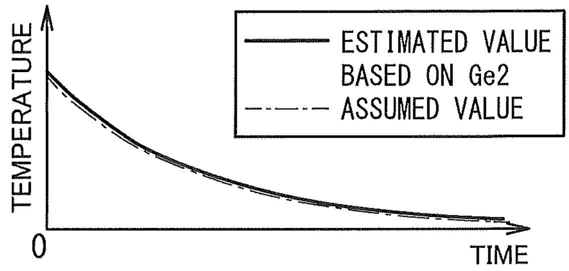


FIG. 31A

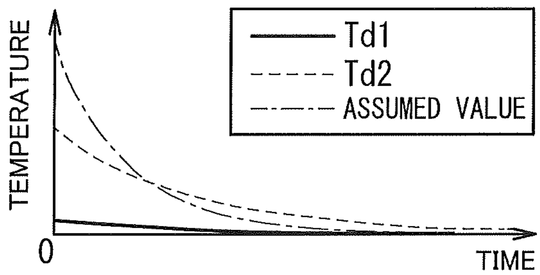


FIG. 31B

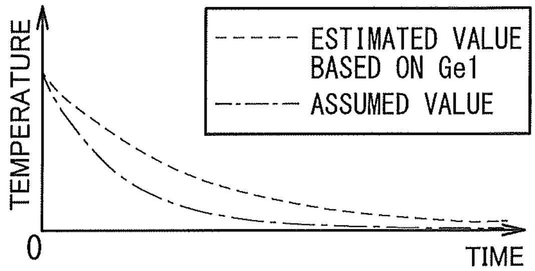


FIG. 31C

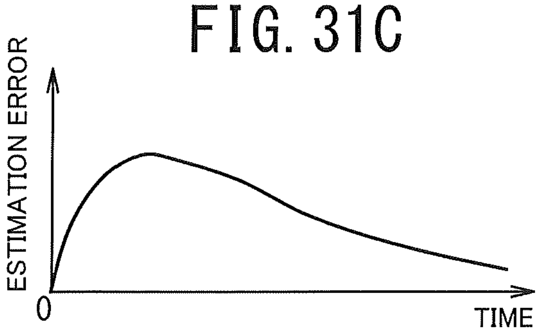


FIG. 31D

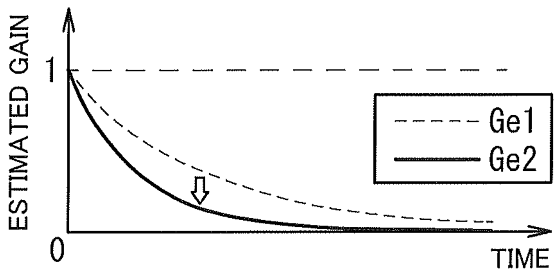


FIG. 30E

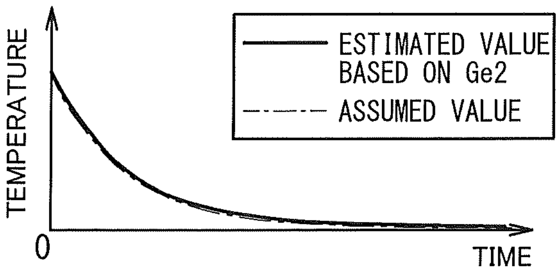

FIG. 32A

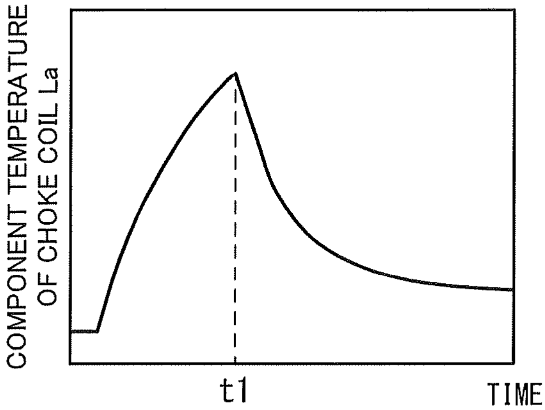


FIG. 32B

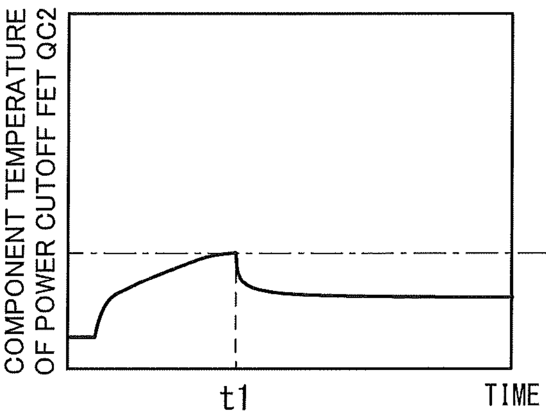


FIG. 32C

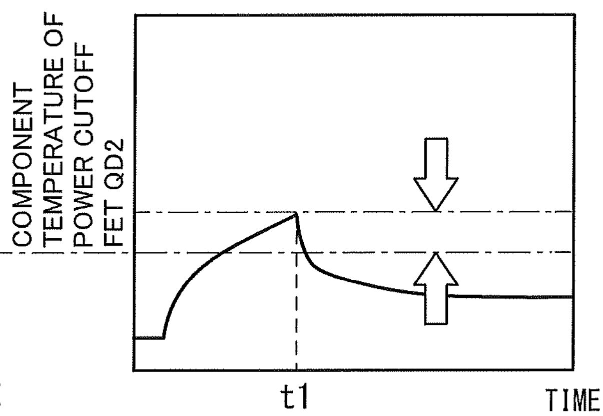


FIG. 32D

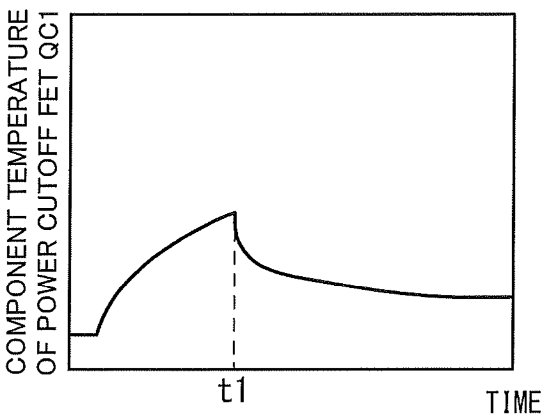


FIG. 32E

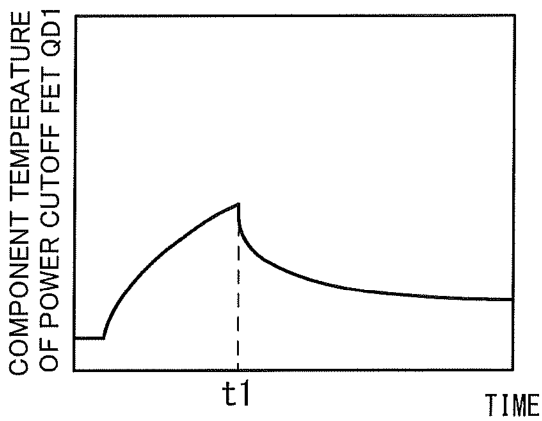

FIG. 33A

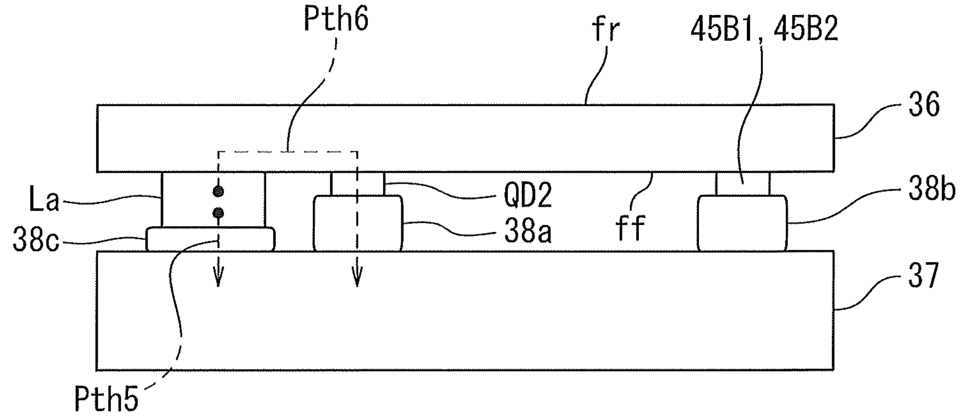


FIG. 33B

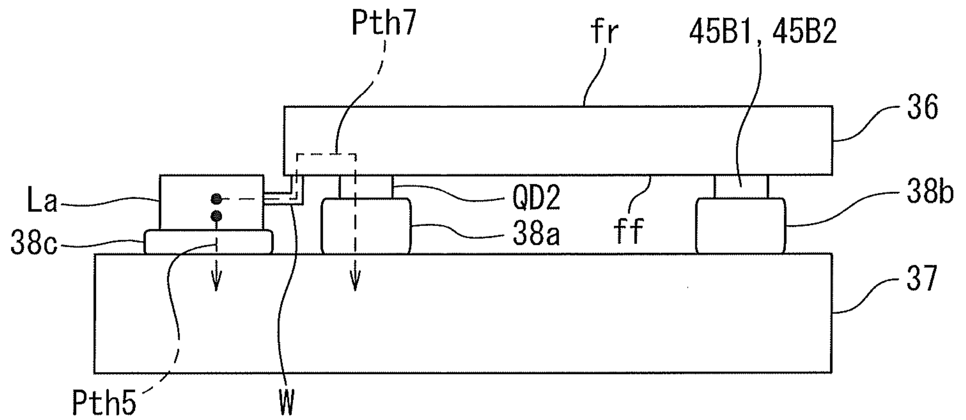


FIG. 33C

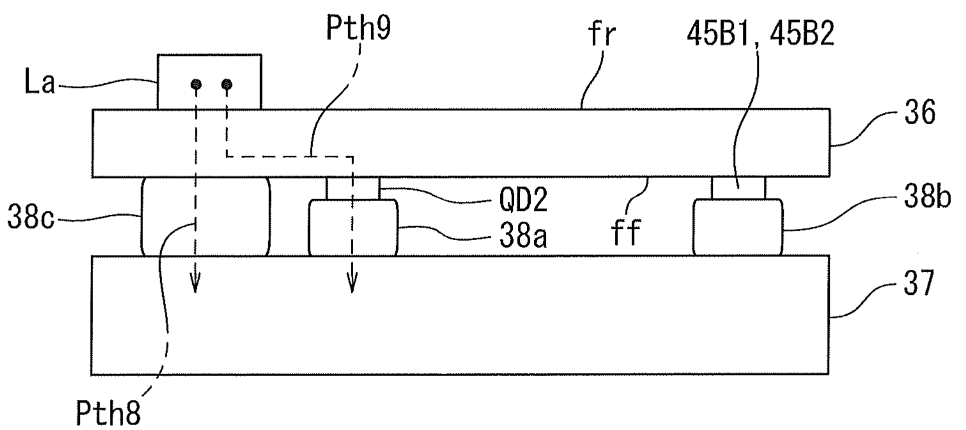

FIG. 34A

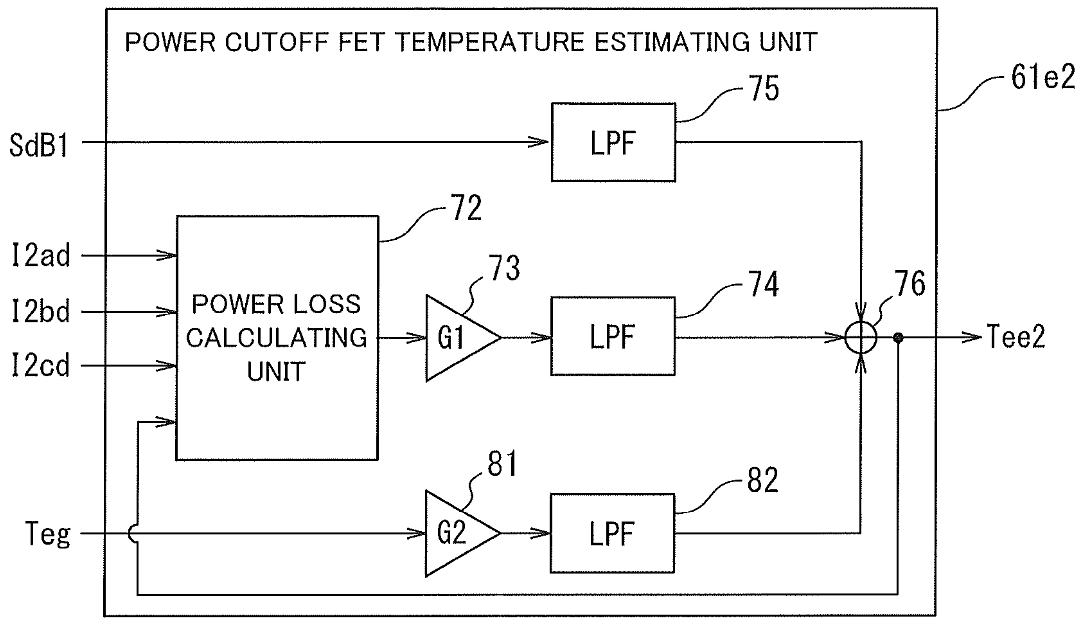


FIG. 34B

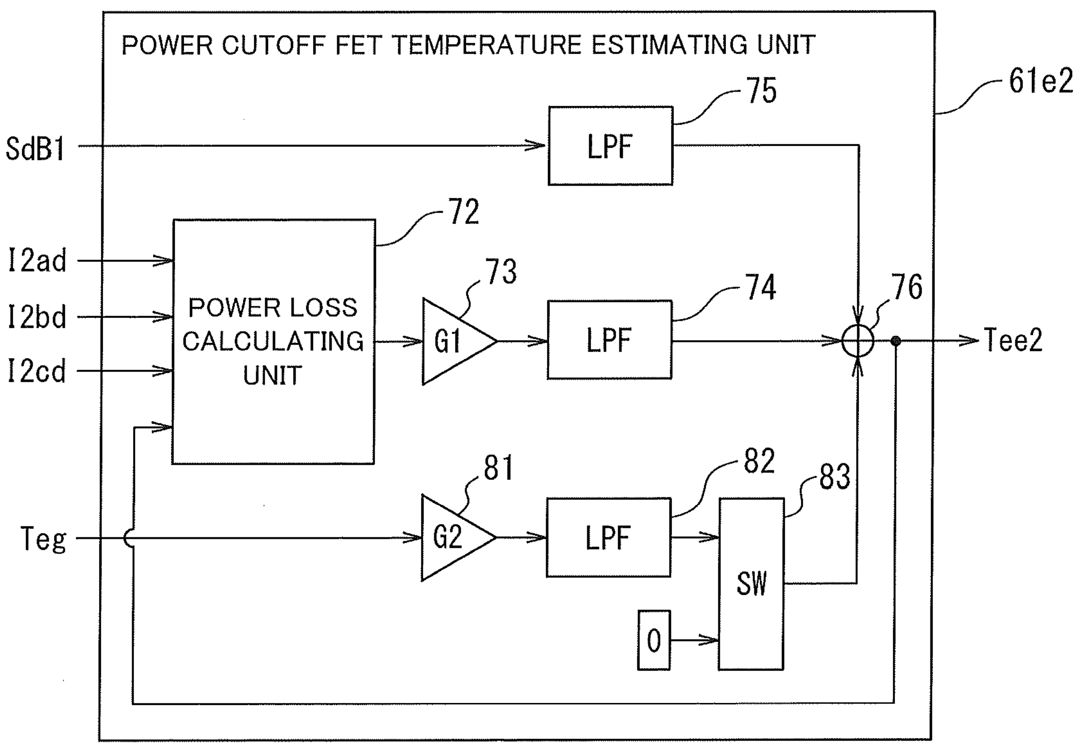

FIG. 35

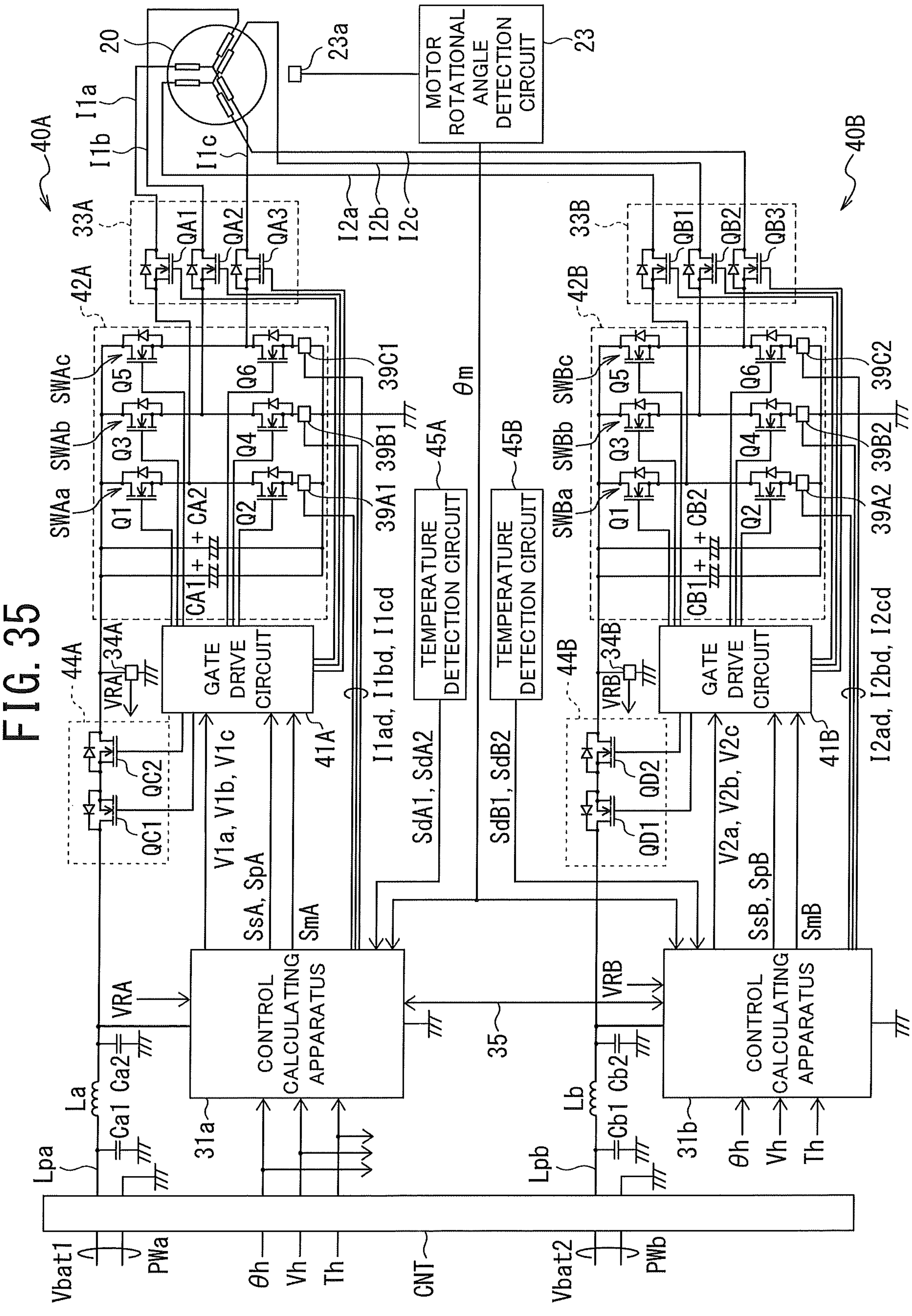

20
I1a
I1b
I1c
40A
23a
MOTOR ROTATIONAL ANGLE DETECTION CIRCUIT
23
33A
QA1
QA2
QA3
I2a
I2b
I2c
42A
SWAa
SWAb
SWAc
Q1
Q3
Q5
Q2
Q4
Q6
CA1
CA2
39A1
39B1
39C1
θm
45A
TEMPERATURE DETECTION CIRCUIT
45B
TEMPERATURE DETECTION CIRCUIT
44A
VRA
34A
GATE DRIVE CIRCUIT
QC1
QC2
V1a, V1b, V1c
41A
I1ad, I1bd, I1cd
SdA1, SdA2
SdB1, SdB2
SsA, SpA
SmA
CONTROL CALCULATING APPARATUS
31a
La
Ca1
Ca2
Lpa
Vbat1
PWa
θh
Vh
Th
CNT
35
Vbat2
PWb
Lpb
Lb
Cb1
Cb2
VRB
31b
40B
33B
QB1
QB2
QB3
42B
SWBa
SWBb
SWBc
CB1
CB2
39A2
39B2
39C2
44B
34B
QD1
QD2
V2a, V2b, V2c
41B
I2ad, I2bd, I2cd
SsB, SpB
SmB

FIG. 36

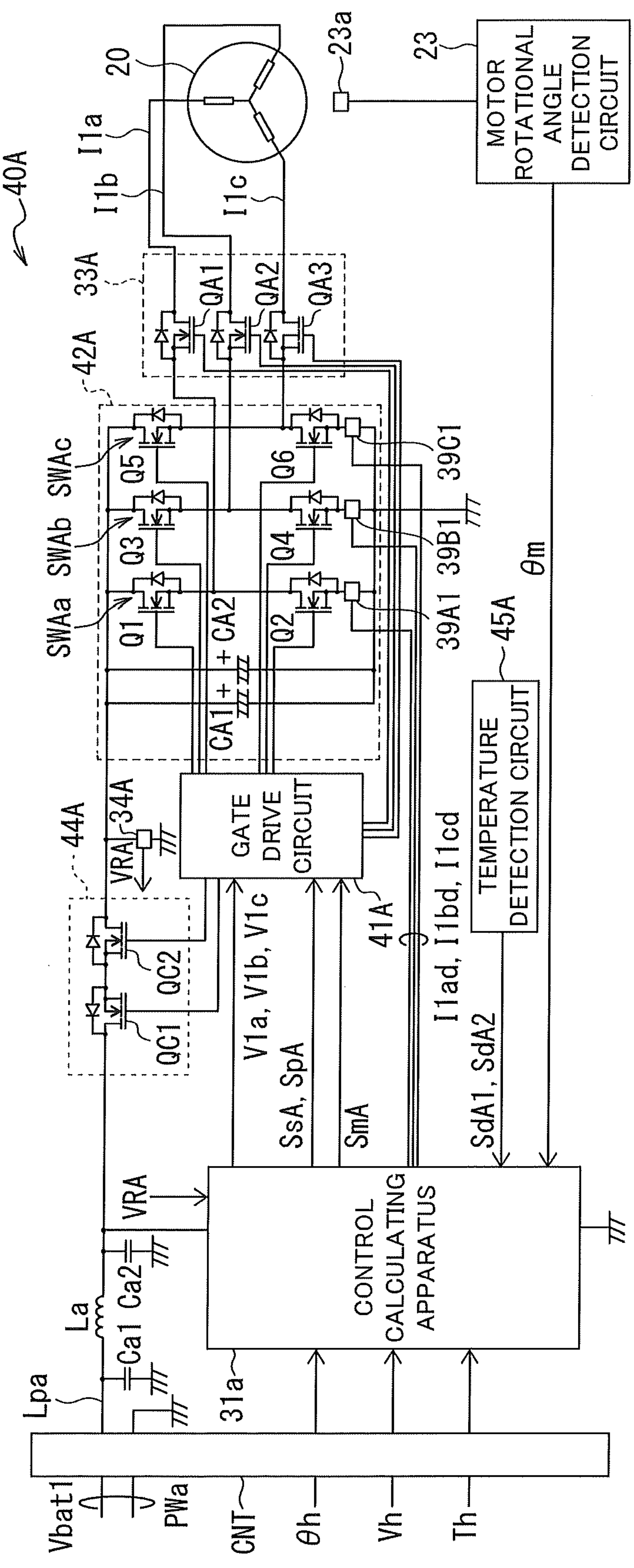

40A
20
23a
23
MOTOR ROTATIONAL ANGLE DETECTION CIRCUIT
I1a
I1b
I1c
33A
QA1
QA2
QA3
42A
SWAa
SWAb
SWAc
Q1
Q2
Q3
Q4
Q5
Q6
39A1
39B1
39C1
CA1
CA2
θm
45A
TEMPERATURE DETECTION CIRCUIT
44A
VRA
34A
GATE DRIVE CIRCUIT
QC1
QC2
V1a, V1b, V1c
41A
I1ad, I1bd, I1cd
SsA, SpA
SmA
SdA1, SdA2
CONTROL CALCULATING APPARATUS
La
Ca1
Ca2
Lpa
31a
Vbat1
PWa
CNT
θh
Vh
Th

FIG. 37

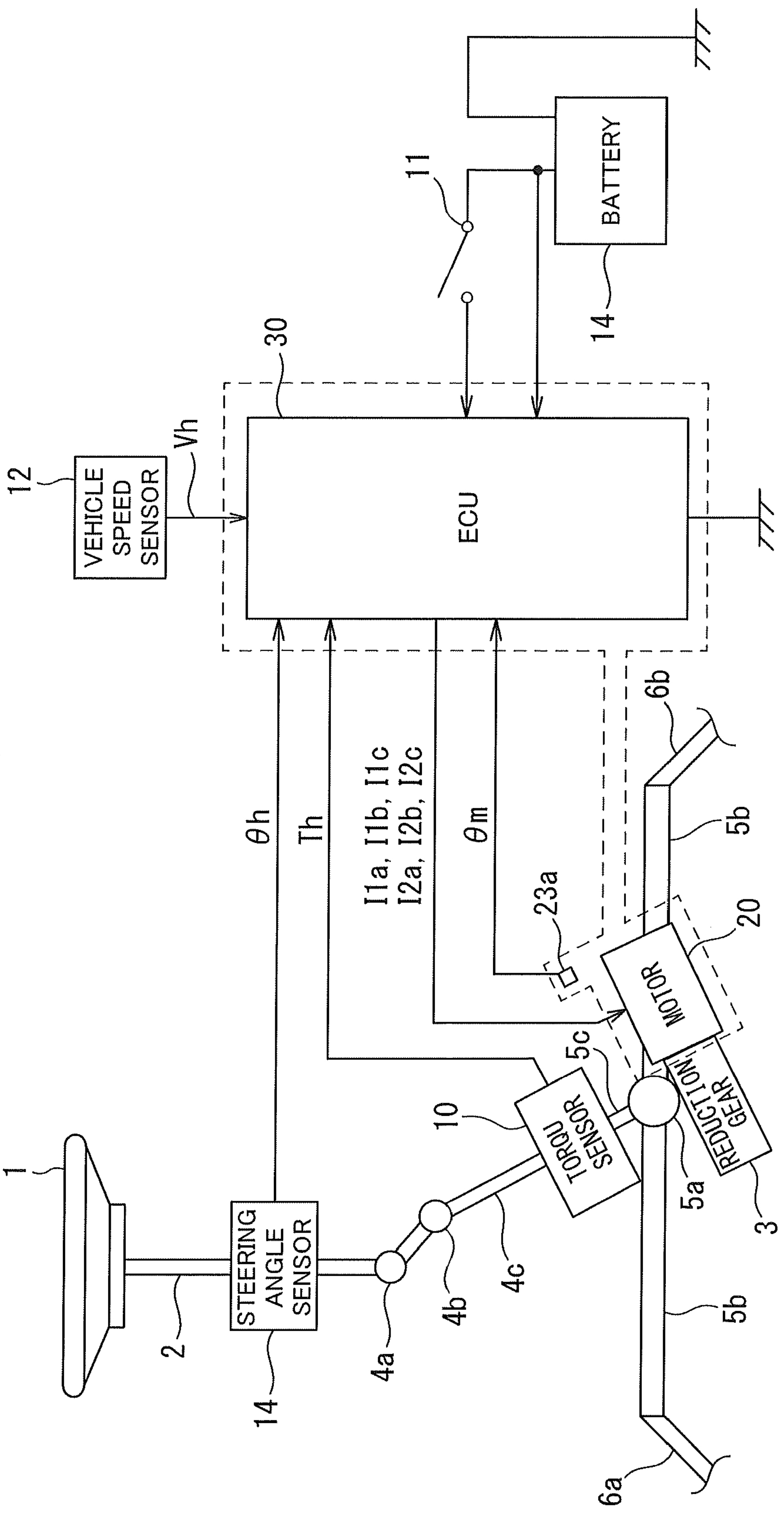
1
2
STEERING ANGLE SENSOR
14
4a
4b
4c
10
TORQU SENSOR
5c
5a
5b
6a
6b
REDUCTION GEAR
3
MOTOR
20
23a
θh
Th
I1a, I1b, I1c
I2a, I2b, I2c
θm
VEHICLE SPEED SENSOR
12
Vh
ECU
30
11
BATTERY
14

FIG. 38

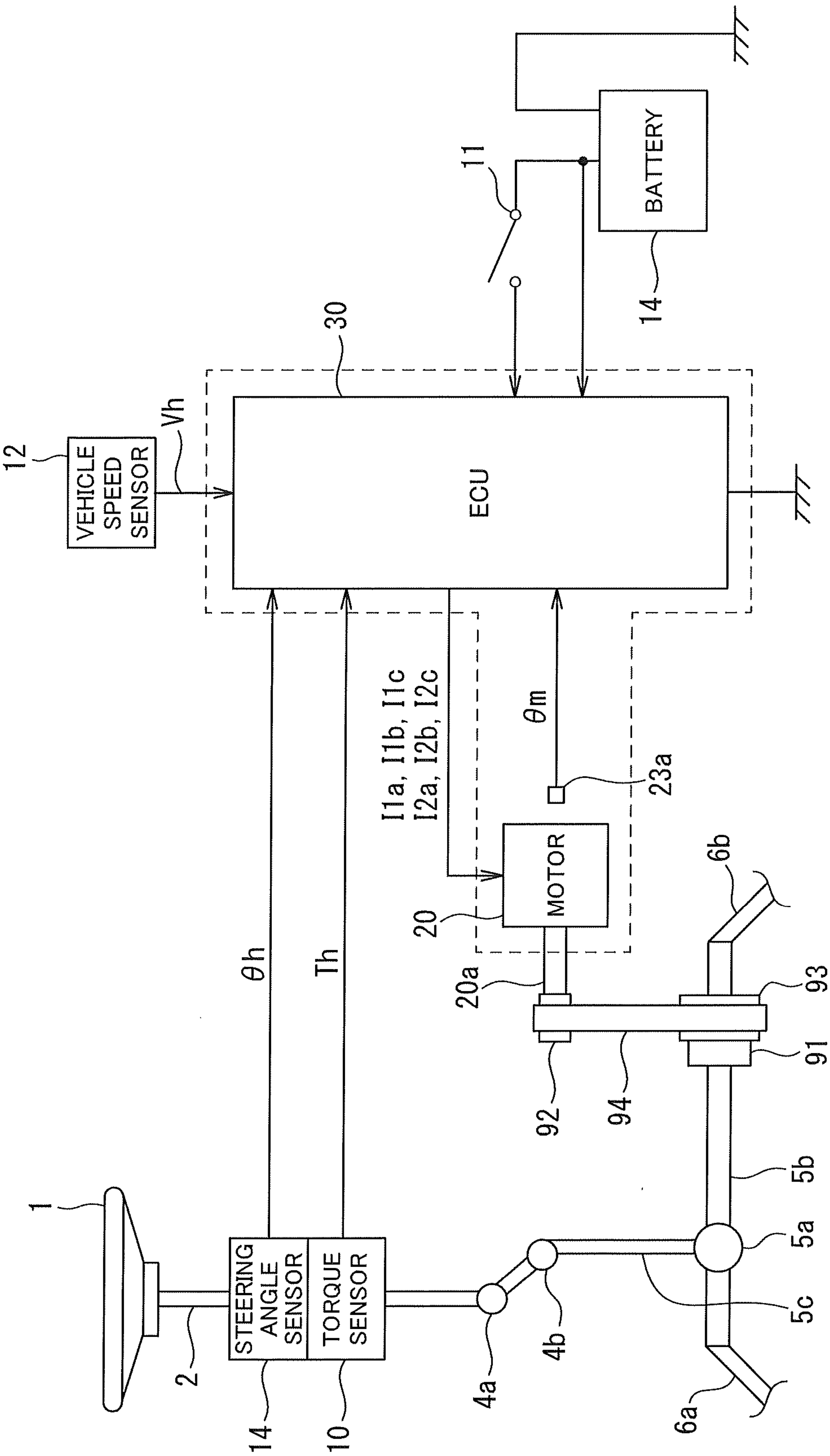
1
2
14
10
STEERING ANGLE SENSOR
TORQUE SENSOR
4a
4b
5a
5b
5c
6a
6b
θh
Th
12
VEHICLE SPEED SENSOR
Vh
30
ECU
I1a, I1b, I1c
I2a, I2b, I2c
θm
23a
MOTOR
20
20a
92
94
91
93
11
BATTERY
14

FIG. 39

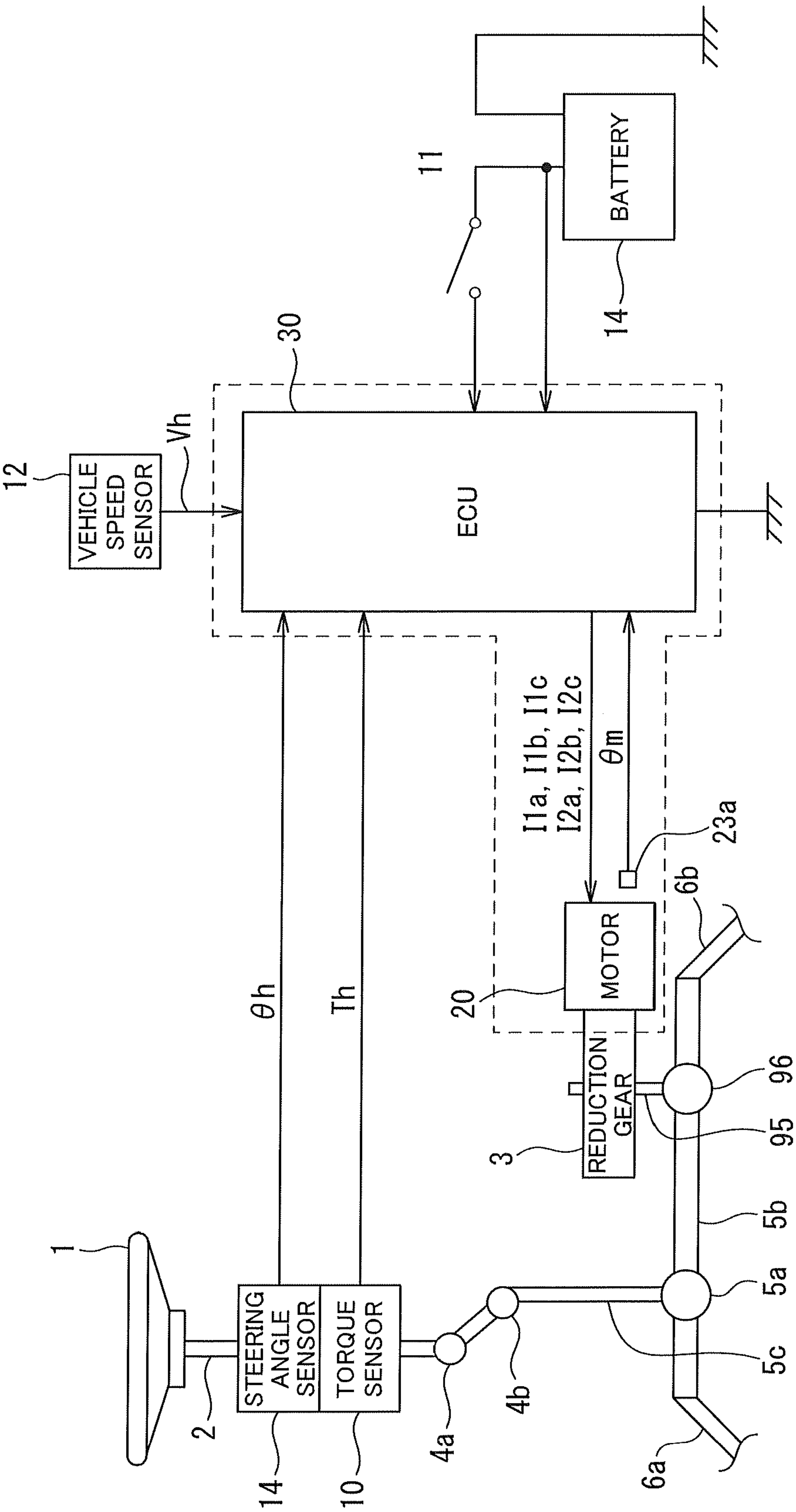
VEHICLE SPEED SENSOR
Vh
ECU
BATTERY
STEERING ANGLE SENSOR
TORQUE SENSOR
θh
Th
I1a, I1b, I1c
I2a, I2b, I2c
θm
MOTOR
REDUCTION GEAR
1
2
3
4a
4b
5a
5b
5c
6a
6b
10
11
12
14
20
23a
30
95
96

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006341795 A
- US 2014118866 A1
- US 2021136947 A1
- CN 105184363 A
- WO 6569447 A

### Non-patent literature cited in the description

- **XINGNING HAN et al.** *Lifetime Estimation of Semiconductor Devices in Wind Turbine Converter Under Fractional Frequency Transmission System*